(19) **Europäisches Patentamt / European Patent Office / Office européen des brevets**

(11) **EP 0 783 207 B1**

(12) **EUROPEAN PATENT SPECIFICATION**

(45) Date of publication and mention
of the grant of the patent:
**20.05.2009  Bulletin 2009/21**

(51) Int Cl.:
***H03M 7/00*** *(2006.01)*

(21) Application number: **96309281.2**

(22) Date of filing: **19.12.1996**

(54) **digital signal processing method and apparatus**

Vorrichtung und Verfahren zur digitalen Signalverarbeitung

Procédé et dispositif de traitement de signaux numériques

(84) Designated Contracting States:
**DE FR GB**

(30) Priority: **27.12.1995  JP 34196595**
**14.03.1996  JP 5799996**
**05.07.1996  JP 17690196**

(43) Date of publication of application:
**09.07.1997  Bulletin 1997/28**

(73) Proprietor: **Sony Corporation**
**Minato-ku**
**Tokyo 108-0075 (JP)**

(72) Inventors:
• **Noguchi, Masayoshi**
**Shinagawa-ku,**
**Tokyo (JP)**
• **Ichimura, Gen**
**Shinagawa-ku,**
**Tokyo (JP)**

(74) Representative: **Nicholls, Michael John**
**J.A. Kemp & Co.**
**14 South Square**
**Gray's Inn**
**London**
**WC1R 5JJ (GB)**

(56) References cited:
**US-A- 4 327 382**   **US-A- 4 541 089**
**US-A- 5 248 971**   **US-A- 5 345 233**

• **PATENT ABSTRACTS OF JAPAN vol. 096, no. 011, 29 November 1996 -& JP 08 172359 A (SONY CORP), 2 July 1996**
• **KERSHAW S.M.; SANDLER M.B.: 'Digital signal processing on a sigma-delta bitstream' IEE COLLOQUIUM ON OVERSAMPLING TECHNIQUES AND SIGMA-DELTA MODULATION 30 March 1994, pages 1 - 8**
• **PNEUMATIKAKIS A.; DELIYANNIS T.: 'Direct processing of sigma-delta signals' PROCEEDINGS OF THIRD INTERNATIONAL CONFERENCE ON ELECTRONICS, CIRCUITS, AND SYSTEMS 13 October 1996, pages 13 - 16**

EP 0 783 207 B1

**Description**

This invention relates to a digital signal processing method and apparatus for switching between a sigma-delta modulation signal as an input signal produced by sigma-delta modulation, and sigma-delta re-modulated signal obtained on sigma-delta re-modulation of the input signal.

For example, a method of digitizing speech signals for recording, reproduction and transmission is implemented in a recording/reproducing apparatus for a disc-shaped recording medium, including an optical disc, such as a compact disc (CD), or a digital audio tape (DAT), or in digital broadcasting, such as satellite broadcasting. In such digital audio transmission apparatus, the format has conventionally been set for the sampling frequency of 48 kHz or 44.1 kHz and the number of quantization bits of 16 or 24 bits for digitization.

In such conventional digital-audio transmission apparatus, the number of quantization bits of digital audio data prescribes the dynamic range of demodulated audio signals. Thus, for transmitting the audio signals of higher signal quality, the number of quantization bits needs to be expanded from 16 bits of the current system to 20 or 24 bits. However, once the format has been set, the number of quantization bits can hardly be increased, so that it has been difficult to take out audio signals of higher quality from the conventional digital-audio transmission apparatus.

As a method for digitizing speech signals, a method termed sigma-delta ($\Sigma\Delta$) conversion as been proposed (see Yoshio Yamazaki, "AD/DA converter and Digital Filter", Journal of Japan Society of Acoustics, Vol.46, No.3 (1990), pp.251-257).

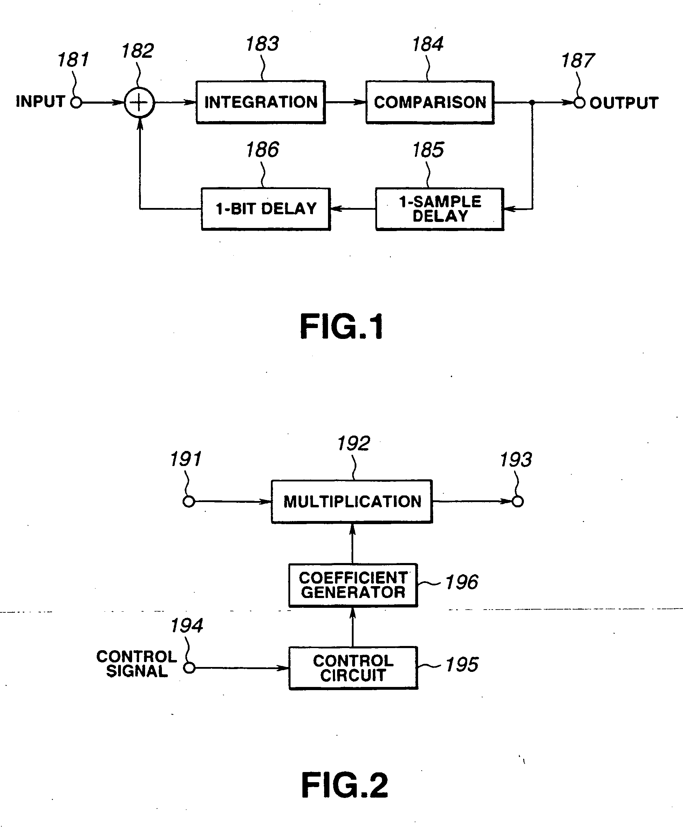

In the accompanying drawings, Fig.1 shows, in a block diagram, a $\Sigma\Delta$ modulation circuit for $\Sigma\Delta$ modulation of, for example, 1-bit digital data. In Fig.1, an input audio signal from an input terminal 181 is supplied via an adder 182 to an integrator 183. A signal from the integrator 183 is supplied to a comparator 184 where it is compared to, for example, a neutral point potential of the input audio signal for effecting one-bit quantization every sampling period. Meanwhile, the frequency of the sampling period (sampling frequency) is 64 or 128 times 48 kHz to 44.1 kHz conventionally employed.

The quantized data is supplied to a 1-sample delay unit 185 so as to be delayed one sampling period. This delayed data is converted by, for example, a one-bit D/A converter 186 into analog signals which are then is sent to an adder 182 so as to be added to the input audio signal from the input terminal 181. The comparator 184 outputs quantized data which is outputted at an output terminal 187. Thus, with the $\Sigma\Delta$ modulation performed by the $\Sigma\Delta$ modulation circuit, a high dynamic range audio signal can be obtained with a smaller number of bits, such as 1 bit, by sufficiently raising the sampling frequency, as explained in the above publication. Moreover, a broad transmission frequency can be realized. In addition, the $\Sigma\Delta$ modulation circuit has a circuit structure that is suited to integration, and high precision in A/D conversion can be realized relatively easily, so that it has hitherto been used widely in an A/D converter. The $\Sigma\Delta$ modulated signal can be restored to the analog audio signal by being passed through a simple analog low-pass filter. By exploiting these characteristics, the $\Sigma\Delta$ modulation circuit can be applied to a recorder handling high-quality data or to data transmission.

Meanwhile, with the digital audio transmission apparatus employing the above-described $\Sigma\Delta$ modulation circuit, signal processing in the amplitude direction, as a sort of the amplitude control operation, such as fading, equalizing, filtering, cross-fading or mixing, that has been possible with the aforementioned digital audio transmission apparatus handling multi-bit digital signal, such as a 16-bit digital signal (multi-bit digital audio transmission apparatus), cannot be realized with the original bit length, such that favorable properties, such as broad range and high dynamic range, cannot be used to advantage.

Among the fading operations, there are a fade out operation of gradually lowering the reproduced signal level as time elapses, and a fade-in operation of gradually raising the audio signal level from a zero level. These fading operations are customary as signal processing in the direction of the amplitude of the audio signal.

Referring to Fig.2, the above fading operation, carried ut on the above multi-bit digital audio transmission apparatus, is explained by referring to Fig.2. Referring to Fig.2, the multibit digital audio signal, such as 16-bit signal, from an input terminal 191, is outputted at an output terminal 193 via a multiplier 192. If a control signal designating the fading start timing or the fading speed is supplied to a control terminal 194, this control signal is fed to a control circuit 195 for generating a desired fading signal. This fading signal is fed to a coefficient generator 196 for generating a coefficient which gradually lowers the audio signal level to zero. This coefficient is supplied to the multiplier 192.

Thus the digital speech signal, supplied to the input terminal 191, has its signal level gradually lowered at a designated speed by a control signal as from the timing designated until it is muted to a zero level, so as to be outputted at the output terminal 193, by way of performing the fade-out operation. The fade-in operation of gradually raising the speech signal level from the zero level may also be effected by reversing the sequence of generation of the coefficients.

However, this processing cannot be performed on the $\Sigma\Delta$-modulated digital speech signal. That is, with the $\Sigma\Delta$-modulated 1-bit signal, the amplitude information is also represented as a 1-bit pattern on the time axis, such that it has been difficult to multiply the amplitude by the multiplier 192 and to perform amplitude processing on the 1-bit basis.

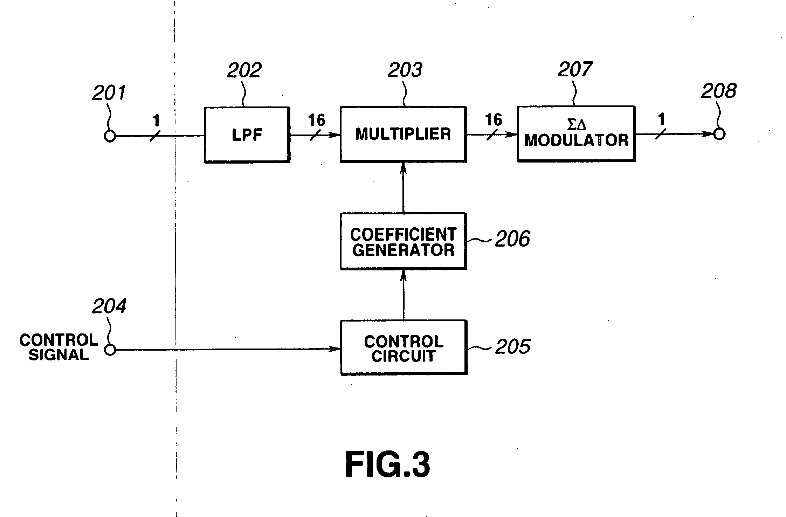

It may be contemplated to convert the $\Sigma\Delta$ signal into signals of the CD or DAT format, using a low-pass filter, and to perform the above fading operation on the converted signal. That is, in Fig.3, a 1-bit $\Sigma\Delta$ signal, for example, is fed via an input terminal 201 to a low-pass filter 202 for conversion into, for example, 16-bit multi-bit speech signal. This converted digital speech signal is sent to a multiplier 203.

Also a control signal designating the fading starting timing or fading speed is fed to a control input terminal 204 and thence supplied to a control circuit 205 for generating a desired fading signal. By this fading signal supplied to a coefficient generator 206, there is generated a coefficient gradually lowering the speech signal level to zero. This coefficient is sent to the multiplier 203.

In this manner, the multi-bit digital audio signal from the low-pass filter 202, the signal level of which has been controlled by the coefficient from the coefficient generator 206, is taken out at the multiplier 203. This digital audio signal is further sent to a $\Sigma\Delta$ modulator 207 for re-conversion into, for example, a 1-bit $\Sigma\Delta$ signal which is outputted at an output terminal 208.

Thus, the $\Sigma\Delta$ signal from the input terminal 201, the level of which has been gradually lowered to the zero level at the designated speed from the timing designated by the control signal, is outputted at the output terminal 208 by way of performing the fade-out operation. The fade-in operation of gradually raising the speech signal level from the zero level may also be performed by reversing the sequence of coefficient generation. Thus it is possible with the present device to perform fading by the same method as the conventional method.

Meanwhile, if such device is used, the $\Sigma\Delta$ signal, supplied to the input terminal 201, is converted at all times into, for example, a 16-bit multi-bit digital speech signal by the low-pass filter 202. That is, with the above device, the $\Sigma\Delta$ signal is passed through the low-pass filter 202 and the $\Sigma\Delta$ modulator 207 even if the signal has not been processed with fading. Thus the signal characteristics become the same as those with the conventional CD or DAT, such that it becomes impossible to exploit characteristics proper to $\Sigma\Delta$ modulation, such as broad band and high dynamic range. Considerations of digital circuit complexity has lead to work on $\Sigma\Delta$ based filteringand thus digitally processing the audio in formation in the $\Sigma\Delta$ bit stream directly (Kershaw S.M. Sandler M.B. "Digital Signal Processing on a Sigma-Delta Bit stream"; IEE Colloquium on Oversampling Techniques and Sigma-Delta Modulation 30.3.1994).

The fading operation can be done by directly supplying the $\Sigma\Delta$ signal supplied to the input terminal 201 to the $\Sigma\Delta$ modulator 207, without passing the $\Sigma\Delta$ signal through the low-pass filter 202. However, in this case, the signal is passed through the $\Sigma A$ modulator 207 if it is not processed with fading, such that it becomes similarly impossible to exploit characteristics proper to $\Sigma\Delta$ modulation, such as broad band and high dynamic range.

Thus it has been contemplated to take out the original $\Sigma\Delta$ signal supplied to a fixed terminal A of a switch 217 at an output terminal 218 and to take out the $\Sigma\Delta$ signal modulated by a $\Sigma\Delta$ modulator 216 and thence supplied to a fixed terminal B of the switch 217 at the output terminal 218 when the amplitude processing such as fading is not done and when the amplitude processing is done, respectively.

However, the above two $\Sigma\Delta$ signals, switched by the switch 217, are signals modulated on the time axis by different $\Sigma\Delta$ modulators, even although the two signals have substantially the same analog audio signal components, so that, if the signals are switched directly, significant noise is generated at the switching point, thus rendering the device practically unusable.

It is therefore an object of the present invention to provide a digital signal processing method and apparatus whereby the noise can be suppressed at the time of switching between the original sigma-delta modulated signal and the sigma-delta re-modulated signal obtained on sigma-delta re-modulating the original sigma-delta modulated signal.

In one aspect, the present invention provides a digital signal processing apparatus according to claim 1.

This arrangement realizes switching in a manner free from noise.

The signal-delta modulation means sets the first stage feedback loop/second stage feedback loop gain ratio to an integer value. The input signal delaying means determines the pre-set number of samples based on the above gain ratio.

The digital signal processing device also includes pattern coincidence detection means for detection of coincidence of the delayed sigma-delta modulated signal and the sigma-delta re-modulated signal over a plurality of samples. The switching control means controls the switching means based on the result of detection obtained by the pattern coincidence detection means. This realizes switching with more reliable noise suppression.

Also, the digital signal processing device sets the initial value of the integrator of the signal-delta modulation means to zero by the switching control means immediately before input of the input signal and/or during the time the delay signals from the first and second input signal delaying meas are selected by switching. This realizes switching with still more reliable noise suppression.

The digital signal processing device also includes amplitude controlling means for controlling the amplitude level of a level adjusted signal having the amplitude level adjusted by he level adjustment means. The switching control means causes the amplitude control means to control the amplitude level of the level-adjusted signal after causing the switching means to switch from the delayed sigma-delta modulated signal from the input signal delaying means to the sigma-delta re-modulated signal obtained on sigma-delta modulation of the level adjusted signal.

The digital signal processing device also includes amplitude controlling means for controlling the amplitude level of the level adjusted signal having its amplitude level adjusted by the level adjustment means, level difference detection means for detecting the difference between the maximum amplitude level of the level-adjusted signal and the amplitude level of the output following amplitude control during the time the amplitude controlling means is controlling the amplitude level of the level-adjusted signal, cumulative addition means for cumulatively adding the level difference from the level difference detection means with a maximum amplitude level width length equal to twice the maximum amplitude level of the level-adjusted signal, and subtraction control means for gradually subtracting the cumulative sum of the cumulative addition means from the maximum amplitude level of the level adjusted signal after the amplitude control in the amplitude controlling means. The switching control means causes the switching means to switch from the sigma-delta modulated signal to the delayed sigma-delta modulated signal after the end of subtraction of the cumulative sum in the subtraction control means.

The digital signal processing device of the present invention also includes error detection means for detecting an uncorrectable burst error in the sigma-delta modulated signal, delaying means provided downstream of he error detection means for delaying the sigma-delta modulated signal, fade-out means for fading out the sigma-delta modulated signal via the delay means, fade-in means for fading in the sigma-delta modulated signal via the delay means, and control means for causing the fade-out means to fade out the sigma-delta modulated signal delayed by the delaying means up to directly before an uncorrectable burst error immediately to a zero level if the detection means detects such uncorrectable burst error in the sigma-delta modulated signal. The control means causes the fade-in means to fade in the sigma-delta modulated signal directly after the burst error up to the maximum amplitude level. This arrangement realizes muting processing in which the signal level on occurrence of burst error may be reduced to zero for noise suppression.

The sigma-delta modulation processing means of the digital signal processing device includes plural stages of serially connected integrators and a local feedback loop for feeding back outputs of the plural stages of the integrators to inputs of preceding stage integrators. This renders it possible to reduce noise components to assure a broad dynamic range in an audible band.

The present invention also includes a digital signal processing device according to claim 12.

This arrangement enables the sound cross-faded from the original audio signal of the first channel to the original audio signal of the second channel to be produced under effective noise suppression.

The sigma-delta modulation processing means sets the first stage feedback loop/second stage feedback loop gain ratio to an integer. The input signal delaying means determines the pre-set number of the samples based on the above gain ratio.

The digital signal processing device also includes pattern coincidence detection means for detecting the coincidence of the first delayed sigma-delta modulated signal and the sigma-delta re-modulated signal over a plurality of samples and for detecting the coincidence of the second delayed sigma-delta modulated signal and the sigma-delta re-modulated signal over a plurality of samples. The first delayed sigma-delta modulated signal is switched to the sigma-delta re-modulated signal or vice versa based on a control signal obtained by the pattern coincidence detection means, while the second delayed sigma-delta modulated signal is switched to the sigma-delta re-modulated signal or vice versa based on the control signal obtained by the pattern coincidence detection means.

The digital signal processing device causes the switching control means to set the initial value of the integrator of the sigma-delta modulation processing means to zero directly before input of the input signal and/or during the time the delayed signal from the first and second input signal delaying means is selected by switching by the switching means.

The sigma-delta modulation processing means of the digital signal processing device includes plural stages of serially connected integrators and a local feedback loop for feeding back outputs of the plural stages of the integrators to inputs of preceding stage integrators.

The amplitude control output adjustment means of the digital signal processing device also includes subtraction means for subtracting a pre-set value from an output signal obtained by the first and second amplitude control means.

When providing limiter means in the integrator of the sigma-delta modulation processing means for limiting the integrated value, the limiting value of the limiter means is set to an integer number times the maximum amplitude level width.

Muting pattern signal generating means is provided in one of the above-mentioned two channels.

In the digital signal processing method according to the present invention, switching between a delayed sigma-delta modulated signal obtained on delaying a sigma-delta modulated signal as an input signal obtained on sigma-delta modulation processing and a sigma-delta re-modulated signal obtained on second sigma-delta conversion processing on the input signal is done by a switching step. This realizes switching in a manner free from noise generation.

The digital signal processing method according to the present invention includes an amplitude controlling step of controlling the amplitude level of the level-adjusted signal having its amplitude level adjusted by the level adjustment step. The switching control step causes the switching step to switch the sigma-delta modulated signal from the input signal delaying step to the sigma-delta re-modulated signal obtained on sigma-delta modulation of the level-adjusted signal. The switching control step then causes the amplitude control step to control the amplitude of the level-adjusted signal. This realized switching between the amplitude-controlled sigma-delta signal and the original 1-bit signal free from deterioration in the sound quality in through-time.

The digital signal processing method according to the present invention first causes the switching control step to switch from the first delayed input signal to the sigma-delta re-modulated signal and then controls the operation of the first and second amplitude control steps for effecting cross-fading amplitude-control of the sigma-delta modulated signal and the other sigma-delta modulated signal, thus realizing cross-fading with minimum sound quality deterioration and suppression of the switching noise.

The invention will be further described by way of example, with reference to the accompanying drawings, in which:-

Fig.1 s a block diagram showing an arrangement of a digital ΣΔ modulator.

Fig.2 is a schematic block diagram of a multi-bit signal processing device.

Fig.3 is a schematic block diagram showing a conventional digital signal processing device handling a digital signal made up of a small number of bits.

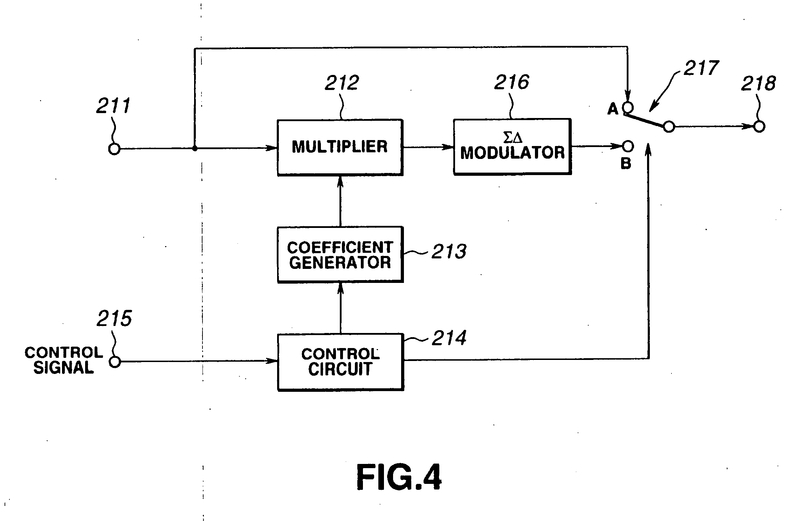

Fig.4 is a schematic block diagram showing a digital signal processing device configured for switching between an original signal made up of a small number of bits and a signal reconverted into the signal made up of the small number of bits.

Fig.5 is a block diagram of a first embodiment of the digital signal precessing method and apparatus according to the present invention.

Fig.6 is a circuit diagram showing an illustrative embodiment of an integrator in a ΣΔ modulator employed in the first embodiment of Fig.5.

Fig.7 is a circuit diagram of a ΣΔ modulator employing the illustrative embodiment of the integrator shown in Fig.2.

Fig.8 is an enlarged circuit diagram for illustrating the operation of a bit length converter employed in the first embodiment of Fig.5.

Fig.9 is a circuit diagram showing another illustrative embodiment of an integrator in the ΣΔ modulator employed in the first embodiment of Fig.5.

Fig.10 is a circuit diagram of a ΣΔ modulator employing another illustrative embodiment of the integrator shown in Fig.2.

Figs.11A, 11B are waveform diagrams for illustrating the effect of the first embodiment of Fig.5.

Fig.12 is a block diagram of a second embodiment of the digital signal precessing method and apparatus according to the present invention.

Fig.13 is a timing chart for illustrating the operation of the second embodiment of Fig.12.

Fig.14 is a block diagram of a third embodiment of the digital signal precessing method and apparatus according to the present invention.

Fig.15 is a timing chart for illustrating the operation of the third embodiment of Fig.14.

Fig.16 is a block diagram of a fourth embodiment of the digital signal precessing method and apparatus according to the present invention.

Fig.17 is a timing chart for illustrating the operation of the fourth embodiment of Fig.16.

Fig.18 is a block diagram of a fifth embodiment of the digital signal precessing method and apparatus according to the present invention.

Fig.19 is a waveform diagram of an output signal waveform for illustrating the operation of a level difference detector and a subtraction value processing controller employed in the fifth embodiment of Fig.18.

Fig.20 is a timing chart for illustrating the operation of the fifth embodiment of Fig.18.

Fig.21 is a circuit diagram showing a ΣΔ modulator having a first integrator fitted with a limiter.

Fig.22 is a block diagram shoving the inner structure of the first integrator fitted with the limiter shown in Fig.21.

Fig.23 is a block diagram of a sixth embodiment of the digital signal precessing method and apparatus according to the present invention.

Fig.24 is a timing chart for illustrating the operation of the sixth embodiment of Fig.23.

Fig.25 is a block diagram of a seventh embodiment of the digital signal precessing method and apparatus according to the present invention.

Fig.26 is a circuit diagram of a ΣΔ modulator having a local feedback loop.

Fig.27 s a block diagram showing details of essential parts of the seventh embodiment shown in Fig.25.

Fig.28 is a timing chart for illustrating the operation of the seventh embodiment of Fig.23.

Fig.29 is a block diagram of an eighth embodiment of the digital signal precessing method and apparatus according to the present invention.

Fig.30 is a circuit diagram showing a detailed structure of an amplitude controller of a first channel employed in the eighth embodiment.

Fig.31 is a circuit diagram showing a detailed structure of an amplitude controller of a second channel employed in the eighth embodiment.

Fig.32 is a timing chart for switching control of a changeover switch in case a cross-fading signal is supplied to the eighth embodiment.

Fig.33 is a block diagram of a ninth embodiment of the digital signal precessing method and apparatus according to the present invention.

Fig.34 is a block diagram of a tenth embodiment of the digital signal precessing method and apparatus according to the present invention.

Fig.35 is a timing chart for illustrating the operation of the tenth embodiment.

Fig.36 is a block diagram of an eleventh embodiment of the digital signal precessing method and apparatus according to the present invention.

Fig.37 is a timing chart for illustrating the operation of the eleventh embodiment.

Fig.38 is a block diagram of a twelfth embodiment of the digital signal precessing method and apparatus according to the present invention.

Fig.39 is a block diagram of a thirteenth embodiment of the digital signal precessing method and apparatus according to the present invention.

Fig.40 illustrates signal examples of an integrated value $S\alpha$ n an amplitude control output adjustment unit and an output $S\beta$ of an adder employed in the thirteenth embodiment for binary number calculation.

Fig.41 is a timing chart for illustrating the operation of a fourteenth embodiment f the digital signal processing method and apparatus according to the present invention.

Fig.42 is a timing chart for illustrating the operation of a digital signal processing method and apparatus as a modification of the fourteenth embodiment according to the present invention.

Fig.43 is a timing chart for illustrating the operation of the sixteenth embodiment f the digital signal processing method and apparatus according to the present invention.

Fig.44 is a timing chart for illustrating the operation of the sixteenth embodiment of Fig.23.

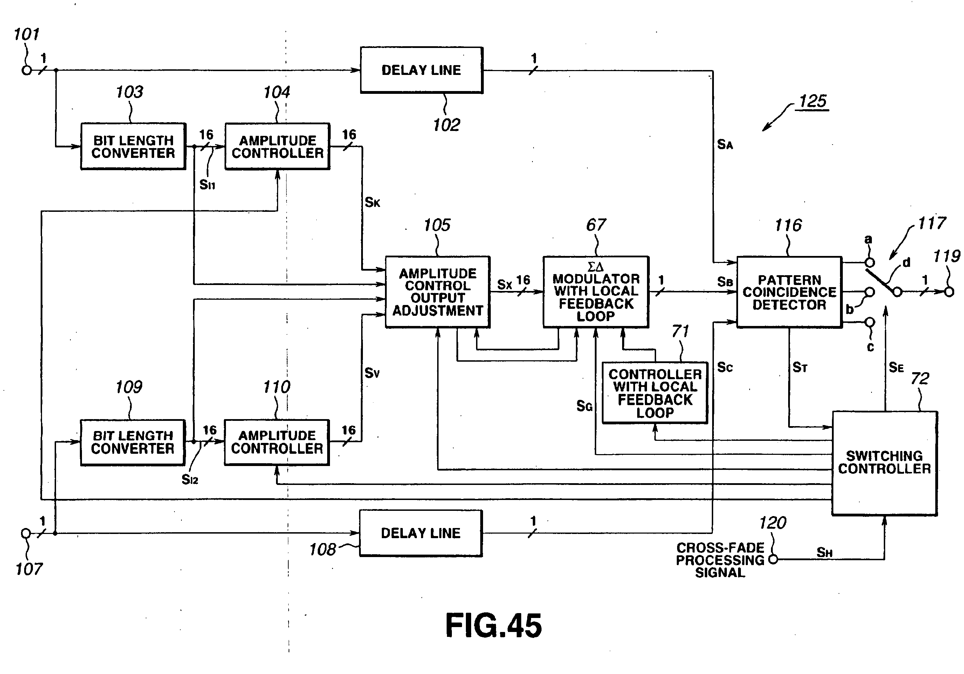

Fig.45 is a timing chart for illustrating the operation of a digital signal processing method and apparatus according to the seventeenth embodiment according to the present invention.

Fig.46 is a block diagram showing another illustrative embodiment of the structure in the vicinity of a subtraction value calculating controller in an amplitude control output adjustment unit employed in the seventeenth embodiment.

Fig.47 is a block diagram showing still another illustrative embodiment of the structure in the vicinity of a subtraction value calculating controller in an amplitude control output adjustment unit employed in the seventeenth embodiment.

Fig.48 is a block diagram showing yet another illustrative embodiment of the structure in the vicinity of a subtraction value calculating controller in an amplitude control output adjustment unit employed in the seventeenth embodiment.

Fig.49 is a timing chart for illustrating an example of the operation of the seventeenth embodiment of Fig.23.

Fig.50 is a timing chart for illustrating another example of the operation of the seventeenth embodiment of Fig.23.

Fig.51 is a block diagram showing a modification in which the $\Sigma\Delta$ modulator having the local feedback loop employed in the seventeenth embodiment is a $\Sigma\Delta$ modulator having the local feedback loop employing a variable gain multiplier.

Fig.52 is a timing chart for illustrating the operation of the modification shown in Fig.47.

Referring to the drawings, certain preferred embodiments of the digital signal processing method and apparatus of the present invention will be explained in detail.

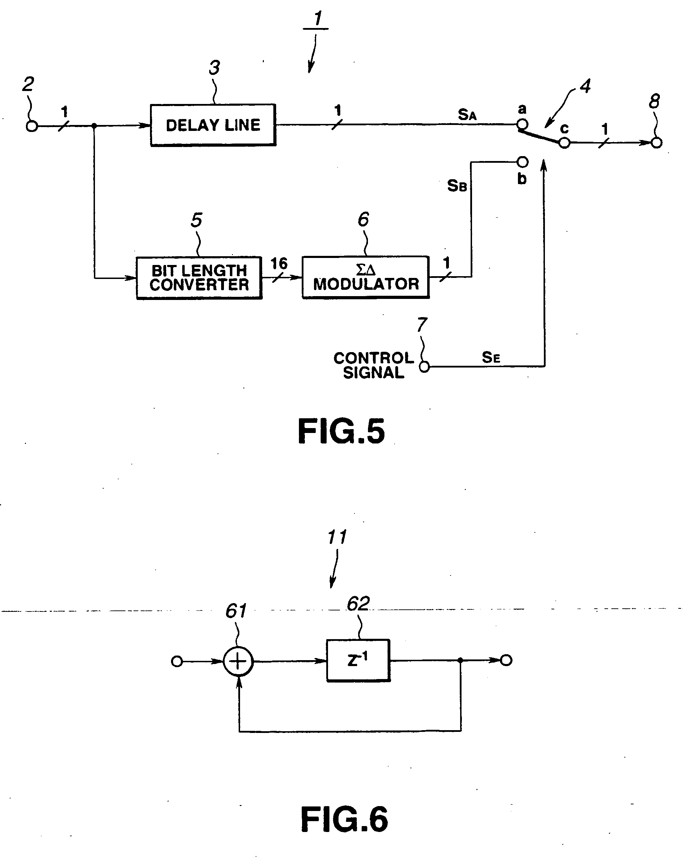

Referring to Figs.5 to 11, a first embodiment of the present invention is explained. The present first embodiment is directed to a digital signal processing device 1 configured for switching between a $\Sigma\Delta$ modulated signal $S_A$, as an input signal obtained on sigma-delta ($\Sigma\Delta$) modulation, and a $\Sigma\Delta$ re-modulated signal $S_B$, obtained on $\Sigma\Delta$ re-modulation on the input signal, by a changeover switch 4, as shown in Fig.5.

The digital signal processing device 1 includes a delay line 3 for delaying the original $\Sigma\Delta$ modulated signal from the input terminal 2 a pre-set number of samples, and a $\Sigma\Delta$ modulator 6 having five integrators and configured for outputting the above $\Sigma\Delta$ re-modulated signal with the gain ratio between the gain of the initial stage feedback loop and the gain of the next stage feedback loop set to 16. The digital signal processing device 1 also includes a bit length converter 5 for matching the amplitude level of the original $\Sigma\Delta$ modulated signal entering the $\Sigma\Delta$ modulator 6 to that of the feedback signal to the initial stage integrator employed in the $\Sigma\Delta$ modulator 6. The switching operation of the changeover switch 4 is controlled depending on a changeover control signal SE supplied from a control signal input terminal 7 for outputting the original $\Sigma\Delta$ modulated signal delayed a pre-set number of samples by the delay line 3 (original 1-bit delay signal) $S_A$ or the $\Sigma\Delta$ re-modulated signal ($\Sigma\Delta$ re-modulated 1-bit signal) $S_B$.

The $\Sigma\Delta$ modulator 6 is configured as a five-order (five-stage) $\Sigma\Delta$ modulator made up of five integrators. For example, a first integrator 11 is configured for shifting an addition output of an adder 61 by a shifter 62 for returning the shifted output to the adder 61, as shown in Fig.6. The remaining integrators are configured in a similar manner.

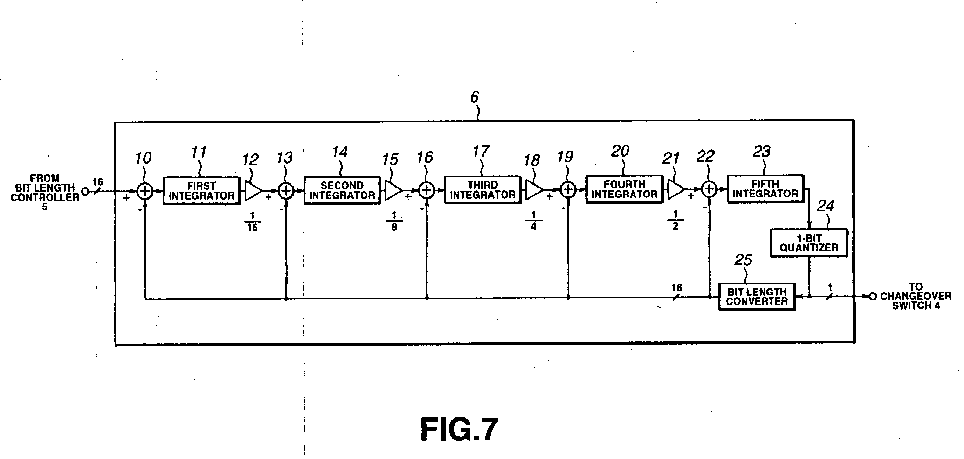

The 16-bit signal, having its amplitude level maximized to the maximum amplitude level by adjustment in the bit length converter 5, is integrated by the first integrator 11 via an adder 10, as shown in Fig.7, and is multiplied in a first coefficient multiplier 12 by a coefficient 1/16, so as to be then supplied to the second stage. An input signal to the second stage is integrated via an adder 13 by a second integrator 14 and multiplied by a second coefficient multiplier 15 with a coefficient 1/8 so as to be supplied to the third stage. An input signal to the third stage is integrated via an adder 16 of the third stage by a third integrator 17 and multiplied by a third coefficient multiplier 18 with a coefficient 1/4 so as to be supplied to the fourth stage. An input signal to the fourth stage is integrated via an adder 19 by a fourth integrator 20 and multiplied by ‰ by a fourth coefficient multiplier 21 so as to be supplied to a fifth stage. An input to the fifth stage is integrated via an adder 22 by a fifth integrator 23 and quantized by a 1-bit quantizer 24 into a 1-bit signal which is supplied to the changeover switch 4. The 1-bit signal is also converted into a 16-bit signal by a bit length converter 25 so as to be fed back to the adders 10, 13, 16, 19 and 22.

In the $\Sigma\Delta$ modulator 6, the gain ratio to the initial stage feedback loop exclusive of the integrator ahead and at back of the 1-bit quantizer 24 of the next-stage feedback loop is set to an integer value of 16, as will now be explained in detail.

The initial-stage feedback loop gain is

$$k \cdot (1 \cdot / 16) \cdot (1/4) \cdot (1/2) = (k/1024)$$

where k is the gain of the bit length converter 25.

The second-stage feedback loop gain is

$$k \cdot (1/8) \cdot (1/4) \cdot (1/2) = (k/64).$$

By dividing the second-stage feedback loop gain by the first-stage feedback loop gain, the gain ratio is given as

$$((k/64)/(k/1024)) = 16..$$

Based on this gain ratio, the delay line 3 sets the number of delayed samples to 16.

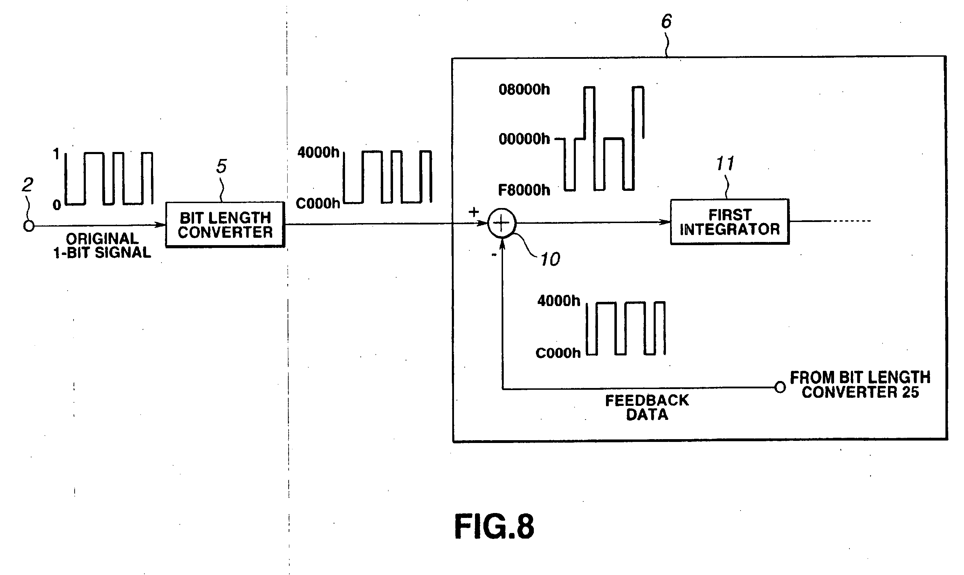

Referring to Fig.8, the bit length converter 5 converts the original 1-bit signal into 16-bit multiple-bit data so that the amplitude level will be of the same level as the amplitude level of the 16-bit feedback signal fed back from the 1-bit quantizer 24 via the bit length converter 25 to the first integrator 11 as the first-stage integrator.

The changeover switch 4 receives the $\Sigma\Delta$ modulated 1-bit signal $S_B$, obtained on $\Sigma\Delta$ modulation by the $\Sigma\Delta$ modulator 6, at a fixed terminal b, while receiving the original 1-bit signal $S_A$, delayed by 16 samples by the delay line 3, at a fixed terminal a. The changeover switch 4 brings a movable contact c into contact with the fixed terminals a or b depending on the changeover control signal SE supplied from the control signal input terminal 7 for supplying the original 1-bit signal or the $\Sigma\Delta$ modulated 1-bit signal $S_B$.

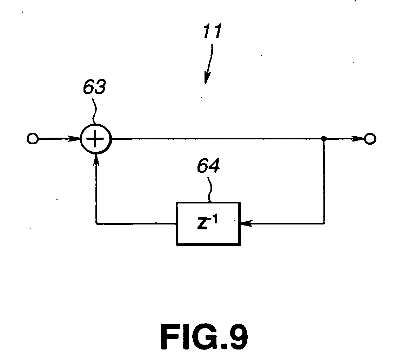

Meanwhile, with the digital signal processing device 1 of the present embodiment, the five integrators used in the $\Sigma\Delta$ modulator 6 may be configured as shown in Fig.9. For example, the first integrator 11 delays the addition output of an adder 63 by a shifter 64 as the addition output is fed back to the adder 63. The remaining integrators are configured in the similar manner.

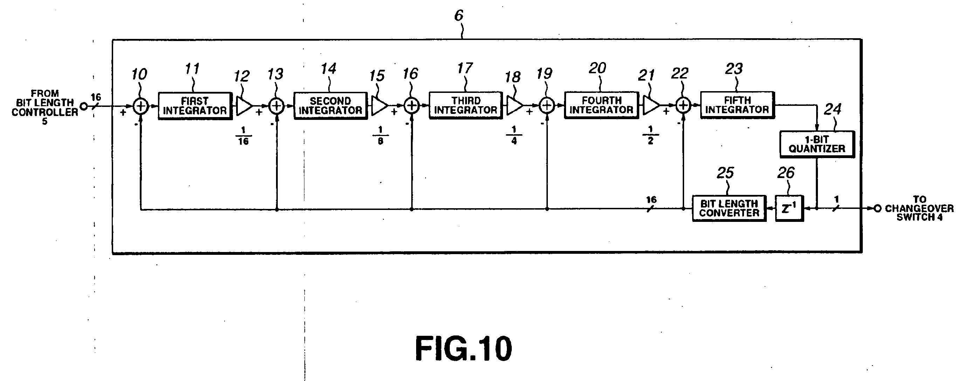

In this case, the $\Sigma\Delta$ modulator 6 has its feedback loop structure modified from that shown in Fig.7, as shown in Fig.10. That is, a shifter 26 is provided ahead of the bit length converter 25.

The 1-bit quantizer 24 quantizes the integration output of the fifth integrator 23 into 1-bit data. The 1-bit signal of the 1-bit quantizer 24 is supplied via shifter 26 to the bit length converter 25, while being supplied to the fixed terminal b of the changeover switch 4. The bit length converter 25 re-converts the delayed 1-bit signal into a 16-bit signal which is supplied to the adders 10, 13, 16, 19 and 22.

In the case of the $\Sigma\Delta$ modulator 6 having the integrator configured as shown in Fig.9, the number of delays in terms of the input/output difference becomes smaller by one sample, so that the number of delay samples of the delay line 3 is equal to (gain ratio - 1), based on the integer gain ratio of the second stage feedback loop gain to the first stage feedback loop gain, ahead and at back of the 1 bit quantizer 24, excluding the integrator. Thus the number of delay samples of the delay line 3 is 16 - 1 = 15.

At any rate, with the present first embodiment of the digital signal processing device 1 of the present first embodiment, the gain ratio of the second stage feedback loop gain to the first stage feedback loop gain in the $\Sigma\Delta$ modulator 6 is set to an integer, while the number of delay samples of the delay line 3, is determined on the basis of the gain ratio.

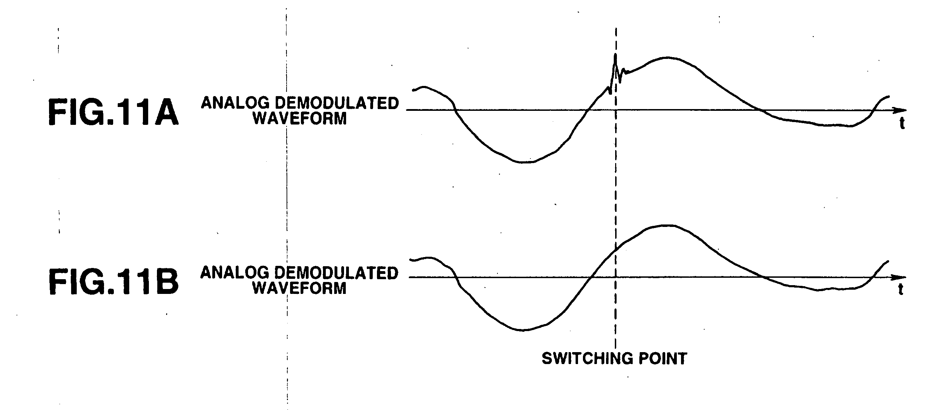

With the present digital signal processing device 1, the noise generated at a switching point as shown in Fig.IIA in case an output of the conventional digital signal processing device, such as the device configured as shown in Fig. 1, is converted into an analog audio signal, may be suppressed, as shown in Fig.11B.

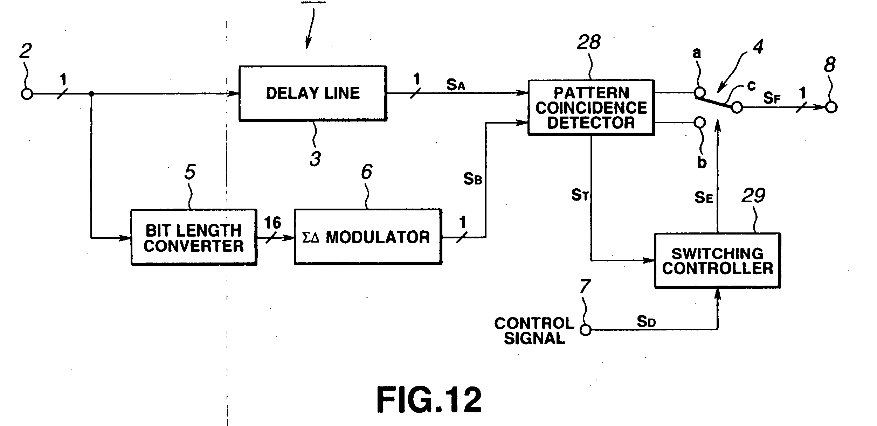

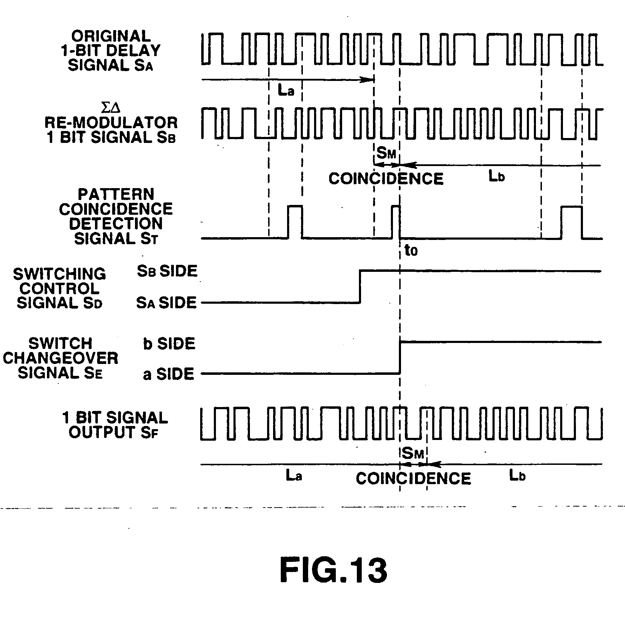

A second embodiment is now explained by referring to Figs.12 and 13. The second embodiment is directed to a digital signal processing device 27 configured for switching between the $\Sigma\Delta$ modulated signal $S_A$, as an input signal obtained on $\Sigma\Delta$ modulation, and a re-modulated signal $S_B$, obtained on $\Sigma\Delta$ remodulation of the input signal. The digital signal processing device 27, however, is designed for detecting coincidence between the $\Sigma\Delta$ modulated signal $S_A$ and the $\Sigma\Delta$ re-modulated signal $S_B$ over plural samples and switches between the $\Sigma\Delta$ modulated signal $S_A$ and $\Sigma\Delta$ re-modulated signal SB responsive to the pattern coincidence detection signal.

The digital signal processing device 27 corresponds to the digital signal processing device 1 of the first embodiment shown in Fig.5 to which are added a pattern coincidence detector 28 and a switching controller 29. The present second embodiment is otherwise the same as the first embodiment so that the corresponding parts are depicted by the same numerals and the corresponding description is not made. The $\Sigma\Delta$ modulator 6 may be configured as shown in Fig. 7 as a five-order $\Sigma\Delta$ re-modulator employing five integrators shown in Fig.6, or may also be configured as shown in Fig. 10 as a five-order $\Sigma\Delta$ re-modulator employing five integrators shown in Fig.7.

The pattern coincidence detector 28 monitors the original 1-bit delayed signal $S_A$ from the delay line 3 and the $\Sigma\Delta$ re-modulated signal $S_B$ from the $\Sigma\Delta$ modulator 6 and, on detection of pattern coincidence continuing over, for example, four samples, generates a pattern coincidence detection signal $S_T$ which is sent to the switching controller 29.

The switching controller 29 controls the switching of the changeover switch 4 in order to output the original 1-bit delayed signal $S_A$ or the $\Sigma\Delta$ re-modulated 1-bit signal $S_B$ at the changeover switch 4.

Fig.13 illustrates, in a timing chart, the operation of the digital signal processing device 27.

Directly after inversion from the side $S_A$ to the side $S_B$ of a changeover control signal $S_D$ supplied from the control-signal input terminal 7, the switching controller 29 generates a switch changeover signal SE from the fixed terminal a to the fixed terminal b, at the next sampling timing t0 of reception of the pattern coincidence detection signal $S_T$ supplied from the pattern coincidence detector 28, and sets the movable contact piece c of the changeover switch 4 from its fixed terminal a to its fixed terminal b.

The digital signal processing device 27 then sums a signal $S_M$ of the four sample pattern coincident portion to the original 1-bit delay signal $S_A$ for a period La and further sums the $\Sigma\Delta$ re-modulated 1-bit signal $S_B$ to the resulting signal to produce a 1-bit signal output $S_F$ which is outputted at the output terminal 8.

Thus, the present digital signal processing device 27 first controls the changeover timing by pattern coincidence detection by the pattern coincidence detector 28 and subsequently switches between the original 1-bit delay signal $S_A$ and the $\Sigma\Delta$ re-modulated 1-bit signal $S_B$, so that switching can be done under more reliable noise suppression.

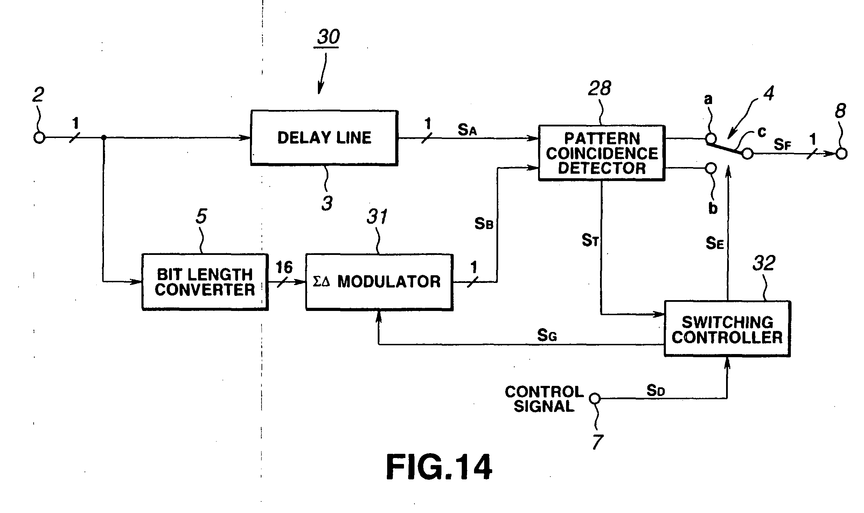

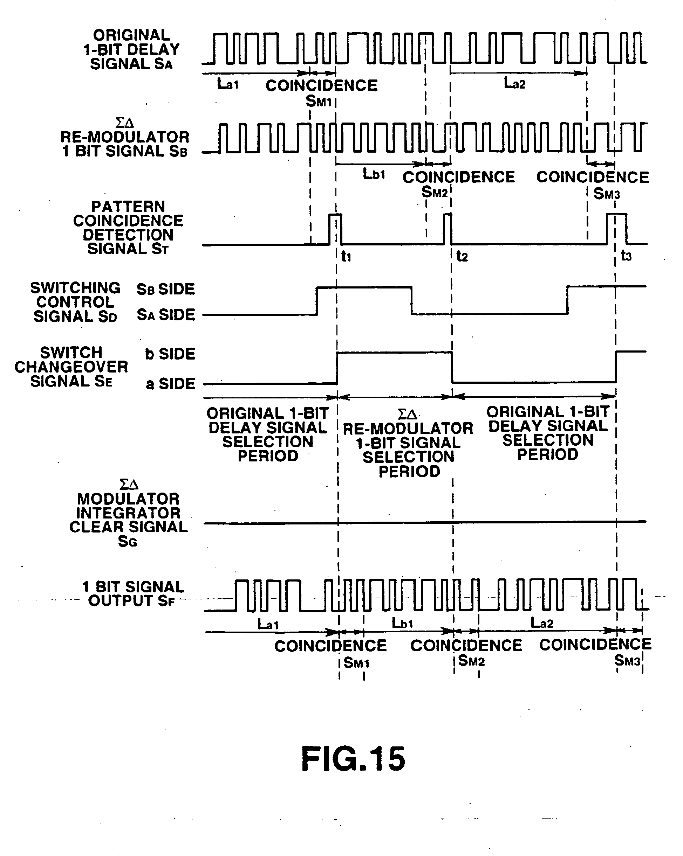

Referring to Figs.14 and 15, a third embodiment will be explained in detail. The present third embodiment is directed to a digital signal processing device 30 which, when switching between the original 1-bit delayed signal $S_A$ and the $\Sigma\Delta$ re-modulated 1-bit signal $S_B$, detects coincidence between these signals $S_A$ and $S_B$ over plural samples and switches between the signals $S_A$ and SB responsive to the pattern coincidence detection signal. However, the initial value of the integrator in the $\Sigma\Delta$ modulator is cleared to zero directly before inputting of the $\Sigma\Delta$ modulated signal to the input terminal 2 and/or during the time of selection by the changeover switch 4 of the original 1-bit delay signal $S_A$ from the 16-tap delay line 3.

A $\Sigma\Delta$ modulator 31 corresponds to the $\Sigma\Delta$ modulator 6 of the digital signal processing device 27 of the second embodiment of Fig.12 to which has been added an integrator 0-clear controller designed for clearing the initial value of the integrator to 0 by a $\Sigma\Delta$ modulator integrator clear signal $S_G$ supplied from a switching controller 32. The present digital signal processing device is otherwise the same as the second embodiment so that equivalent parts are denoted by the same numerals and the corresponding description is not made. The $\Sigma\Delta$ modulator 31 may be configured as a five-order $\Sigma\Delta$ modulator employing five integrators shown in Fig.6, as shown in Fig.7, or may also be configured as a five-order $\Sigma\Delta$ modulator employing five integrators shown in Fig.9, as shown in Fig.10.

Fig.15 shows, by a timing chart, the operation of the present digital signal processing device 30. The pattern coincidence detector 28 monitors the original 1-bit delay signal $S_A$ from the delay line 3 and the $\Sigma\Delta$ re-modulated 1-bit signal $S_B$ from the $\Sigma\Delta$ modulator 6, every sampling period, and generates a pattern coincidence detection signal $S_T$ if 1-bit data coincide for four samples on end. Here, four patterns coincide at three pattern coincident portions SM1, SM2 and SM3. Directly after inversion to the side $S_A$ or to the side $S_B$ of the switching control signal $S_D$ entering the control signal input terminal 7, the switching controller 32 inverts the switch changeover signal SE to the fixed terminal a or to the fixed terminal b at the sampling timings t1, t2 and t3 next to the reception of the pattern coincidence detection signal $S_T$ supplied from the pattern coincidence detector 28. Also, during the time the delayed original 1-bit signal $S_A$ is selected by the changeover switch 4, the switching controller 32 sends the $\Sigma\Delta$ re-modulator integrator clear signal $S_G$ to the $\Sigma\Delta$ modulator 31. Thus the integrated value accumulated in the integrator in the $\Sigma\Delta$ modulator 31 is cleared to zero before an output of the bit length converter 5 is supplied to the $\Sigma\Delta$ modulator 31.

The digital signal processing device 30 then connects the original 1-bit delay signal $S_A$ over a period $L_{a1}$ to the

ΣΔ modulated 1-bit signal $S_B$ over a period $L_{b1}$ with tie interposition of the pattern coincident portion $S_{M1}$ and further connected to the resulting signal the original 1-bit delay signal $S_A$ over a period $L_{a2}$ with the interposition of the four-pattern coincident portion $S_{M2}$ to produce a 1-bit signal output $S_F$ which is outputted at the output terminal 8.

With the present digital signal processing device 30, switching under more reliable noise suppression may be realized since the original ΣΔ modulated signal is supplied to the integrator in the ΣΔ modulator 31 from the state of the zero integrated value.

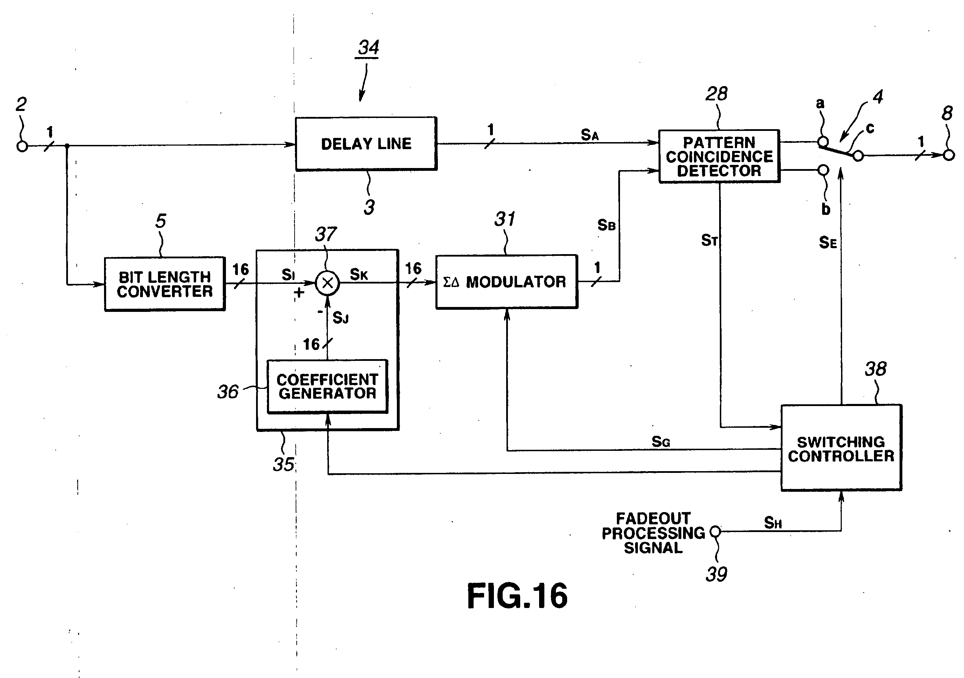

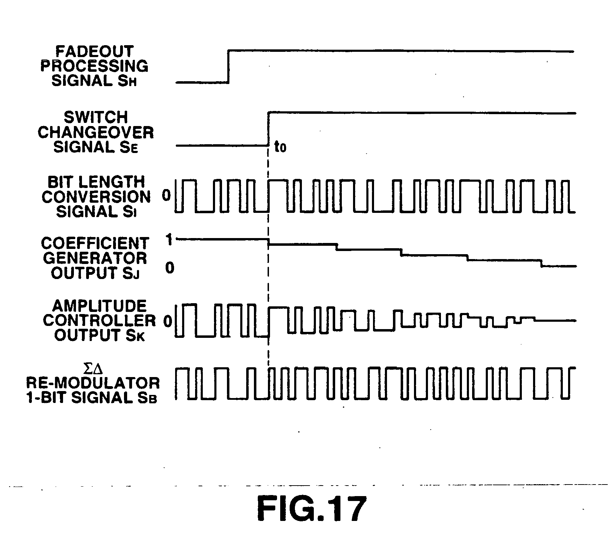

Referring to Figs.16 and 17, a fourth embodiment is now explained. The present fourth embodiment is directed to a digital signal processing device 34 switching between the delayed original 1-bit signal $S_A$ and the ΣΔ re-modulated 1-bit signal $S_B$ obtained on clearing the integrated value in the integrator in the ΣΔ modulator 31 as described above to zero, after detection of coincidence of several patterns on end by pattern coincidence detection, as shown in Fig.16. However, the digital signal processing device 34 converts the ΣΔ re-modulated 1-bit signal $S_B$ into a signal processed with fade-out which is a sort of amplitude control processing.

The amplitude control processing is such signal processing in which signal processing is done in the amplitude direction, such as fade-out in which the reproduced audio signal level is gradually lowered with time, fade-in in which the audio signal level is gradually raised from the zero level, or cross-fade.

A digital signal processing device 34, as a fourth embodiment, is provided with an amplitude controller 35 between the ΣΔ modulator 31 and the bit length converter 5 of the digital signal processing device 30 of the third embodiment. The amplitude controller 35 is controlled by a switching controller 38.

The amplitude controller 35 performs amplitude control processing, such as fade-out described above, on a bit-length-converted signal $S_I$, as a level-adjusted signal outputted by the bit length converter 5. Before starting the amplitude control by the amplitude controller 35, the switching controller 38 causes the changeover switch 4 to perform switching from the original 1-bit delay signal $S_A$ to the ΣΔ re-modulated 1-bit signal $S_B$ obtained on ΣΔ re-modulation of the bit-length-converted signal $S_I$ by the ΣΔ modulator 31. The amplitude level of the bit-length-converted signal $S_I$ at this time is of the maximum amplitude level.

Fig.17 illiterates, by a timing chart, the operation of the present digital signal processing device 34. When a fade-out precessing signal $S_H$ is suppled from a control signal input terminal 39 to a switching controller 38, the switching controller 38 sends a switching control signal $S_E$ to the changeover switch 4 after waiting for supply of the four-pattern coincidence detection signal $S_T$ from the pattern coincidence detector 28. In this case, the movable contact c of the changeover switch 4 is changed over from the fixed terminal a to the fixed terminal b. The changeover switch 4 then switches, at a changeover timing t0, from the original 1-bit delay signal $S_A$ to the ΣΔ re-modulated 1-bit signal $S_B$ obtained on directly ΣΔ modulating the bit length conversion signal $S_I$.

During the time the original 1-bit delay signal $S_A$ is selected by the changeover signal 4, the switching controller 38 sends the ΣΔ re-modulator integrator clear signal $S_G$ to the ΣΔ modulator 31.

After the switch 4 is changed over to the signal $S_B$, the switching controller 38 causes transition of a coefficient output SJ of a coefficient generator 36 of the amplitude controller 35 from 1 to 0.

The amplitude controller 35 also includes a multiplier 37 and multiplies the bit-length-converted signal $S_I$ with the coefficient output SJ which undergoes transition from 1 to 0 on execution of the fade-out processing. The amplitude controller 35 then causes an amplitude controller output $S_K$ to undergo transition from the maximum amplitude level to the zero level.

The ΣΔ modulator 31 may be configured as a five-order ΣΔ modulator employing five integrators shown in Fig. 6, as shown in Fig.7, or may also be configured as a five-order ΣΔ modulator employing five integrators shown in Fig. 9, as shown in Fig.10.

The ΣΔ modulator 31 ΣΔ re-modulates the amplitude controller output $S_K$ and outputs the ΣΔ re-modulated 1-bit signal $S_B$. Thus, if the 1-bit signal obtained at the output terminal 8 is restored to the analog audio signal by a low-pass filter, a fade-out processed signal can be heard, in which the noise otherwise produced on switching from the analog audio signal to a zero-amplitude level is suppressed.

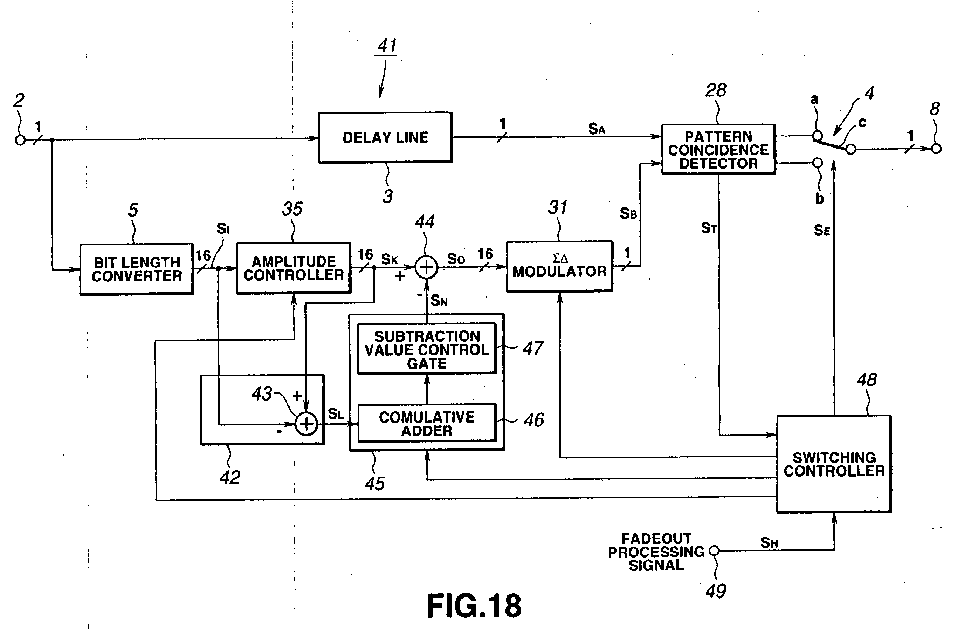

Referring to Figs.18 to 20, a fifth embodiment is explained. The present fifth embodiment s directed to a digital signal processing device 41 switching between the delayed original 1-bit signal obtained on ΣΔ modulation and the ΣΔ re-modulated 1-bit signal $S_B$ obtained on clearing the integrated value in the integrator in the ΣΔ modulator to zero after detection of coincidence of several patterns on end by pattern coincidence detection. However, the digital signal processing device 41 sets the ΣΔ re-modulated 1-bit signal $S_B$ into a signal processed with fade-out/in processing and connects the signal SB to the original 1-bit delay signal $S_A$.

The fade-out/in precessing means such processing in which fade-in precessing is performed in succession to the fade-out processing. The present digital signal processing device 41 thus performs amplitude control processing in which the original 1-bit delay signal $S_A$ is, as it were, processed with fade-in and subsequently restored to the original level.

To this end, the digital signal processing device 41 includes, in addition to the delay line 3, pattern coincidence detector 28, bit length converter 5, amplitude controller 35 and the ΣΔ modulator 31, a level difference detector 42, a cumulative adder 46, a subtraction value control gate 47 and a switching controller 48, as shown in Fig.18. The level difference detector 42 detects the difference between the maximum amplitude level of the bit length conversion output $S_I$ entering the $\Sigma\Delta$ modulator 31 during the time the amplitude controller 35 is controlling the amplitude level 1 of the bit-length-converted output $S_I$ of the bit length converter 5 and the amplitude level of the amplitude-controlled output. The cumulative adder 46 cumulatively sums the level difference from the level difference detector 42 with the maximum amplitude level width length which is twice as large as the above-described maximum amplitude level. The subtraction value control gate 47 gradually subtracts the cumulative sum value of the cumulative adder 46 from the maximum amplitude level of the amplitude controller output $S_K$ entering the $\Sigma\Delta$ modulator 31 after amplitude control by the amplitude controller 35 using an adder/subtractor 44. The switching controller 48 controls the operation of the amplitude controller 35 as will be explained subsequently. In addition, after end of the subtraction control of the cumulative sum value from the maximum amplitude level by the subtraction value control gate 47, the switching controller causes the changeover switch 4 to switch the output of the $\Sigma\Delta$ modulator 31 to the original 1-bit delay signal $S_A$ after pattern coincidence detection by the pattern coincidence detector 28 and to output the signal $S_A$. The cumulative adder 46 and the subtraction value control gate 47 make up the subtraction value processing controller 45.

The amplitude controller 35 has a configuration shown in Fig.16, that is, includes the coefficient generator 36 and the multiplier 37. The coefficient generator 36 generates a coefficient output SJ undergoing transition from 1 t 0 and then from 0 to 1, in a manner of executing the fade-out/in processing, under control by the switching controller 48. The multiplier 37 multiplies the bit length conversion signal SL with the above coefficient output SJ.

The level difference detector 42 is configured as shown in Fig.16, that is, the detector 42 detects the difference between the maximum amplitude level of the bit-length-converted output $S_I$ entering the $\Sigma\Delta$ modulator 31 during the time the amplitude controller 35 is controlling the amplitude level of the bit length conversion output $S_I$ of the bit length converter 5 and the output $S_K$ of the amplitude controller 35 and sends the level difference detection output SL to the cumulative adder 46 in the subtraction value processing controller 45.

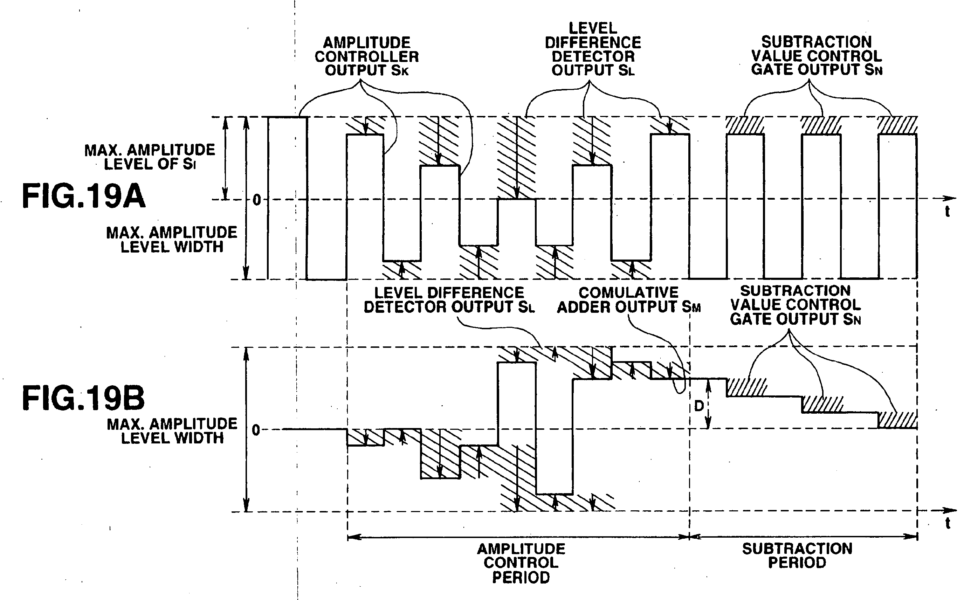

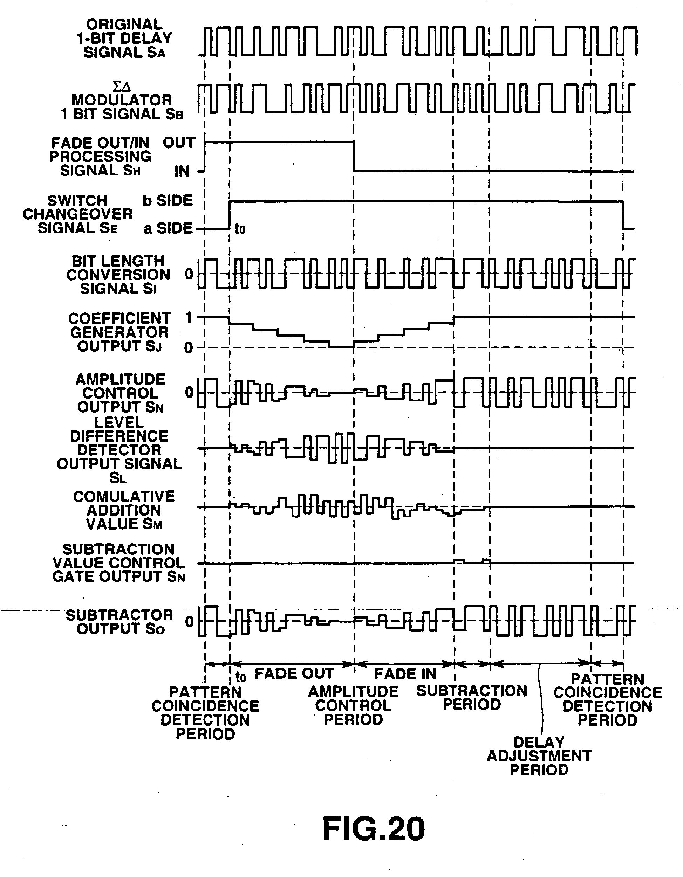

Referring to Figs.19 and 20, the operation of the present digital signal processing device 41 is explained. Fig. 19 is an output signal waveform diagram for illustrating the operation of the level difference detector 42 and the subtraction value processing controller 45. Fig.20 is a timing chart for illustrating the fade-out/in processing performed by the digital signal processing device 41.

When the fade-out/in processing signal $S_H$ is supplied from a control signal input terminal 49 to the switching controller 48, the switching controller 48 first awaits the oncoming of the 4-pattern coincidence detection signal $S_T$ for the pattern coincidence detection circuit 28, and subsequently routes a switch changeover signal $S_E$ to the changeover switch 4. The switching controller 48 then causes the movable contact c of the changeover switch 4 to be changed over from the fixed terminal a to the fixed terminal b. Then, at a switching timing t0, the changeover switch 4 switches the bit length conversion signal $S_I$ from the original 1-bit delayed signal $S_A$ to the $\Sigma\Delta$ re-modulated 1-bit signal $S_B$.

Meanwhile, during the time the original 1-bit delay signal $S_A$ is being selected by the changeover switch 4, the changeover switch 4 is supplying the $\Sigma\Delta$ re-modulator integrator clear signal $S_G$ to the $\Sigma\Delta$ modulator 31.

After the switch 4 is changed over to $S_B$, the switching controller 48 causes transition of the coefficient output SJ of the coefficient generator 36 of the amplitude controller 35 from 1 to 0 and then again to 1. This causes transition of the level of the input signal to the $\Sigma\Delta$ modulator 31, that is the level of the subtractor output So, to the 0 level, and then again to the maximum amplitude level. ,

During this time, the level difference detector 42 detects the level difference of the amplitude level of the amplitude controller output $S_K$ relative to the maximum amplitude of the bit length converter output $S_I$, and outputs a level difference detector output $S_L$ to the cumulative adder 46 of the subtraction value processing controller 45, as shown in Fig.19A.

The cumulative adder 46 cumulatively sums the level difference detector output $S_L$ during the amplitude control period. In particular, the cumulative adder 46 is made up of a signed accumulator for the maximum amplitude level width length which is twice as large as the above-described maximum amplitude level. In case of overflow of the cumulative addition, the cumulative adder 46 undergoes cycling and outputs a cumulative ader output $S_M$.

When the amplitude control output $S_K$ of the amplitude controller 35, that is the input signal to the $\Sigma\Delta$ modulator 31, again reaches the maximum amplitude level, data D so far accumulated in the cumulative adder 46 is gradually discharged via the subtraction value control gate 47. The discharged data corresponds to a subtraction value control gate $S_N$ and is subtracted from the maximum amplitude level input signal to the $\Sigma\Delta$ modulator 31 by the adder/subtractor 44 so that a subtractor output So is fed to the $\Delta\Sigma$ modulator 31.

When the cumulative sum value $S_M$ reaches zero through the process of subtraction, the switching controller 48 awaits the oncoming of the pattern coincidence signal $S_T$ from the pattern coincidence detector 28, after delay on the delay line 3, and then causes the changeover switch 4 to perform switching from the $\Sigma\Delta$ modulator output signal $S_B$ to the original 1-bit delay signal $S_A$.

Thus, if the 1-bit signal outputted at the output terminal 8 is restored via the low-pass filter to the analog audio signal, fade-out/in precessing from the original audio signal through the zero amplitude level to the original audio signal may be realized under noise suppression.

With the present digital signal processing device 41. the $\Sigma\Delta$ modulator 31 may be configured as a five-order $\Sigma\Delta$ modulator employing five integrators shown in Fig.6, as shown in Fig.7, or may also be configured as a five-order $\Sigma\Delta$ modulator employing five integrators shown in Fig.9, as shown in Fig.10.

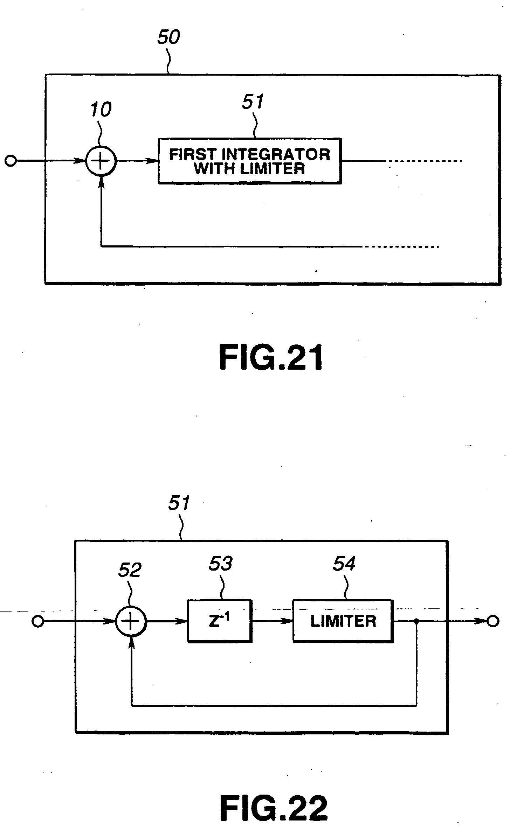

Also, for preventing oscillation of the $\Sigma\Delta$ modulator 31, the first integrator 11 shown in Fig.2 may be configured as a first integrator 51 fitted with a limiter, as shown in Fig.21. This first integrator 51 fitted with the limiter limits the integrated value of the first integrator to a value equal to an integer number times the maximum amplitude level value.

If the limiter function is operating under such a state in which the integrated value of the first integrator exceeds the limiter value, the switching controller 48 clears the cumulative addition value of the cumulative adder 46 to zero.

The first integrator 51 fitted with the limiter is made up of an adder 52, a shifter 53 and a limiter 54, and feeds back an output limited by the limiter 54 to the adder 52.

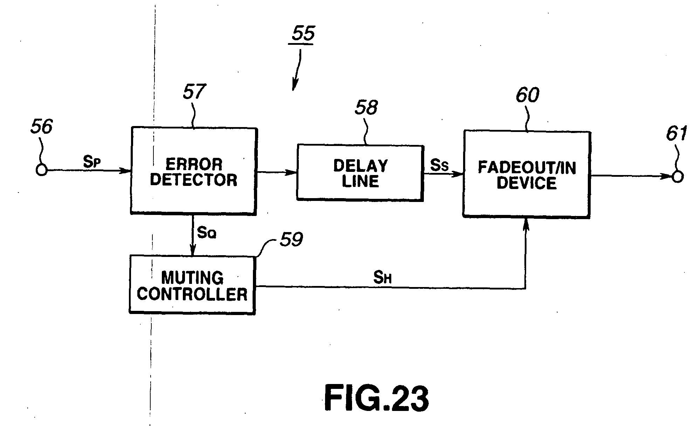

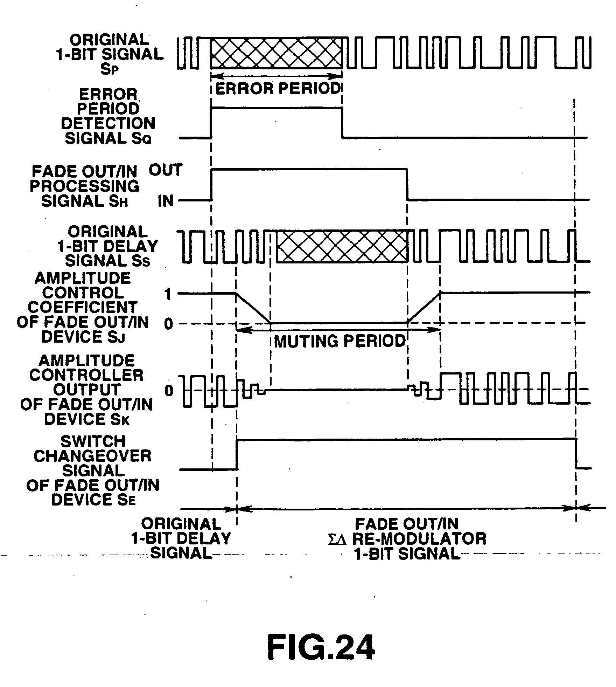

Referring to Figs.23 and 24, a sixth embodiment is explained. This sixth embodiment is directed to a digital signal processing device 55 which, if an input original 1-bit signal $S_P$ contains an uncorrectable burst error, fades-out the 1-bit signal directly before the burst error using a fade-in device 60, and fades-in the signal directly after the burst error, thus muting the 1-bit signal during the period of occurrence of the burst error.

This digital signal processing device 55 includes an error detector 57 for detecting the uncorrectable burst error contained in the original 1-bit signal $S_P$ supplied from an input terminal 56, a delay line 58 arranged downstream of the error detector 57 for delaying the original 1-bit signal $S_P$ and a fade-out/fade-in device 60 for fading-out and fading-in the delayed 1-bit signal $S_S$ from the delay line 58. The digital signal processing device 55 also includes a muting controller 59 which, on detection by the error detector 57 of the uncorrectable burst error in the original 1-bit signal $S_P$, immediately fades-out the delayed 1-bit signal lying directly before the uncorrectable burst error in the delayed 1-bit signal $S_S$ from the delay line 58, using the fade/out/in device 60, and fades-in the delayed 1-bit signal immediately after the burst error to the maximum amplitude level using the fade-out/in device 60.

As the above fade-out/in device 60, the digital signal processing device 41 as shown in Fig.18 may be used. For executing the fade-out processing, the amplitude controller 35 is actuated. In effect, after the switching controller 48 switches the delayed $\Sigma\Delta$ modulated signal from the delay line 3 to the $\Delta\Sigma$ re-modulated signal from the $\Sigma\Delta$ modulator 31, the amplitude controller 35 controls the amplitude level of the level adjustment signal in order to execute the fade-out processing.

For executing the fade-in processing, the amplitude controller 35, level difference detector 42, cumulative adder 46 and the subtraction value control gate 47 are actuated. In effect, after the switching controller 48 switches the $\Sigma\Delta$ re-modulated signal to the delayed $\Sigma\Delta$ modulated signal after the end of subtraction of the cumulative sum in the subtraction value control gate 47 with the aid of the changeover switch 4, the amplitude controller 35, level difference detector 42, cumulative adder 46 and the subtraction value control gate 47 execute the fade-in processing.

The operation of the digital signal processing device 55 is explained by referring to the timing chart of Fig.24.

If, in a system for transmitting or recording the original 1-bit signal $S_P$, an uncorrectable burst error is produced, the error detector 57 generates an error period detection signal $S_Q$ specifying the error period. On reception of error period detection signal $S_Q$, the muting processor 59 sends a fade-out/in processing signal $S_H$ to the switching controller 48 in the fade-out/in device 60 shown in Fig.18. In this fade-out/in processing signal SH, the transition has been made from the fade-out/in processing to the fade-out processing. After awaiting the pattern coincidence signal $S_T$ fed from the pattern coincidence detector 28, the switching controller 48 causes the changeover switch 4 to switch from the 1-bit signal $S_A$ to the $\Sigma\Delta$ modulated output $S_B$ of the $\Sigma\Delta$ modulator 31. The 1-bit signal $S_A$ corresponds to the original 1-bit signal $S_P$ delayed by the delay line 58 and then re-delayed by the delay line 3.

In response thereto, the coefficient generator 36 in the amplitude controller 35 in the fade-out/in device 60 immediately causes transition of the coefficient from 1 to 0, and completes the transition before error data during the error period reaches the $\Sigma\Delta$ modulator 31 through the delay line 58. When the error period comes to a close and the error period detection signal $S_Q$ is canceled, the muting controller 59 causes transition of the fade-out/in signal to the fade-in processing side after delay by the delay line 58. In response thereto, the coefficient generator 36 in the amplitude controller 35 immediately causes transition from 0 to 1.

The subtraction value processing controller 45 cumulatively sums the level difference detector output signal $S_L$ from the level difference detector 42 to be cumulatively summed by the cumulative adder 46, as explained with reference to Fig.19. When the input signal to the $\Sigma\Delta$ modulator 31 again reaches the above-mentioned maximum amplitude level, data D so far accumulated in the cumulative adder 46 is gradually discharged via the subtraction value control gate 47. This data D, as the subtraction value control gate output SN, is subtracted by the subtractor 44 from the maximum amplitude level input signal to the $\Sigma\Delta$ modulator 31 to supply the subtractor output $S_o$ to the $\Sigma\Delta$ modulator 31.

When the cumulative sum value $S_M$ reaches zero through the subtraction period, the switching controller 48 first awaits, after delay by the delay line 31, the oncoming of the pattern coincidence detection signal $S_T$ from the pattern coincidence detector 28, and subsequently causes the changeover switch 4 to switch from the $\Sigma\Delta$ modulator output signal $S_B$ to the 1-bit signal $S_A$. The 1-bit signal SA corresponds to the original 1-bit signal $S_S$ delayed from the $\Sigma\Delta$ modulated signal $S_B$ and further delayed by the delay line 3.

If, when an uncorrectable burst error is produced, the 1-bit output signal of the fade-out/in device 60 is returned via the low-pass filter to an analog audio signal, muting processing, in which the signal level is reduced to a zero level under noise suppression, is realized.

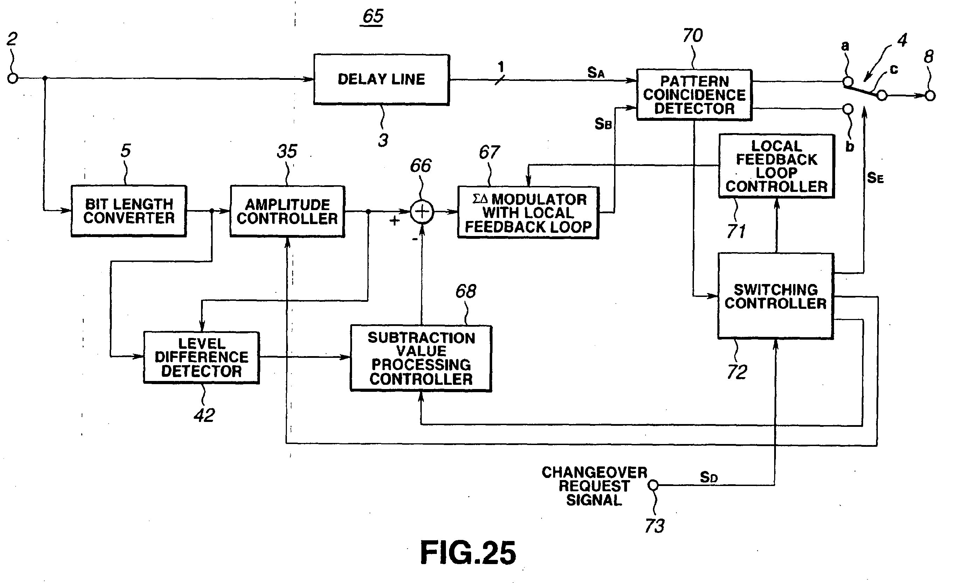

Referring to Figs.25 to 28, a seventh embodiment is explained. This seventh embodiment is directed to a digital signal processing device 65 switching between the original 1-bit delay signal $S_A$ and the 1-bit signal $S_B$, obtained on $\Sigma\Delta$ re-modulating the amplitude-controlled signal by a as $\Sigma\Delta$ modulator having a local feedback loop 67 ($\Sigma\Delta$ modulator having a local feedback lop), as shown in Fig.25.

With the present digital signal processing device 65, the $\Sigma\Delta$ modulator having a local feedback loop 67 shown in Fig. .25 is used in place of the $\Sigma\Delta$ modulator 31 of the digital signal processing device 41 of the fifth embodiment.

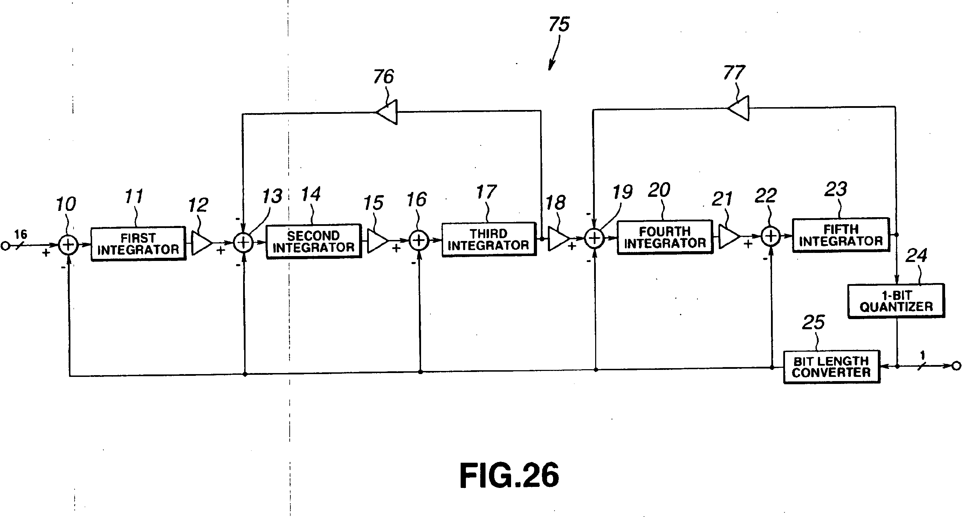

The local feedback loop is a well-known technique. Fig.26 shows an arrangement in which two local feedback loops having two gain multipliers 76, 77 are applied to a five-order $\Sigma\Delta$ modulator having five integrators shown in Fig.6, as shown in Fig.7. With a $\Sigma\Delta$ modulator having the local feedback loop 75, it is possible to optimize the quantization noise components in the audible range for setting a dynamic rang to a broader value.

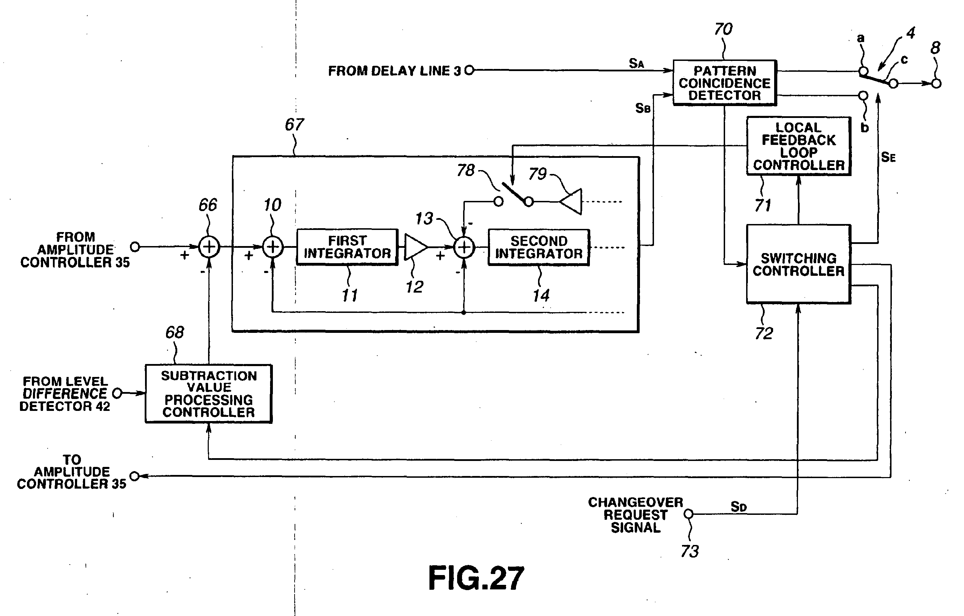

In effect, with the digital signal processing device 65 of the present seventh embodiment, a switch 78 shown in Fig.27 is provided in a feedback loop of the $\Sigma\Delta$ modulator having a local feedback loop 67 for controlling the switching timing by a local feedback loop controller 71.

The above processing is done for suppressing the noise generated on switching between the $\Sigma\Delta$ re-modulated signal obtained by $\Sigma\Delta$ modulator having the local feedback loop 75 and the original 1-bit signal.

That is, the digital signal processing device 65 includes a delay line 3, the bit-length converter 5, the amplitude controller 35, the level difference detector 42, an adder 66, the $\Sigma\Delta$ modulator having the local feedback loop 67, the changeover switch 4, a switching controller 72, a subtraction value processing controller 68 for each integrator, a pattern coincidence detector 70 and a local feedback loop controller 71.

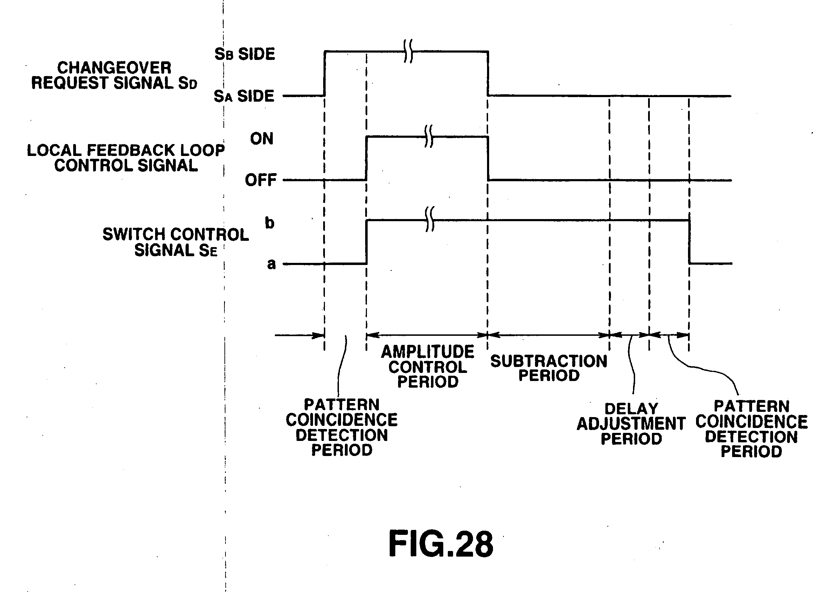

The operation of the digital signal processing device 65 is explained by referring to the timing chart of Fig.28.

During the time the original 1-bit delay signal $S_A$ is selected by the changeover switch 4, the local feedback loop controller 71 turns the local feedback loop of the $\Sigma\Delta$ modulator having a local feedback loop 67 off so as not to perform local feedback. On reception of a switching request signal $S_D$ for switching from the delayed original 1-bit signal $S_A$ to the $\Sigma\Delta$ re-modulated signal $S_B$, the switching controller 72 first detects the coincidence at the pattern coincidence detector 70 and subsequently causes the changeover switch 4 to switch from the delayed original 1-bit signal to the $\Delta\Sigma$ re-modulated signal $S_B$.

In response thereto, the local feedback loop 71 turns the local feedback loop control signal on and, by turning the switch 78 on, shorts the local feedback loop of the $\Sigma\Delta$ modulator having a local feedback loop 67 on to render local feedback active. On reception of the switching request signal $S_D$ from the $\Sigma\Delta$ re-modulated signal $S_B$ to the delayed original 1-bit signal $S_A$, after the gain is again restored to 1 through the amplitude processing by the amplitude controller 35, the local feedback loop 71 turns the local feedback loop control signal off to turn the local feedback loop of the $\Sigma\Delta$ modulator having a local feedback loop 67 off to stop local feedback.

In response thereto, the switching controller 72 causes the changeover switch 4 to switch from the output $S_B$ of the $\Sigma\Delta$ modulator having a local feedback loop 67 to the original 1-bit signal $S_A$, after passing through the subtraction by the subtraction value processing controller 68 and pattern coincidence detection processing, for realizing the switching free of noise.

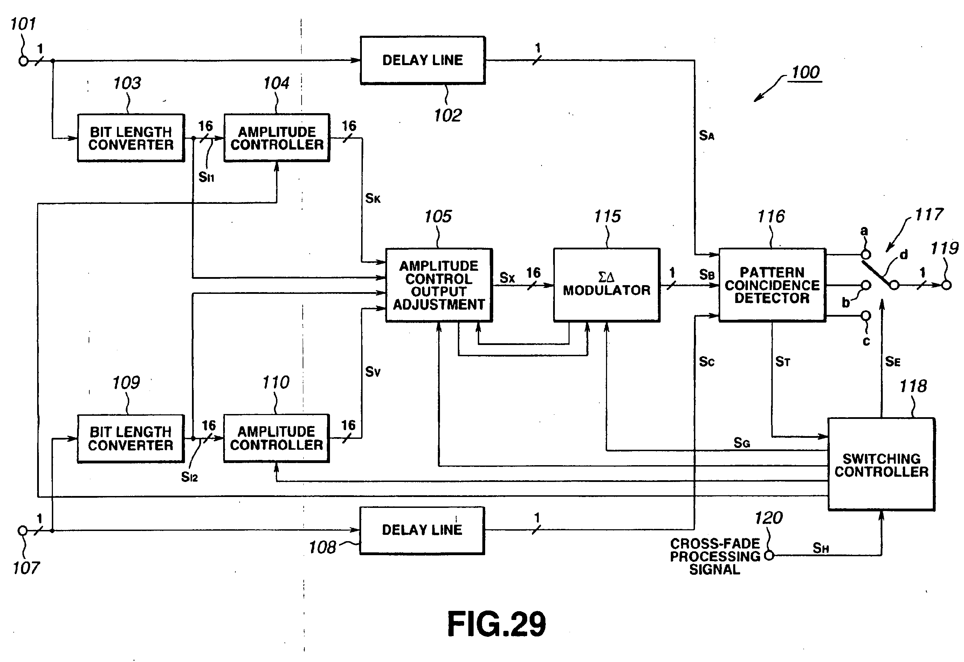

Referring to Figs.29 to 32, an eighth embodiment is explained. This eighth embodiment is directed to a digital signal processing device 100 switching between two-channel $\Sigma\Delta$ modulated signal, as an input signal obtained by two-channel $\Sigma\Delta$ modulation, and the $\Sigma\Delta$ re-modulated signal obtained from this input signal by a changeover switch as switching means, and executes cross-fading..

This digital signal processing device 100 includes a $\Sigma\Delta$ modulator 115 for setting the gain ratio between the first stage feedback loop and the second stage feedback loop to 16 and for outputting the $\Sigma\Delta$ re-modulated 1-bit signal $S_B$, and a delay line 102 for delaying a $\Sigma\Delta$ modulated signal entered via an input terminal 101 by a first one of the above two channels a pre-set number of samples. This digital signal processing device 100 also includes a bit length converter 103 for matching the amplitude level of the $\Sigma\Delta$ modulated signal to the amplitude level of the feedback signal to the first-stage integrator used in a $\Sigma\Delta$ modulator 115 and an amplitude controller 104 for controlling the amplitude level of the a first level-adjusted signal having its amplitude level adjusted by-the bit length converter 103. The digital signal processing device 100 also includes a delay line 108 for delaying the other $\Sigma\Delta$ modulated signal entered via an input terminal 101 by the second one of the above two channels a pre-set number of samples and a bit length converter 109 for matching the amplitude level of the other $\Sigma\Delta$ modulated signal to the amplitude level of the feedback signal to the first-stage integrator used in the $\Sigma\Delta$ modulator 115. The digital signal processing device 100 also includes an amplitude controller 110 for controlling the amplitude level of the second level-adjusted signal having its amplitude level adjusted by the bit length converter 109. The digital signal processing device 100 also includes an amplitude control output adjustment unit 105 comprised of a subtraction value processing controller for generating a signal for $\Sigma\Delta$ re-modulation from two input/output signals of the amplitude controller 104 and the amplitude controller 110 and/or the signal in the $\Sigma\Delta$ modulator 115

and for generation and subtraction of subtraction data obtained on the basis of the control processing during the amplitude control period. The digital signal processing device 100 further includes a switching controller 118 for controlling the amplitude controllers 104, 110, $\Sigma\Delta$ modulator 115, amplitude control output adjustment unit 105 and the changeover switch 117.

It s noted that the $\Sigma\Delta$ modulator 115 is a five-order $\Sigma\Delta$ modulator comprised of five integrators configured as shown in Fig.6, and is of the same configuration as the $\Sigma\Delta$-modulator 6 shown in Fig.7. Thus the gain ratio of the second-stage feedback loop to the state feedback loop excluding the integrator ahead and at back of the 1-bit quantizer in the $\Sigma\Delta$ modulator 115 is an integer value of 16. The number of delay samples in the delay lines 102 and 108 is set to 16 for correspondence to this gain ratio of 16.

The $\Sigma\Delta$ modulator 115 may be a five-order $\Sigma\Delta$ modulator comprised of five integrators configured as shown in Fig.9, and may be configured as shown in Fig.19. In such case, the pre-set number of samples is 15 (=16 - 1) in correspondence to the gain ratio of 16.

During the time the delayed signals from the delay lines 102 and 108 are selected by switching, the initial value of the integrator enclosed within the $\Sigma\Delta$ modulator 115 is set to 0.

The digital signal processing device 100 also includes a pattern coincidence detection unit1 16 for detecting coincidence between the one and the other $\Sigma\Delta$ modulated signals and the $\Sigma\Delta$ re- modulated signals over plural samples and, based on the control signal obtained by the pattern coincidence detection unit 116 for switching between the one or the other $\Sigma\Delta$ modulated signals $S_A$ and $S_C$ and the $\Sigma\Delta$ re- modulated signals $S_B$.

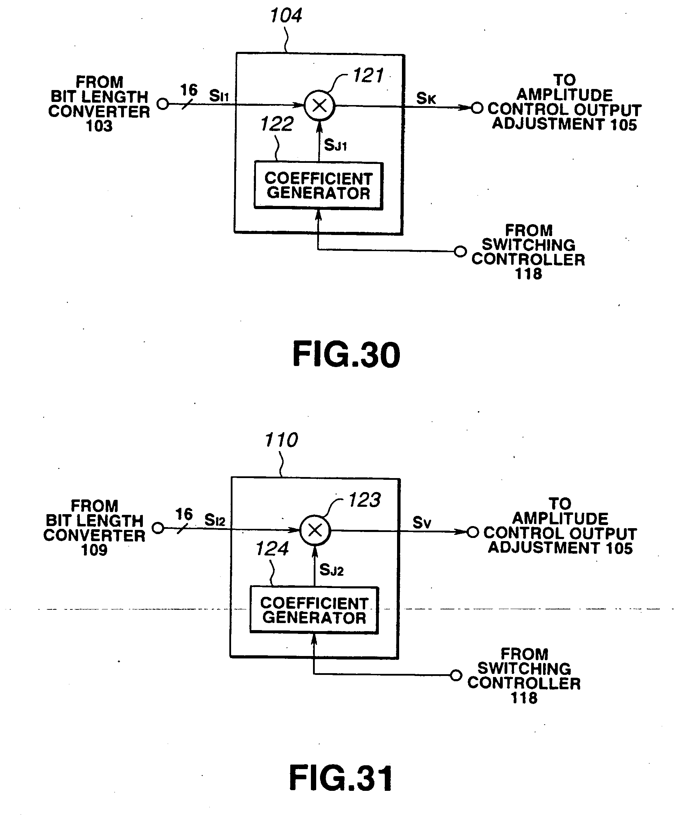

The amplitude controller 104 is made up of a multiplier 121 and a coefficient generator 122, as shown in Fig. 30, and multiplies a first level-adjusted signal $S_{I1}$ from the bit length converter 103 by a coefficient output $S_{J1}$ from a coefficient generator 122 by the multiplier 121. The amplitude controller 104 then sends an amplitude controller output $S_K$ to the amplitude control output adjustment unit 105. The amplitude controller 110 is made up of a multiplier 123 and a coefficient generator 124, as shown in Fig.31, and multiplies a second level-adjusted signal $S_{I2}$ from the bit lenght converter 109 by a coefficient output $S_{J2}$ from a coefficient generator 124 in the multiplier 123. The amplitude controller 110 then sends an amplitude controller output $S_V$ to the amplitude control output adjustment unit 105.

The subtraction value processing controller in the amplitude control output adjustment unit 105 may be configured in many ways, as will be specifically described in the embodiments as later explained.

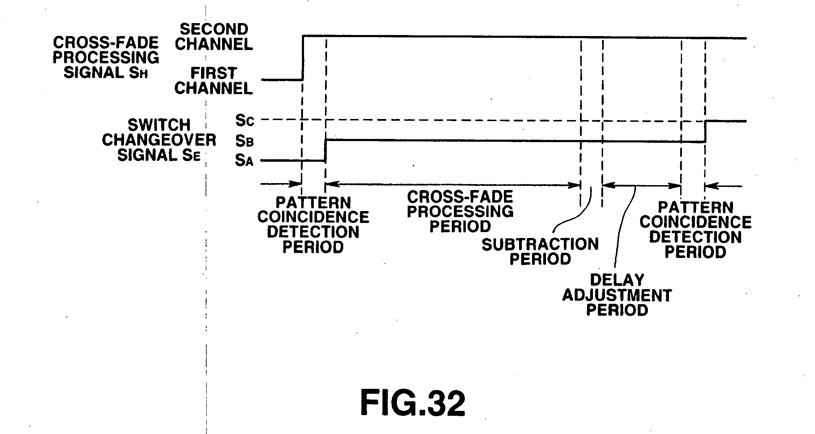

The cross-fading processing operation, performed by the present digital signal processing device 100, is explained by referring to Fig.32. Fig.32 shows, in a timing chart, the switching operation which the switching controller 118 causes the changeover switch 117 to perform when the cross-fading processing signal $S_H$ is supplied to the control signal input terminal 120 of Fig.29.

On reception of the cross-fading processing signal $S_H$ via the control signal input terminal 120, the switching controller 118 first awaits the pattern coincidence processing by the pattern coincidence detector 116, and subsequently sends the switch changeover signal $S_E$ to the changeover switch 117 in order to switch from the delayed original 1-bit signal $S_A$ of the first channel to the $\Sigma\Delta$ re- modulated signals $S_B$.

At this time, a sum signal $S_X$ by the amplitude control output adjustment unit 105 of the amplitude controller output obtained with the coefficient of the coefficient generator 122 in the amplitude controller 104 set to 1 with the amplitude controller output $S_V$ obtained with the coefficient of the coefficient generator 124 in the amplitude controller 110 set to 0, is supplied to the $\Sigma\Delta$ modulator 115.

The switching controller 118 then causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 to 1.

The amplitude control output adjustment unit 105 is fed with a gradually decreasing amplitude controller output $S_K$ and a gradually increasing amplitude controller output $S_V$. The amplitude control output adjustment unit 105 sends a cross-faded addition signal $S_X$ to the $\Sigma\Delta$ modulator 115. On termination of the cross-fading, the subtraction data, obtained on the basis of the control processing during the cross-fading period by the subtraction value processing controller in the amplitude control output adjustment unit 105 is gradually subtracted from the addition signal or from within $\Sigma\Delta$ modulator 115. On termination of the subtraction operation, the amplitude control output adjustment unit 105 first awaits the pattern coincidence processing in the pattern coincidence detector 116 and sends the switch changeover signal $S_E$ to the changeover switch 117 to switch from the $\Sigma\Delta$ re-modulator output $S_B$ to the delayed original 1-bit signal $S_C$ of the second channel.

Thus, if the 1-bit output signal outputted at an output terminal 119 of the digital signal processing device 100 is restored via a low-pass filter to an analog audio signal, the listener can hear the sound cross-faded from the original audio signal of the first channel to the original audio signal of the second channel with noise suppression.

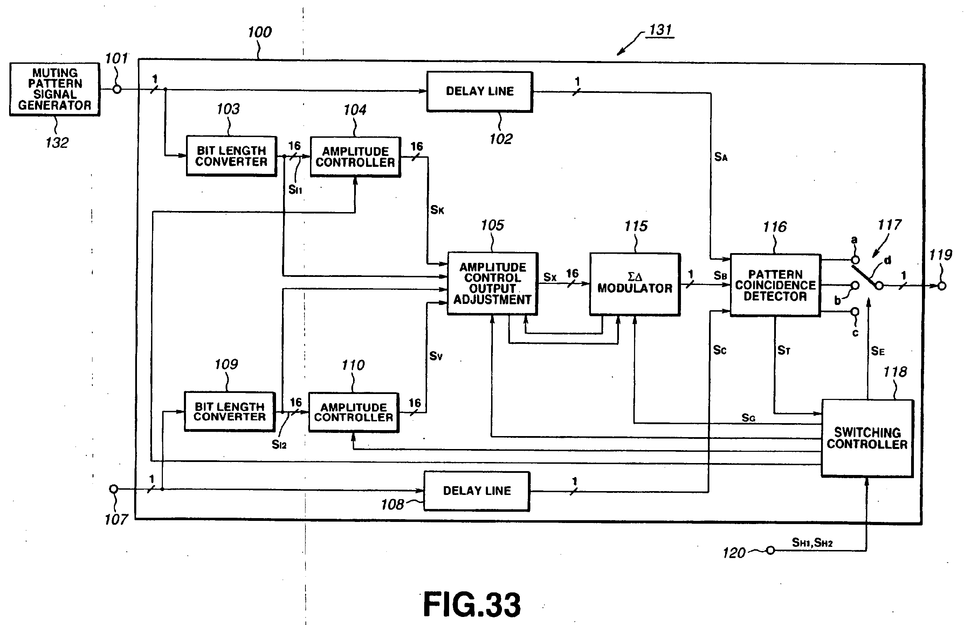

Referring to Fig.33, a ninth embodiment will be explained. This ninth embodiment is directed to a digital signal processing device 131 for realizing fade-in from a muted pattern signal and fade-out to the muted pattern signal by cross-fading a 1-bit muted pattern signal and a 1-bit signal obtained by $\Sigma\Delta$ modulation.

This digital signal processing device 131 has a mute pattern signal generator 132 for generating a mute pattern signal connected to the input terminal 101 of the digital signal processing device 100 of the above-described eighth embodiment. Therefore, parts or components excluding mute pattern signal generator 132 are depicted by the same numerals as those of the eighth embodiment and are not specifically explained.

The operation of the digital signal processing device 131 is explained for the case of performing fade-in processing from a muting processing and for the case of performing muting processing from the fade-out processing.

First, in the case of fade-in processing, the digital signal processing device 131 receiving a fade-in processing signal $S_{H1}$ via control signal input terminal 120 performs cross-fading from the mute pattern signal obtained by the mute pattern signal generator 132 supplied to the input terminal 101 to the $\Sigma\Delta$ modulated signal supplied to the input terminal 107. This cross-fading processing is similar to that of the above-described eighth embodiment and hence is not explained specifically.

Thus, if the 1-bit output signal obtained at the output terminal 119 of the digital signal processing device 131 is restored to the analog audio signal via a low-pass filter, an audio signal fade-in processed from the muted state can be obtained with noise suppression.

Then, for fade-out processing, the digital signal processing device 100 receiving a fade-out processing signal $S_{H2}$. via switching control terminal 120 performs cross-fading processing from the $\Sigma\Delta$ modulated signal supplied to the input terminal 107 to the mute pattern signal obtained by the mute pattern signal generator 132 supplied to the input terminal 101.

This cross-fading processing is similar to that of the above-described eighth embodiment and hence is not explained above-described eighth embodiment and hence is not explained specifically.

Thus, if the 1-bit output signal obtained at the output terminal 119 of the digital signal processing device 131 is restored to the analog audio signal via a low-pass filter, an audio signal which becomes muted after the fade-out processing is obtained under noise suppression.

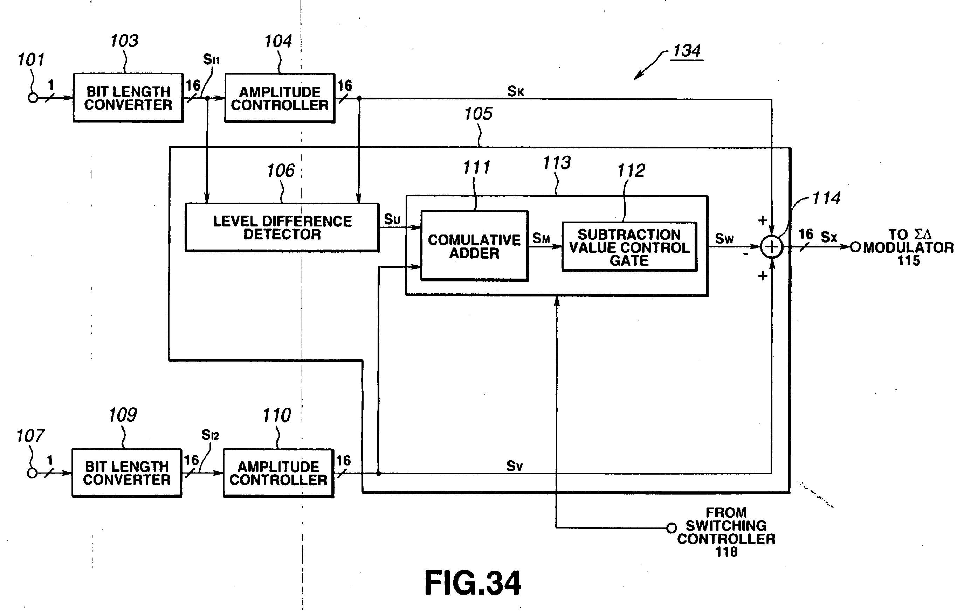

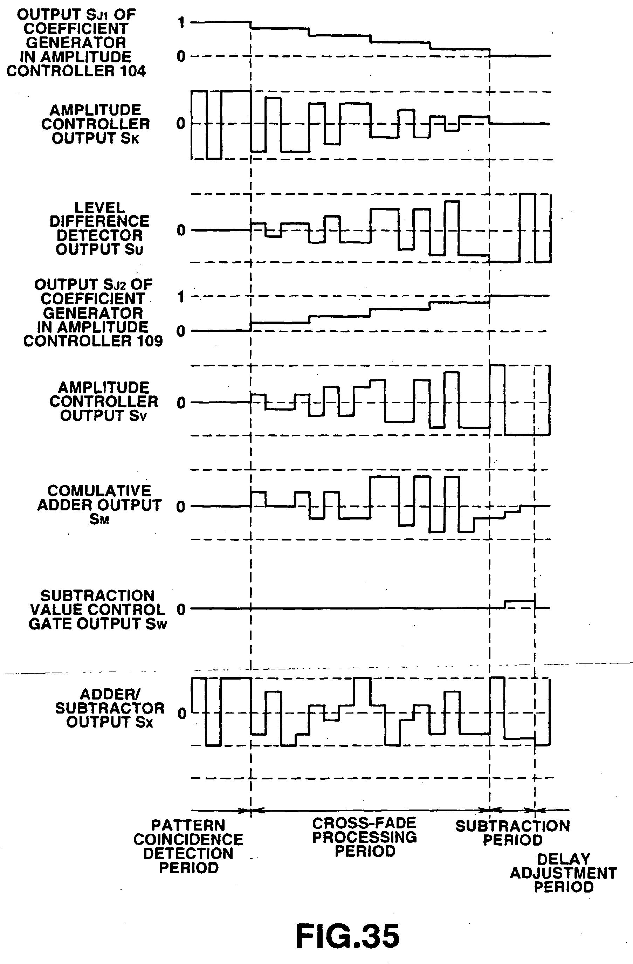

Referring to Figs.34 and 35, a tenth embodiment is now explained. This tenth embodiment is also a digital signal processing device for switching between two-channel $\Sigma\Delta$ modulated signals as input signals obtained by the two-channel $\Sigma\Delta$ modulation processing, and the $\Sigma\Delta$ re-modulated signal derived from this input signal, and performs cross-fading. This tenth embodiment differs from the eighth embodiment shown in Fig.29 in arranging the amplitude control output adjustment unit 105 of the digital signal processing device 100 of the eighth embodiment as shown in Fig.34 and is otherwise the same as the eighth embodiment.

The amplitude control output adjustment unit 105 includes a level difference detector 106 for detecting the difference between the first level adjustment signal from the bit length converter 103 and the level of the amplitude control output by the amplitude controller 104, and a cumulative adder 111 for cumulatively adding the level difference $S_u$ from the level difference detector 106 and the amplitude control output $S_v$ for the amplitude level control period for the first and second level-adjusted signals over the amplitude level width length of the first and second level-adjusted signals. The amplitude control output $S_v$ is an amplitude-controlled second level-adjusted signal from the bit length converter 109 outputted by the amplitude controller 110. The amplitude control output adjustment unit 105 also includes a subtraction value processing control gate 112 for gradually subtracting the cumulative sum $S_M$ of the cumulative adder 111 from the first and second level-adjusted signals using the adder/subtractor 114. The cumulative adder 111 and the subtraction value processing control gate 112 make up a subtraction value processing controller 113. The amplitude control output adjustment unit 105 is otherwise similar to the arrangement shown in Fig.29. The timing chart for switching control performed by the switching controller 118 for the changeover switch 117 is similar to that of Fig.32.

Fig.35 shows, by an overall timing chart, the cross-fading processing operation by the present digital signal processing device 134.

First, on reception of the cross-fading signal $S_H$ via control signal input terminal 120, a switching controller 118 awaits the pattern coincidence processing by the pattern coincidence detector 116, and subsequently sends a switch changeover signal $S_E$ to the changeover switch 117 to switch from the delayed original 1-bit signal $S_A$ of the first channel to the $\Sigma A$ modulator output $S_B$.

At this time, an addition signal $S_X$ by the adder/subtractor 114 in the amplitude control output adjustment unit 105 of the amplitude controller output $S_K$, obtained with the coefficient of the coefficient generator 122 in the amplitude controller 104 set to 1, and the amplitude controller output $S_V$ obtained with the coefficient of the coefficient generator 124 in the amplitude controller 110 set to 0, are fed to the $\Sigma\Delta$ modulator 115.

The switching controller 118 causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 to 1.

During this time, the level difference detector 106 detects the difference $S_U$ between the amplitude level of the level adjustment signal $S_{I1}$ (maximum amplitude level) and the input signal level to the adder/subtractor 114. The switching controller 118 controls the cumulative adder 111 for cumulatively adding the level difference $S_U$ and the output $S_V$ of the amplitude controller 110.

When the coefficient generator outputs $S_{J1}$ and $S_{J2}$ have reached 0 and 1, respectively, the switching controller 118 causes the adder/subtractor 114 to gradually subtract the data SM, accumulated in the cumulative adder 111, from the amplitude controller outputs $S_K$ and $S_V$ via the subtractor control gate 112.

When the cumulative sum value $S_M$ in the cumulative adder 111 reaches 0, the switching controller 118 controls the switching from the $\Sigma\Delta$ modulator output $S_B$ to the delayed original 1-bit signal $S_C$ of the second channel through the pattern coincidence processing following delay of a pre-set number of samples.

For preventing oscillation of the digital signal processing device 134, a first integrator 51 having a limiter shown in Fig.21 is substituted for the first integrator of the $\Sigma\Delta$ modulator115, and the limiter value is set to an integer number times the maximum amplitude level width.

If the limiter function is in operation while the integrated value of the first integrator is larger than the above limiter value, control is managed so that the cumulative sum value in the cumulative adder 111 is cleared to zero by the switching controller 118.

Thus, if the 1-bit output signal outputted at an output terminal of the digital signal processing device 134 is restored via a low-pass filter to an analog audio signal, the listener can hear the cross-faded sound from the original audio signal of the first channel to the original audio signal of the second channel with noise suppression.

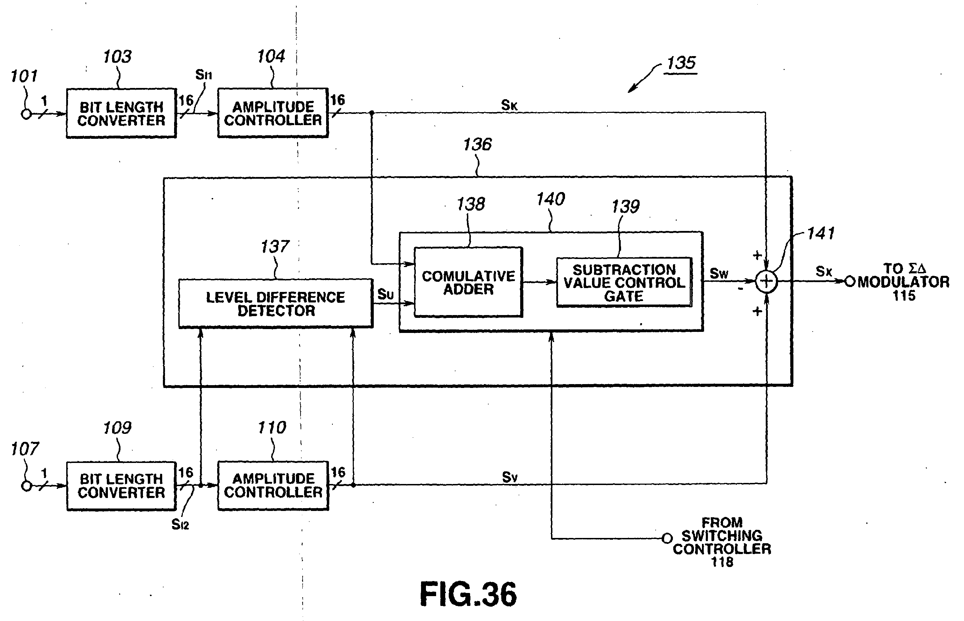

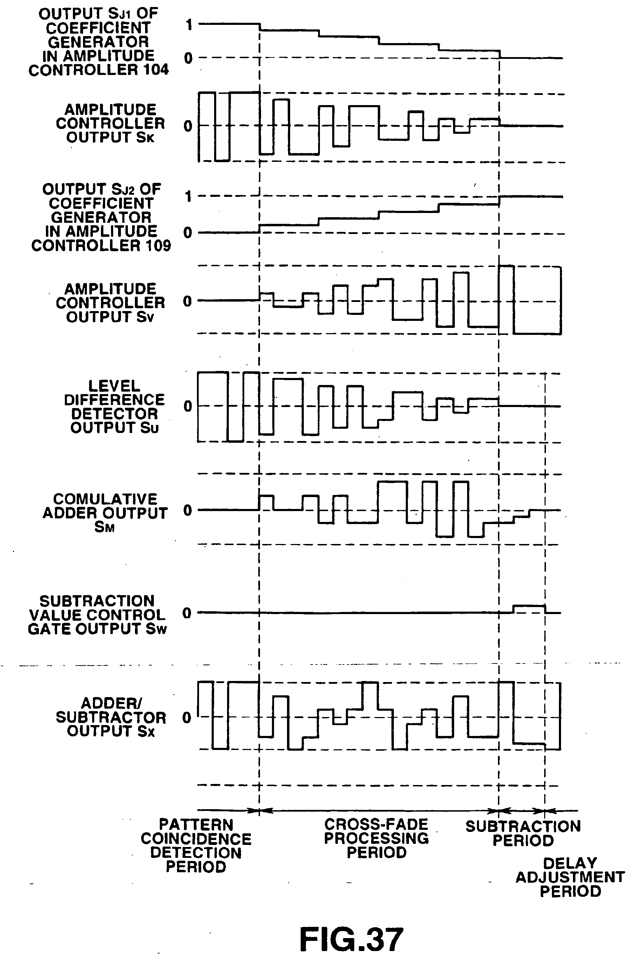

Referring to Figs.36 and 37, an eleventh embodiment is now explained. This eleventh embodiment is directed to a digital signal processing device 135 configured for switching between two-channel $\Sigma\Delta$ modulated signal as an input signal obtained by the two-channel $\Sigma\Delta$ modulation processing, and $\Sigma\Delta$ re-modulated signal derived from this input signal, and performs cross-fading. This tenth embodiment differs from the eighth embodiment shown in Fig.29 in substituting the an amplitude control output adjustement until 136 for the amplitude control output adjustement. unit 105 of the digital signal processing device 100 of the eighth embodiment shown in Fig.29, and is otherwise the same as the eighth embodiment.

The amplitude control output adjustment unit 136 includes a level difference detector 137 for detecting the difference between the above second level adjustment signal and the level following amplitude control by the amplitude controller 110, and a cumulative adder 138 for cumulatively adding the level difference from the level difference detector 137 and the level following control of the amplitude level of the first level adjustment signal by the amplitude controller 104 with the amplitude level width length during the period of amplitude level control of the first and second level-adjusted signals. The amplitude control output adjustment unit 136 also includes a subtraction value control gate 139 for gradually subtracting the cumulative sum of the cumulative adder 138 from the first and second level adjustment signals using the adder/subtractor 141. The cumulative adder 138 and the subtraction value control gate 139 make up a subtraction value processing controller 140. Since the various components of the amplitude control output adjustment unit 136 are similar to those of the amplitude control output adjustment unit 100, the corresponding description in not made.

The cross-fading processing operation performed by the digital signal processing device 135 is explained by referring to the timing chart of Fig. 37. The timing chart for switching control performed by the switching controller 18 is similar to that shown in Fig.32.

First, the switching controller 118 receiving the cross-fading processing signal via switching control terminal 120 awaits the pattern coincidence processing at the pattern coincidence detector 116 and sends a switch changeover signal $S_E$ to the changeover switch 117 in order to switch from the delayed 1-bit signal $S_A$ of the first channel to the $\Sigma\Delta$ modulator output $S_B$.

To the $\Sigma\Delta$ modulator 115 is sent the addition signal $S_X$ by the adder/subtractor 114 of the amplitude controller output $S_K$ obtained with the coefficient of the coefficient generator 122 in the amplitude controller 104 set to 1 and the amplitude controller output $S_V$ obtained with the coefficient of the coefficient generator 124 in the amplitude controller 110 set to 0.

The switching controller 118 then causes transition of the coefficient generator output $S_{J1}$ of the coefficient generator 122 in the amplitude controller 104 from 1 to 0, while causing transition of the coefficient generator output $S_{J2}$ of the transition of the coefficient generator output $S_{J2}$ of the coefficient generator 124 in the amplitude controller 110 from 0 to 1.

During this time, the level difference detector 137 detects the difference $S_U$ of the input signal level to the adder/substractor 141 with respect to the amplitude level of the level-adjusted signal $S_{12}$ (maximum amplitude level). During this time, the switching controller 118 controls the cumulative adder 138 for cumulatively adding the level difference $S_U$ to the output $S_K$ of the amplitude controller 104.

When the coefficient generator output $S_{J1}$ and the coefficient generator output $S_{J2}$ reach 0 and 1, respectively, the switching controller 118 gradually subtracts the data $S_M$ accumulated in the cumulative adder 138 by the adder/subtractor 141 from the amplitude controller output $S_K$ and the amplitude controller output $S_V$ through the subtraction control gate 139.

When the cumulative addition value $S_M$ of the cumulative adder 138 reaches 0, the switching controller 118 controls the switching from the $\Sigma\Delta$ modulator output $S_B$ to delayed original 1-bit delay signal $S_C$ through pattern coincidence processing following delay over a pres-set number of samples.

For preventing oscillation of the digital signal processing device 135, a first integrator 51 having a limiter 51 shown in Fig.21 is substituted for the first integrator of the ΣΔ modulator115, and the limiter value is set to an integer number times the maximum amplitude level width.

If the limiter function is in operation while the integrated value of the first integrator is larger than the above limiter value, control is managed so that the cumulative sum value in the cumulative adder 111 is cleared to zero by the switching controller 118.

Thus, if the 1-bit output signal outputted at an output terminal of the digital signal of the first channel to the digital signal processing device 134 is restored via a low-pass filter to an analog audio signal, the listener can hear the noise-suppressed cross-faded sound cross-faded from the original audio signal of the second channel..

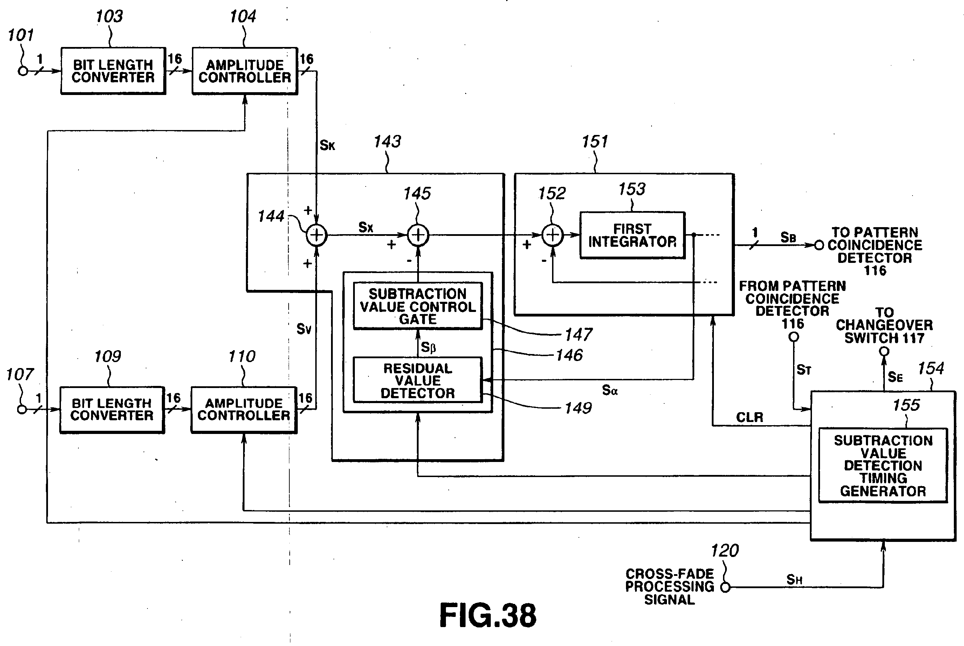

Referring to Fig.38, a twelfth embodiment is now explained. This twelfth embodiment is directed to a digital signal processing device configured for switching between two-channel ΣΔ modulated signal as an input signal obtained by the two-channel ΣΔ modulation processing, and a ΣΔ re-modulated signal derived from this input signal, by the changeover switch 117 as switching means, and performs cross-fading. This twelfth embodiment differs from the eighth embodiment shown in Fig.29 in substituting the amplitude control output adjustment unit 143 for the amplitude control output adjustment unit 105 of the digital signal processing device 100 of the eighth embodiment shown in Fig.29 and in substituting a switching controller 154 for the switching controller 118. The present twelfth embodiment is otherwise the same as the eighth embodiment.

The amplitude control output adjustment unit 143 includes a remainder detector 149 for detecting the remainder of the integrated value $S\alpha$ of a first integrator 153 in the ΣΔ modulator 151 with respect to the maximum amplitude level width (equal to twice the above maximum amplitude level) and a subtraction value detector 147 for gradually subtracting the remainder detected by the remainder detector 149 from the maximum amplitude level signal outputted by the adder 144 using an adder./subtractor 145. The remainder detector 149 and the subtraction value detector 147 make up a subtraction value processing controller 146.

The ΣΔ modulator 151 is configured similarly to the ΣΔ modulator 6 shown in Fig.7 and is comprised of a first coefficient multiplier connected downstream of a first adder 152 and the first integrator 153. The integrated value outputted by the first integrator 153 is supplied to the remainder detector 149 in the subtraction value processing controller 146.

The switching controller 154 controls the amplitude controllers 104, 110, ΣΔ modulator 151, amplitude control output adjustment unit 143 and the changeover switch 117, and is particularly characterized in that a subtraction value detection timing generator 155, generating a subtraction value detection timing signal, is provided in the subtraction value processing controller 146 in the amplitude output adjustment unit 143.

The operation of the digital signal processing device of the present twelfth embodiment is explained. First, the switching controller 154 receiving the cross-fading processing signal via switching control terminal 120 awaits the pattern coincidence processing at the pattern coincidence detector 116 and sends a switch changeover signal $S_E$ to the changeover switch 117 in order to switch from the delayed 1-bit signal $S_A$ of the first channel to the ΣΔ modulator output $S_B$.

To the ΣΔ modulator 151 is sent the addition signal $S_X$ by the adder 144 of the amplitude controller output $S_K$ obtained with the coefficient of the coefficient generator 122 in the amplitude controller 104 of Fig.26 set to 1 and the amplitude controller output $S_V$ obtained with the coefficient of the coefficient generator 124 in the amplitude controller 110 set to 0.

The switching controller 154 then causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 to 1.

At a point after outputs of the amplitude controller 104 and the amplitude controller 110 become 0 and 1 (maximum amplitude level) , respectively, by the cross-fading processing, the subtraction value detection timing generator 155 in the switching controller 154 generates a subtraction value detection timing signal. The subtraction value control gate 147 is responsive to the subtraction value detection timing signal to seize a remainder $S\beta$ from the remainder value detector 149.

The subtraction value control gate 147 is responsive to the subtraction value detection timing signal to seize the remainder $S\beta$ and causes he subtractor 145 to gradually subtract The remainder value from the addition signal $S_X$.

The switching controller 154 controls the switching from the ΣΔ modulator output $S_B$ to the delayed original 1-bit signal $S_C$ of the second channel through the pattern coincidence processing following delay of a pre-set number of samples.

Thus, if the 1-bit output signal outputted at an output terminal of the digital signal of the digital signal processing device 134 of the twelfth embodiment is restored via a low-pass filter to an analog audio signal, cross-fading is realized from the original audio signal to the original audio signal of the second channel with noise suppression.

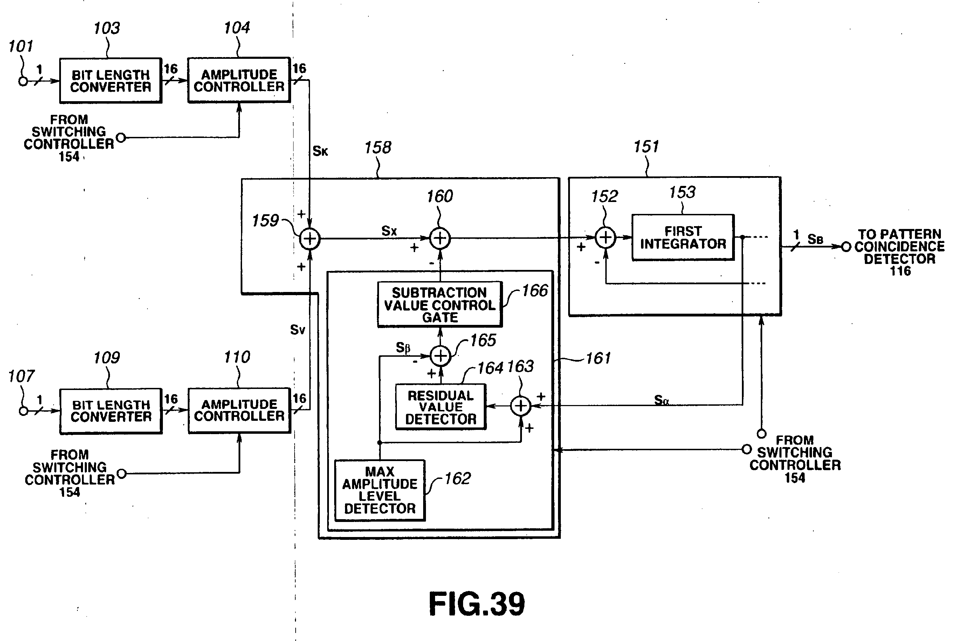

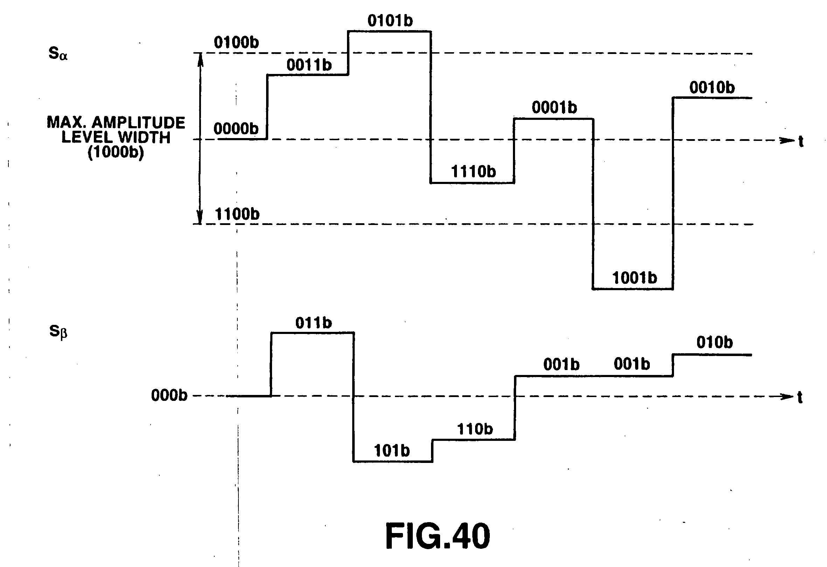

Referring to Figs.39 and 40, a thirteenth embodiment is now explained. This thirteenth embodiment is directed to a digital signal processing device configured for switching between two-channel ΣΔ modulated signal as an input signal obtained by the two-channel ΣΔ modulation processing, and ΣΔ re-modulated signal derived from this input signal, by a changeover switch as switching means, and performs cross-fading. This thirteenth embodiment differs from the eighth embodiment shown in Fig.29 in substituting the an amplitude control output adjustment unit 158 for the amplitude control output adjustment unit 105 of the digital signal processing device 100 of the eighth embodiment shown in Fig. 29 and is otherwise the same as the eighth embodiment.

The amplitude control output adjustment unit 158 includes an adder 163 for adding the positive maximum amplitude level from the maximum amplitude level generator 162 to the integrated value $S\alpha$ of the first integrator 153 in the $\Sigma\Delta$ modulator 151, and a remainder value detector 164 for detecting the remainder value relative the maximum amplitude level (equal to the above maximum amplitude level) of the addition output of the adder 163. The amplitude control output adjustment unit 158 also includes a subtractor 165 for subtracting the positive maximum amplitude level from the remainder value detected by the remainder value detector 164, and a subtraction value control gate 166 for gradually subtracting the subtraction output of the subtractor 165 from the maximum amplitude level signal outputted by the adder 159 using the adder/subtractor 160. The subtraction output is termed thereinafter as the result of subtraction of the addition remainder value. The adder 163, remainder value detector 164, subtraction value control gate 166 and a maximum amplitude level generator 162 make up a subtraction value processing controller 161.

The operation of the digital signal processing device of the present thirteenth embodiment is explained by referring to Fig.40 showing signal examples of the integration value $S\alpha$ and the result of subtraction of the addition remainder value $S\beta$ in the case of binary processing.

First, the switching controller 154 receiving the cross-fading processing signal via switching • control terminal 120 awaits the pattern coincidence processing at the pattern coincidence detector 116 and sends a switch changeover signal $S_E$ to the changeover switch 117 in order to switch from the delayed 1-bit signal $S_A$ of the first channel to the $\Sigma\Delta$ modulator output $S_B$.

To the $\Sigma\Delta$ modulator 151 is sent, via a subtractor 160, an addition signal $S_X$ by the adder 159 of the amplitude controller output $S_K$ obtained with the coefficient of the coefficient generator 122 in the amplitude controller 104 of Fig. 30 set to 1 and the amplitude controller output $S_V$ obtained with the coefficient of the coefficient generator 124 in the amplitude controller 110 set to 0.

The switching controller 118 then causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 to 1.

At a point after outputs of the amplitude controller 104 and the amplitude controller 110 become 0 and 1 (maximum amplitude level), respectively, by the cross-fading processing, the subtraction value detection timing generator 155 in the switching controller 154 generates a subtraction value detection timing signal. The subtraction value control gate 166 is responsive to the subtraction value detection timing signal to seize the remainder $S\beta$ from the remainder value detector 165.

The result of subtraction of the addition remainder value $S\beta$ is now explained. The first integrator 153 of the $\Sigma\Delta$ modulator 151 outputs an integrated value $S\alpha$ shown in Fig.40. It is assumed that the maximum amplitude level width is 1000 (binary) as a power of 2. Then, by detecting the lower 3 bits and recognizing them as a 2's complement, the detection value directly becomes the result of subtraction of the addition remainder value $S\beta$ obtained on subtracting the positive maximum amplitude level from the remainder value corresponding to addition of the positive maximum amplitude level.

By adding the positive maximum amplitude level by the adder 163 to the integrated value $S\alpha$ as an output of the first integrator 153, detecting the remainder of the addition output from the maximum amplitude level width by the remainder value detector 164 and by subtracting the maximum amplitude level from the remainder by a subtractor 165, the result of subtraction of the addition remainder value $S\beta$ is obtained. This result of subtraction of the addition remainder value $S\beta$ is the lower 3 bits of the integrated value $S\alpha$.

The subtraction value control gate 166 seizes the result of subtraction of the addition remainder value $S\beta$ responsive to the subtraction value detection timing signal and gradually subtracts the result $S\beta$ from the addition signal $S_X$.

The switching controller 154 controls switching from the $\Sigma\Delta$ modulator output $S_B$ to the delayed original 1-bit signal $S_C$ of the second channel through the pattern coincidence processing following delay over a pre-set number of samples.

Thus, if the 1-bit output signal outputted at an output terminal of the digital signal processing device of the thirteenth embodiment is restored via a low-pass filter to an analog audio signal, cross-fading from the original audio signal of the first channel to the original audio signal of the second channel with noise suppression is realized.

By using the result of subtraction of the addition remainder value $S\beta$, obtained on subtracting the maximum amplitude level from the remainder, as a value seized by the subtraction value control gate 166, the time of convergence to zero may be halved for realizing smoother switching.

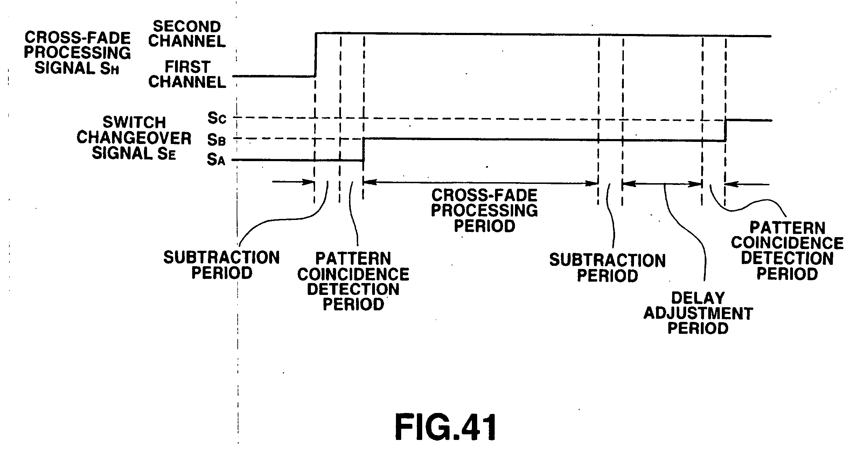

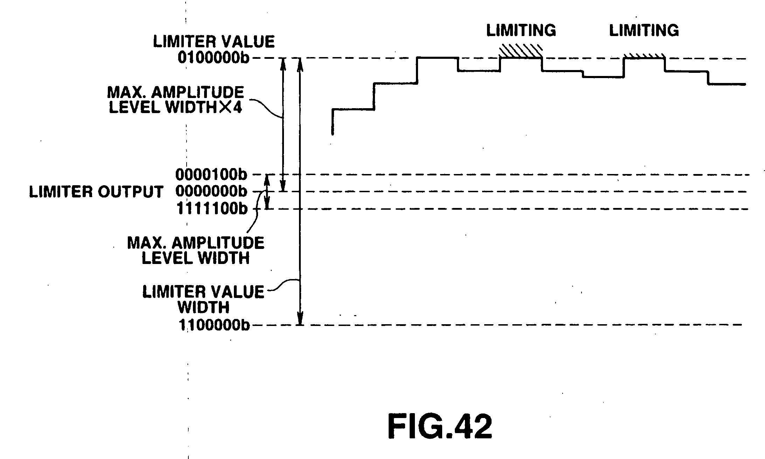

Referring to Figs.41 and 42, a fourteenth embodiment is explained, in which the first integrator 51 having the limiter shown in Fig. 21 is substituted for the first integrator 153 of the-'EA--modulator-151-iri--the digital signal processing device of the above-described twelfth embodiment, is explained. This fourteenth embodiment is directed to a digital signal processing device for causing a changeover switch 117, as switching means, to switch between the two-channel $\Sigma\Delta$ modulated signal, as an input signal obtained by the two-channel $\Sigma\Delta$ modulation, and $\Sigma\Delta$ re-modulated signal derived from the input signal, and performs cross-fading. However, there is provided a first integrator having a limiter 151, for preventing dispersion in the ΣΔ modulator 151.

The integrated value Sα, limited by the integrator 51 having the limiter, is supplied to a remainder value detector 149 in the subtraction value controller 146 shown in Fig.38.

Referring to Fig.41, the operation of the digital signal processing device according to the fourteenth embodiment is now explained. On reception of the cross-fading signal $S_H$ via control signal input terminal 120, a switching controller 154 shown in Fig.41 awaits the pattern coincidence processing by the pattern coincidence detector 116, and subsequently sends a switch changeover signal $S_E$ to the changeover switch 117. The changeover switch switches from the delayed original 1-bit signal $S_A$ of the first channel to the ΣΔ modulator output $S_B$. Before this pattern coincidence processing, the digital signal processing device causes the subtraction value control gate 147 to gradually subtract, from the maximum amplitude level signal, the remainder value Sβ from the maximum amplitude level width of the limiter integrated value Sα during the period of selection of the delayed original 1-bit signal, using the subtractor 145.

Subsequently, an addition signal $S_X$ by the adder/subtractor 144 in the amplitude control output adjustment unit 144 of the amplitude controller output $S_K$ obtained with the coefficient of the coefficient generator 122 in the amplitude controller 104 of Fig.30 set to 1 and the amplitude controller output $S_V$ obtained with the coefficient of the coefficient generator 124 in the amplitude controller 110 set to 0, is fed via subtractor 145 to the ΣΔ modulator 151.

The switching controller 154 causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 tol.

At a point after outputs of the amplitude controller 104 and the amplitude controller 110 become 0 and 1 (maximum amplitude level), respectively, by the cross-fading processing, the subtraction value detection timing generator 155 in the switching controller 154 generates a subtraction value detection timing signal. The subtraction value control gate 147 is responsive to the subtraction value detection timing signal to seize a remainder Sβ from the remainder value detector 149.

The subtraction value control gate 147 is responsive to the subtraction value detection timing signal to seize the remainder Sβ and causes the subtractor 145 to gradually subtract the remainder value from the addition signal $S_X$.

The switching controller 154 controls the switching from the ΣΔ modulator output $S_B$ to the delayed original 1-bit signal $S_C$ of the second channel through the pattern coincidence processing following delay of a pre-set number of samples.

Thus, if the 1-bit output signal outputted at an output terminal of the digital signal of the digital signal processing device 134 of the twelfth embodiment is restored via a low-pass filter to an analog audio signal, there is realized cross-fading from the original audio signal to the original audio signal of the second channel with noise suppression.

A modification of the digital signal processing device according to the fourteenth embodiment s now explained. This modification is directed to a digital signal processing device in which the limit value of the first integrator having the limiter 51 of the ΣΔ modulator 151 is set to a value equal to, for example, four times the maximum amplitude level width. Various components of Figs.21 and 38 apply unchanged and hence the corresponding description is not made.

That is, the digital signal processing device according to the present modification has a first integrator 51 having a limiter for limiting the integrated value of the ΣΔ modulator 151 with a limit value of an integer number multiple, such as four times, of the maximum amplitude level width.

The operation of the digital signal processing device according to the present modification is explained by referring to Fig.42.

If the maximum amplitude level width is 01000 (binary), the limit values of the first integrator having the limiter 51 become 0100000 and 1100000. This sets the remainder from the maximum amplitude level width during operation of the first integrator 51 having the limiter to 0. Thus, with the present modification, subtraction of the remainder value from the maximum amplitude level by the subtraction control gate 147 prior to switching control to the ΣΔ re-modulated 1-bit signal, required with the digital signal processing device according to the fourteenth embodiment, is not required, such that cross-fading from the original audio signal of the first channel to the original audio signal of the second channel under noise suppression is realized even on limiter operation.

A fifteenth embodiment, in which the ΣΔ modulator 151 shown in Fig.21 is substituted for the first integrator 153 of the ΣΔ modulator 151 of the digital signal processing device according to the thirteenth embodiment, is explained. The present fifteenth embodiment is directed to a digital signal processing device having a changeover switch 117 as switching means for switching between the two-channel ΣΔ modulated signal as an input signal obtained by the two-channe ΣΔ modulation and the ΣΔ re-modulated signal derived from the input signal, and executes cross-fading. The present fifteenth embodiment has a first integrator having limiter 51 for preventing dispersion of the ΣΔ modulator 151.

The integrated value Sα, limited by the integrator 51 having the limiter, is supplied to a remainder value detector 163 in the amplitude control output adjustment unit 158 shown in Fig.39.

On reception of the cross-fading signal $S_H$ via control signal input terminal 120, the switching controller 154 awaits the pattern coincidence processing by the pattern coincidence detector 116, and subsequently sends a switch changeover signal $S_E$ to the changeover switch 117. The changeover switch switches from the delayed original 1-bit signal $S_A$ of the first channel to the $\Sigma\Delta$ modulator output $S_B$. Before this pattern coincidence processing, the digital signal processing device gradually subtracts, from the maximum amplitude level signal entering the $\Sigma\Delta$ modulator 151, the remainder value $S\beta$ from the maximum amplitude level width of the limiter integrated value $S\alpha$ during the period of selection of the delayed original 1-bit signal, using the subtractor 160.

This result of subtraction of addition remainder value $S\beta$ is obtained by detecting, by the remainder value detector 164, the remainder value from the maximum amplitude level width of an addition signal obtained on adding the positive maximum amplitude level by the adder 163 to the limiter integrated value $S\alpha$ of first integrator 51 having the limiter, and by subtracting the maximum signal level by the subtractor 165.

Subsequently, an addition signal $S_X$ by the adder 159 of the amplitude controller output $S_K$ obtained with the coefficient generator output $S_{J1}$ of the coefficient generator 122 in the amplitude controller 104 of Fig.30 set to 1 and the amplitude controller output $S_V$ obtained with the coefficient of the coefficient generator 124 in the amplitude controller 110 set to 0, is fed via subtractor 160 to the $\Sigma\Delta$ modulator 151.

The switching controller 154 causes transition of the coefficient generator output $S_{J1}$ of the coefficient generator 122 in the amplitude controller 104 from 1 to 0, while causing transition of the coefficient generator output $S_{J2}$ of the coefficient generator 124 in the amplitude controller 110 from 0 tol.

At a point after outputs of the amplitude controller 104 and the amplitude controller 110 become 0 and 1 (maximum amplitude level), respectively, by the cross-fading processing, the subtraction value detection timing generator 155 in the switching controller 154 generates a subtraction value detection timing signal. The subtraction value control gate 166 is responsive to the subtraction value detection timing signal to seize the remainder $S\beta$.

The subtraction value control gate 166 then gradually subtracts the remainder $S\beta$ from the addition signal $S_X$ by the subtractor 160.

The switching controller 154 controls the switching from the $\Sigma\Delta$ modulator output SB to the delayed original 1-bit signal $S_C$ of the second channel through the pattern coincidence processing following delay of a pre-set number of samples.

Thus, if the 1-bit output signal outputted at an output terminal of the digital signal of the digital signal processing device 134 of the twelfth embodiment is restored via a low-pass filter to an analog audio signal, there is realized cross-fading from the original audio signal to the original audio signal of the second channel with noise suppression.

By using the result of subtraction of the addition remainder value $S\beta$, obtained on subtraction of the positive maximum amplitude level from the remainder value, as the value seized by the subtraction value control gate 151, the time of convergence to zero may be halved for realizing smother switching.

With the digital signal processing device of the present fifteenth embodiment, by setting the limit value of the first integrator having the limiter 151 to an integer number times, such as four times, the maximum amplitude level width, subtraction of the result of subtraction of the addition remainder value $S\beta$ from the maximum amplitude level 1 by the subtraction control gate 166 prior to switching control to the $\Sigma\Delta$ re-modulated 1-bit signal, is not required, such that cross-fading from the original audio signal of the first channel to the original audio signal of the second channel under noise suppression is realized even on limiter operation.

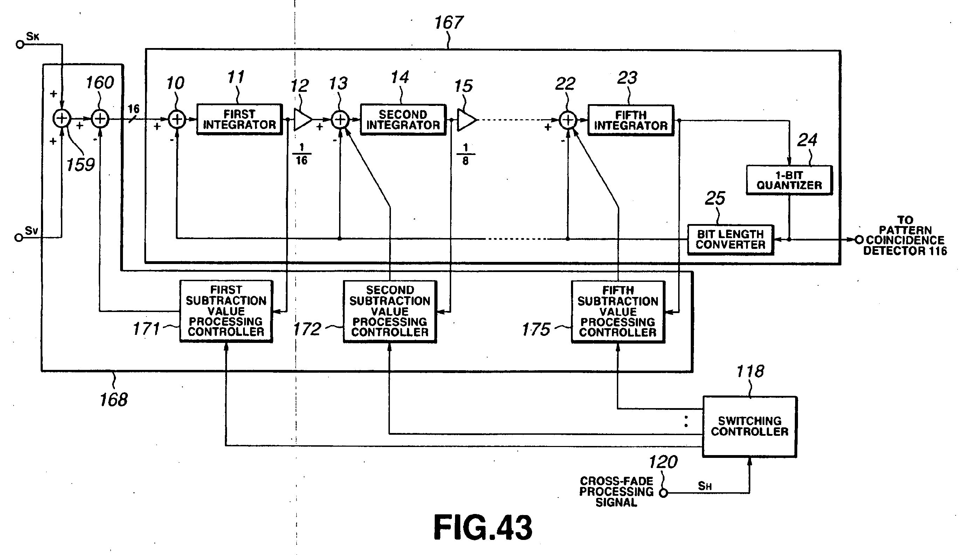

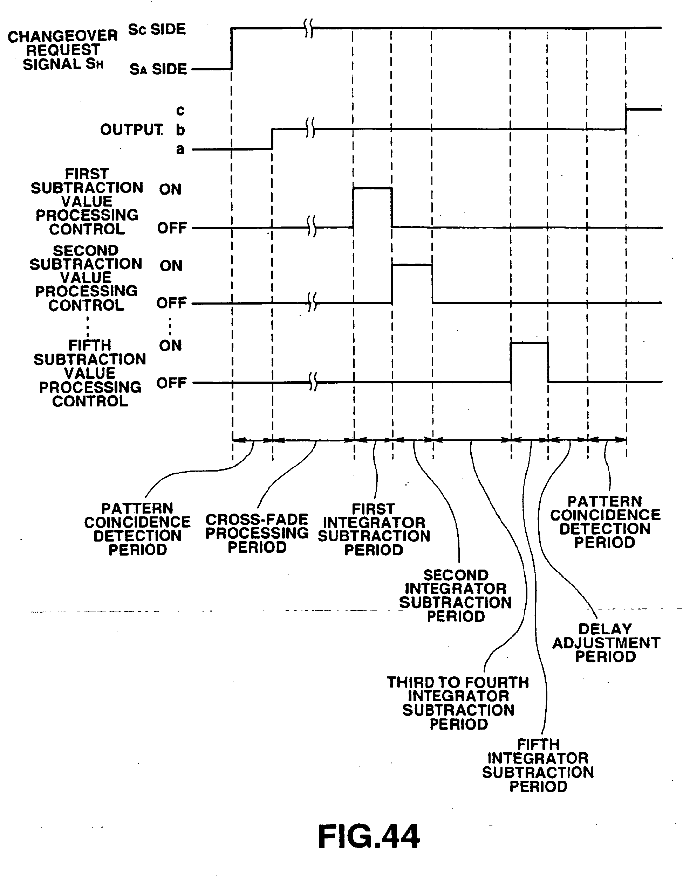

Referring to Figs.43 and 44, a sixteenth embodiment is explained. The present sixteenth embodiment is directed to an arrangement of a switching device for two-channel $\Sigma\Delta$ modulated signal of the eighth embodiment in which, for constructing a subtraction value processing controller within the amplitude control output adjustment unit in Fig.29, a remainder value detector is provided within the amplitude control output adjustment unit.

Thus the present embodiment is directed to such a device corresponding to the twelfth, thirteenth and fourteenth embodiments in which not only the integrated value of the first integrator but also the integrated values of the second and following integrators are used for controlling the subtraction of the integrated value in the integrator in each $\Sigma\Delta$ modulator in each digital signal processing device.

Fig.43 shows an illustrative device for controlling the processing of subtraction values for the second and following integrators. Control outputs returned from the second subtraction value processing controller 172 through to the fifth subtraction value processing controller 175 are returned to the adders 13 through to 22 provided ahead of the integrators of the second and following stages of the integrators. In this case, subtraction value processing control occurs sequentially after subtraction processing in the first-stage first subtraction value processing controller 171 completely comes to a close. This is realized by the switching controller 171 supplying pulsed subtraction value processing control signals to the subtraction value processing controllers 171 through to 175 at the timing shown in Fig.44. For example, in the case of the arrangement shown in Fig. 43, the reference value for detection of the remainder value in the remainder detector in the second subtraction value processing controller 172 is 1/16 of the reference for detection of the first-stage remainder value, while the reference value for detection of the remainder value in the remainder detector in the third subtraction stage is 1/128 (=(1/16) x (1/8)) of the reference for detection of the first-stage remainder.

Moreover, by using the $\Sigma\Delta$ modulator shown in Fig.43, limiting processing becomes possible for the second and the following stages of the integrators by similar subtraction processing by the integrators with the limiters. In addition, by setting the limit values of the entire integrators to a value equal to an integer number times of the maximum amplitude level value, limiting processing free of subtraction is also realized. This may be applied to the tenth and eleventh embodiments.

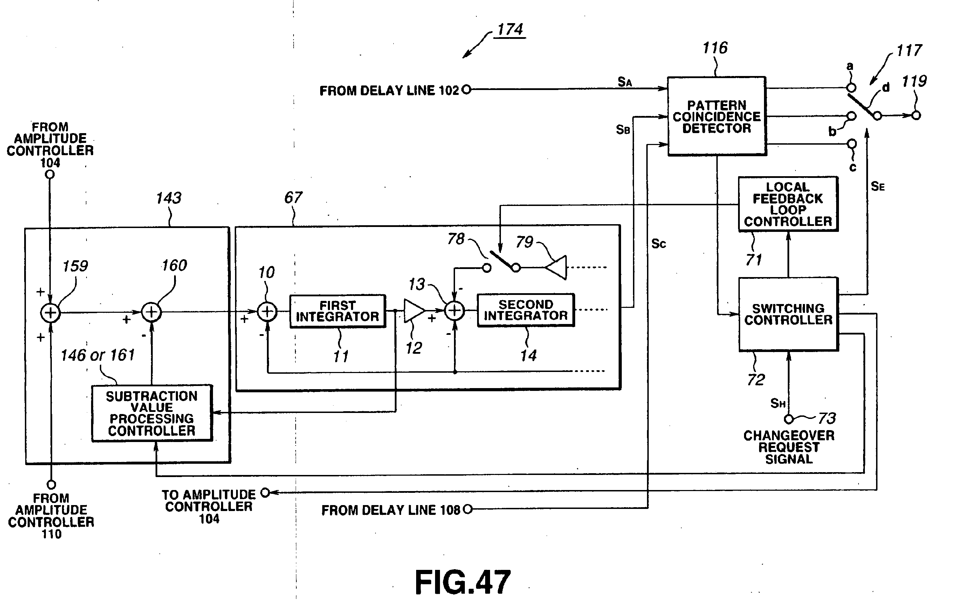

Referring to Fig.17, a seventeenth embodiment is explained. This seventeenth embodiment is directed to a digital signal processing device 125 designed for switching between two-channel $\Sigma\Delta$ modulated signals $S_A$, $S_C$ and a 1-bit signal $S_B$ obtained on $\Sigma\Delta$ re-modulating a signal $S_X$ by a $\Sigma\Delta$ modulator 67 having a local feedback loop shown in Fig.26. The signal $S_X$, in turn, is obtained by amplitude-controlling these two-channel $\Sigma\Delta$ modulated signals $S_A$, $S_C$. The basic arrangement is similar to that of the digital signal processing device 100 shown in Fig.29. The arrangement of the $\Sigma\Delta$ modulator and the peripheral circuitry are also shown in Fig.47.

That is, the present digital signal processing device 125 includes two delay lines 102, 108, two bit length converters 103, 109, two amplitude controllers 104, 110 and an amplitude control output adjustment unit 105. The present digital signal processing device 125 also includes a $\Sigma\Delta$ modulator having a local feedback loop 67, a changeover switch 117, a switching controller 72, subtraction value processing controllers 68, 69 for the integrators, a pattern coincidence detector 116 and a local feedback loop controller 71.

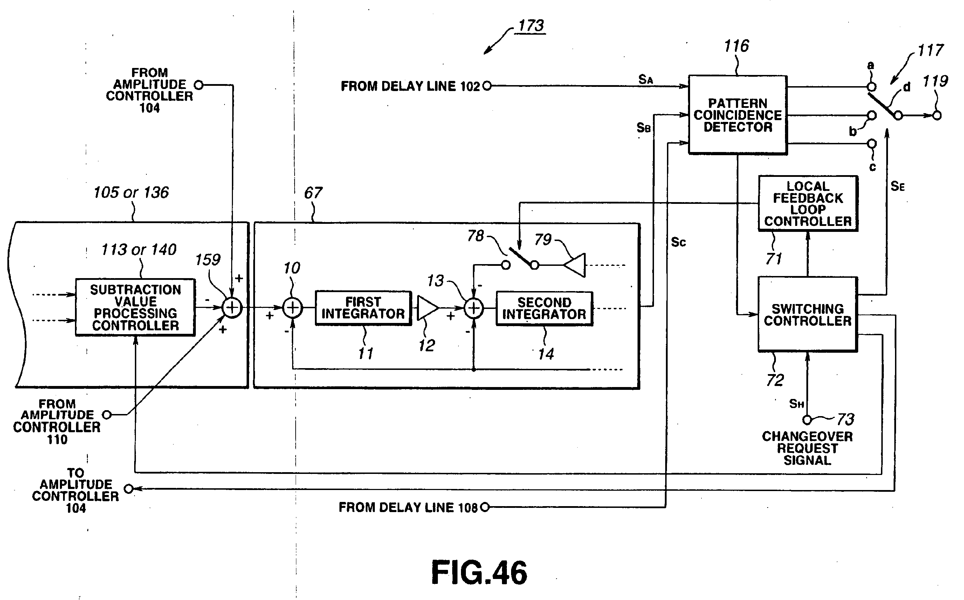

The arrangement of the $\Sigma\Delta$ modulator having a local feedback loop 67 and the subtraction value processing controller in the amplitude control output adjustment unit may be configured as the $\Sigma\Delta$ modulator having a local feedback loop 67 in the digital signal processing devices 173, 174 and 175 and the amplitude control output adjustment units 105, 143 and 176 shown in Figs.46 to 48. Within the $\Sigma\Delta$ modulator having a local feedback loop 67 is provided a switch 78 for opening/closing the local feedback loop.

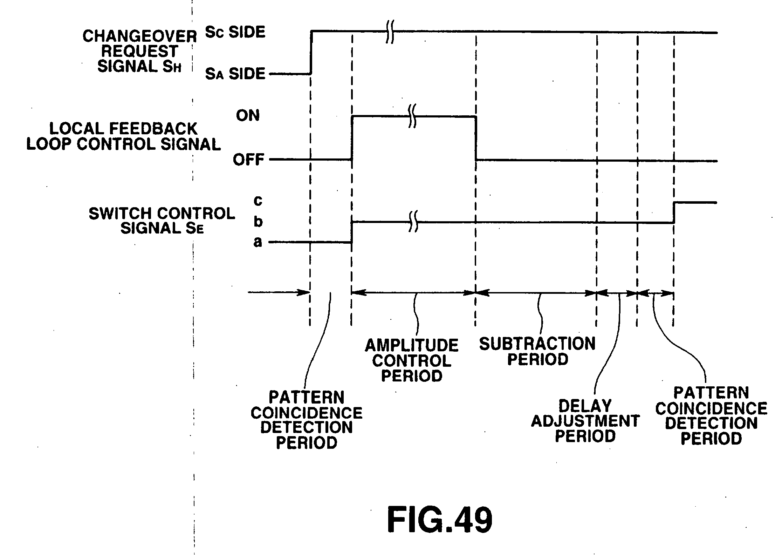

The operation of the digital signal processing device 125 is now explained by referring to the timing chart of Fig.49.

During the time the delayed original 1-bit signal $S_A$ from the delay line 102 is selected by the changeover switch 117, the local feedback loop controller 71 opens the switch 78 for turning off the local feedback loop of the $\Sigma\Delta$ modulator having a local feedback loop 67 to inhibit local feedback. On reception of the switching request signal $S_H$ for switching from the original 1-bit signal $S_A$ from the original 1-bit signal $S_B$ for cross-fading, the switching controller 72 first detects pattern coincidence in the pattern coincidence detector 116 and then receives the switch control signal $S_E$ to cause the changeover switch 117 to switch from the original 1-bit signal $S_A$ to the signal $S_B$ of the $\Sigma\Delta$ modulator having a local feedback loop 67.

In response thereto, the local feedback loop controller 71 turns on the switch 78 to complete the local feedback loop of the $\Sigma\Delta$ modulator having a local feedback loop 67 to activate local feedback. Subsequently, the local feedback loop controller 71 undergoes the amplitude processing by the amplitude controllers 104, 110 to reach respective gain values of 0 and 1, respectively. The local feedback loop controller 71 then receive a switching request to the original 1-bit signal $S_C$ from the $\Sigma\Delta$ re-modulated signal $S_B$ to turn off the switch 78 to open the local feedback loop of the $\Sigma\Delta$ modulator having a local feedback loop 67 to terminate local feedback.

In response thereto, the switching controller 72 receives the switching control signal $S_E$ following subtraction processing by the subtraction value processing controller and the pattern coincidence detection processing, for realization of the noise-free switching, and causes the changeover switch 117 to switch from tne $\Sigma\Delta$ re-modulated signal $S\beta$ to the original 1-bit signal $S_C$.

Thus, if the 1-bit output signal derived from the output terminal 119 of the digital signal processing device 125 is restored by a low-pass filter through a low-pass filter, the listener can hear high-quality cross-faded sound from the original audio signal of the first channel to the original audio signal of the second channel.

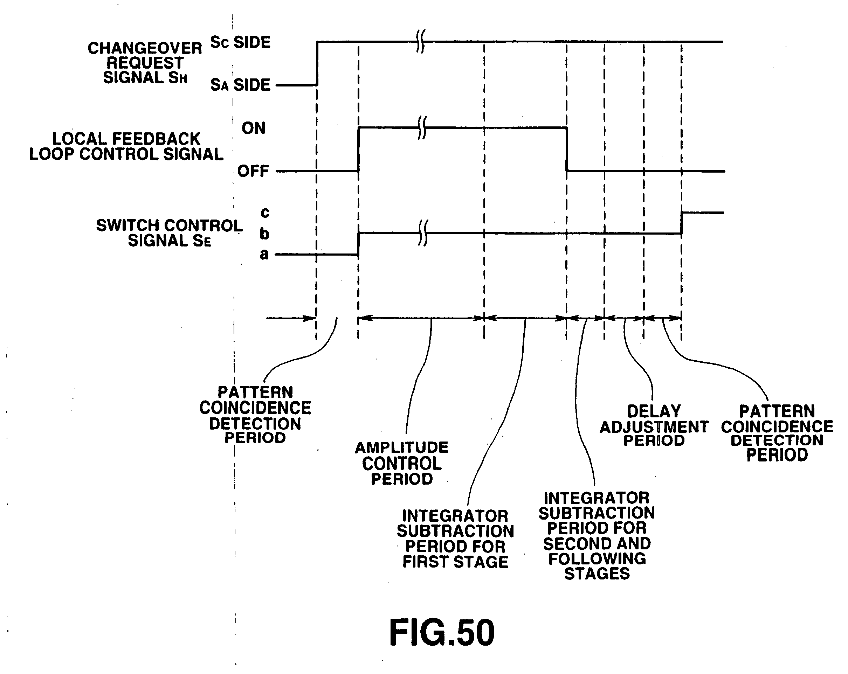

Fig.50 illustrates, by a timing chart, another example of the on-of control by the switch 78 of local feedback of the $\Sigma\Delta$ modulator having a local feedback loop 67 by the local feedback loop controller 71.

The operation up to activation of the local feedback loop is the same as that shown in Fig.49. After the local feedback loop controller 71 undergoes the amplitude processing by the amplitude controller 104, 110 to reach respective gain values of 0 and 1, respectively, the switching controller 72 receives a switching request to the original 1-bit signal $S_C$ from the $\Sigma\Delta$ re-modulated signal $S_B$ to perform subtraction processing for the first-stage integrator by the subtraction value processing controller or the first subtraction value processing controller 171.

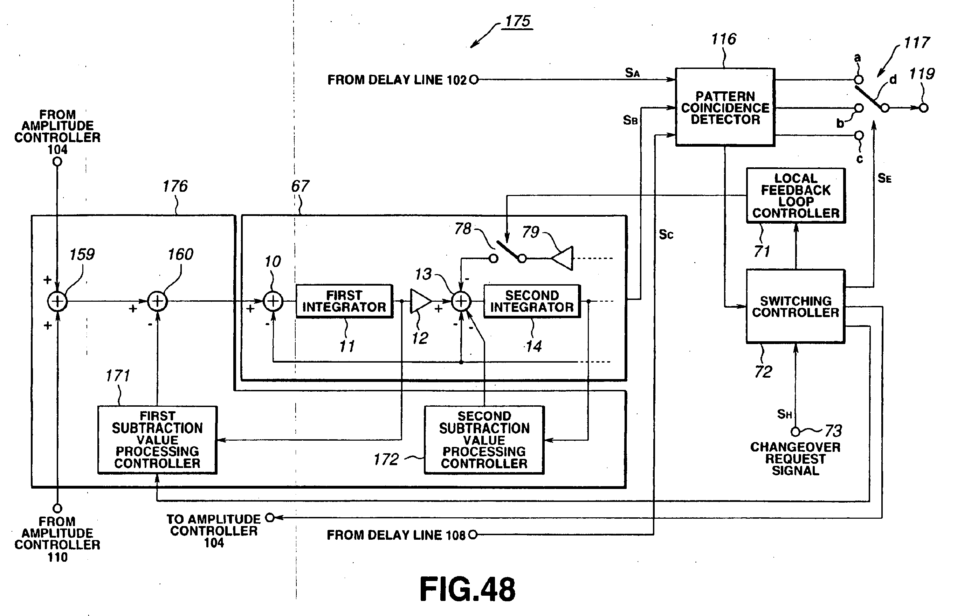

The local feedback loop controller 71 then turns off the local feedback loop control signal and turns off the switch 78 to open the local feedback loop of the $\Sigma\Delta$ modulator having a local-feedback loop 67 to terminate local feedback. If the device has second and following stages of the integrators as shown in Fig.48, the local feedback loop controller 71 sequentially performs subtraction processing for the second and following stages of the integrators by the second and following stages of the subtraction value processing controllers and undergoes the pattern coincidence detection processing to receive the switch control signal $S_E$ to switch from the output $S_B$ of the $\Sigma\Delta$ re-modulator having local feedback loop to the original 1-bit signal $S_C$.

The control of the local feedback lop at the timing shown in Fig.50 is effective for a modulator, as $\Sigma\Delta$ modulator having a local feedback loop 67, in which the local feedback loop is not connected to a point ahead of the initial stage integrator 11, such as a five-order $\Sigma\Delta$ modulator shown for example in Fig.26. This realizes a $\Sigma\Delta$ re-modulated signal

having a local feedback loop until directly before switching.

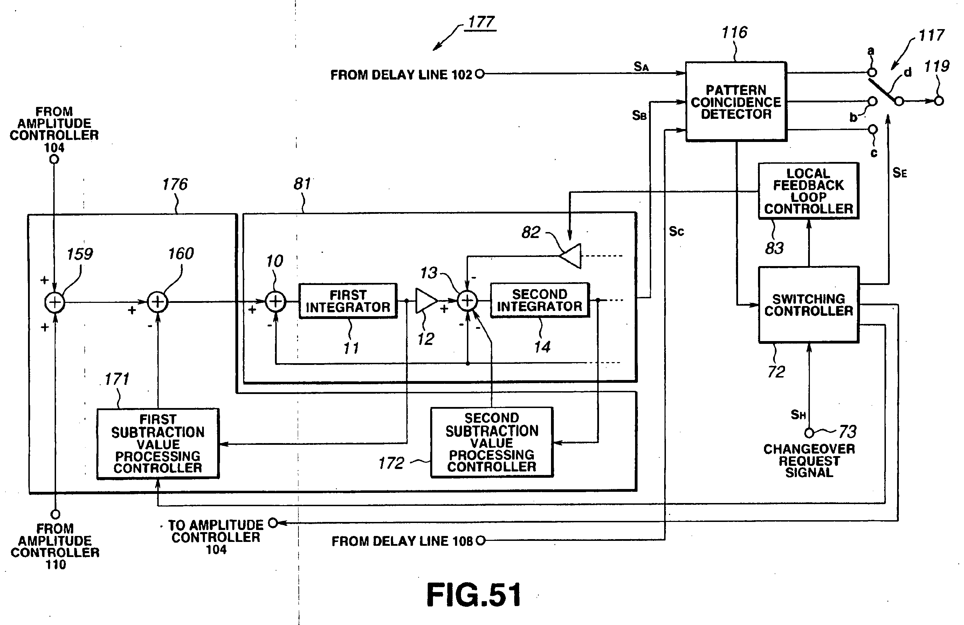

The ΣΔ modulator having a local feedback loop 67 may be configured as shown in Fig.51. That is, the feedback loop gain by the variable gain multiplier 82 of the ΣΔ modulator having a local feedback loop 81 may be variably controlled by the local feedback loop controller 83. Although the exceptional case of the device having plural stages of the subtraction value processing controllers configured as shown in Fig.48 has been described in the above, this is not to be construed in the limiting sense.

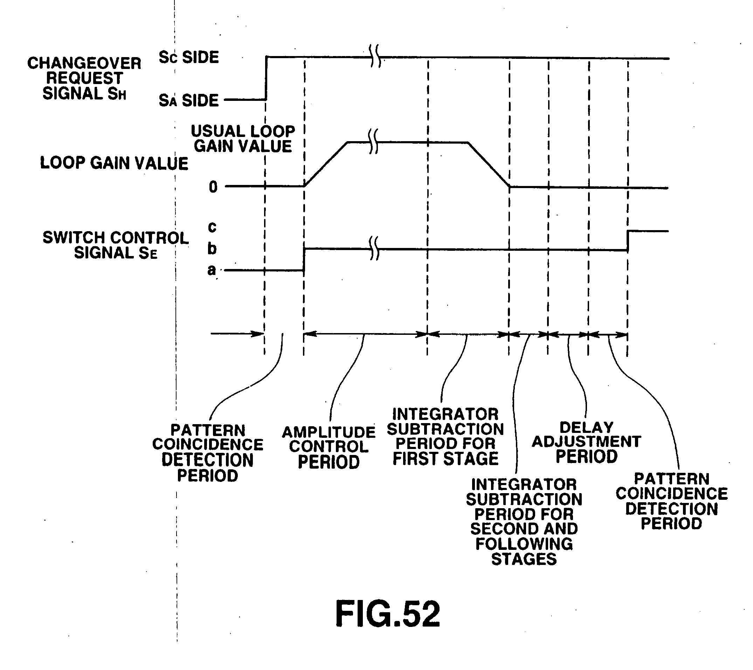

The operation for this case is explained by referring to the timing chart of Fig.52. During the time the delayed original 1-bit signal is selected by the changeover switch 117, the local feedback loop controller 83 sets the loop gain value sent to the variable gain multiplier 82 of the local feedback loop of the ΣΔ modulator having a local feedback loop 81 to zero without performing local feedback. On reception of the switching request signal $S_H$ from the original 1-bit signal $S_A$ to the signal $S_C$, for cross-fading, the switching controller 72 first detects the pattern coincidence at the pattern coincidence detector 70 and then receives the switching control signal $S_E$ to cause the changeover switch 117 to switch from the original 1-bit signal $S_A$ to the output $S_B$ of the ΣΔ modulator having local feedback loop.

In response thereto, the local feedback loop 83 gradually varies the loop gain value to the variable gain multiplier 82 to a stationary loop gain value for activating the feedback to the ΣΔ modulator having local feedback loop. 81. If, after the gain values are restored to 0 and 1 through the amplitude processing performed by the amplitude controllers 104, 110, respectively, the switching controller 72 receives a switching request from the ΣΔ re-modulated signal $S_B$ to the original 1-bit signal $S_C$, the switching controller 72 performs subtraction processing for the first-stage integrator by the subtraction value processing controller or the first subtraction value processing controller 171 for realizing noise-free switching. Simultaneously of with a slight time delay if the local feedback loop is not connected to a point ahead of the first-stage integrator, the local feedback loop controller 83 gradually diminishes the loop gain value to the variable gain multiplier 82 and ultimately to zero for opening the local feedback loop for terminating local feedback. If the device has second and following stages of the subtraction value processing controllers after cessation of the processing and local feedback, the local feedback loop controller 83 receives the switch control signal $S_E$ after sequentially performing subtraction processing for the second and following stage integrators by the second and following stage subtraction value processing controller 172 and the pattern coincidence detection processing to cause the switch 117 to switch from the output $S_B$ of the ΣΔ modulator having local feedback loop 81 to the original 1-bit signal $S_C$.

With the digital signal processing device 65, it is assumed that two local feedback loops are controlled simultaneously by an arrangement in which the five-order ΣΔ modulator has two local feedback loops. However, the same effect may be realized by controlling only the input side feedback loop. The similar effect may also be realized by setting the opening timing of the downstream side local feedback loop so as to be temporally after the end of the subtraction processing for the integrator upstream of the integrator to which is connected the feedback loop.

Although the five-order ΣΔ modulator shown in Fig.26 is used in the digital signal processing device 65 as the ΣΔ modulator having the local feedback loop, there is no limitation to the number of orders or the number of feedback loops.

The ΣΔ modulator having the local feedback loop may be configured as shown in Fig.51 for outputting variable loop gain from the local feedback controller 83 to the variable gain multiplier 82.

It is to be noted that the application shown as the switching device for an input obtained by a two-channel ΣΔ modulator can be applied to a device for scanning the amplitude of an input signal obtained by a single-channel ΣΔ modulation

## Claims

1. A digital signal processing apparatus(1) for switching between a delayed sigma-delta modulated signal ($S_A$), obtained by delaying a sigma-delta modulated signal, as an input signal, and a sigma-delta re-modulated signal ($S_B$) obtained by sigma-delta re-modulation of said input signal, said apparatus comprising:

   input signal delaying means (3) for delaying said input signal by a pre-set number of samples, for outputting said delayed sigma-delta modulated signal ($S_A$);
   sigma-delta modulation processing means (6) having a plurality of integrators (11, 14, 17, 20, 23) for outputting said sigma-delta re-modulated signal ($S_B$);
   level adjustment means (5) for adjusting the amplitude level of the sigma-delta modulated signal entering said sigma-delta modulation processing means (6) to match the amplitude level of a feedback signal to a first-stage integrator (11) employed in said sigma-delta modulation processing means (6); and
   switching control means (7) for controlling the switching by a switching means (4).

2. The digital signal processing apparatus as claimed in claim 1 wherein a gain ratio between a first-stage feedback loop in said sigma-delta modulation processing means (6) and the next-stage feedback loop is an integer and wherein the pre-set number of samples of said input signal delay means (3) is set based on said gain ratio.

3. The digital signal processing apparatus as claimed in claim 1 or 2, further comprising pattern coincidence detection means (28) for detection of coincidence of said delayed sigma-delta modulated signal ($S_A$) and the sigma-delta re-modulation signal ($S_B$) over a plurality of samples; said switching control means (29) controlling said switching means based on the result of detection obtained by said pattern coincidence detection means (28).

4. The digital signal processing apparatus as claimed in claim 1, 2 or 3,
wherein said switching control means (29) sets the initial value of the integrator of said sigma-delta modulation processing means (6) to zero directly before input of said input signal and/or during the time the delayed sigma-delta modulated signal ($S_A$) from said input signal delaying means (3) is selected by switching by said switching means (4).

5. The digital signal processing apparatus as claimed in claim 1, 2, 3 or 4, further comprising amplitude controlling means (35) for controlling the amplitude level of a level-adjusted signal ($S_1$) having the amplitude level adjusted by said level adjustment means; said switching control means (48) causing said amplitude control means to control the amplitude level of said level-adjusted signal after causing said switching means to switch from the delayed sigma-delta modulated signal from said input signal delaying means to the sigma-delta re-modulated signal obtained on sigma-delta modulation of said level-adjusted signal.

6. The digital signal processing apparatus as claimed in claim 1, 2, 3 or 4, further comprising:

amplitude controlling means (35) for controlling the amplitude level of the level-adjusted signal having its amplitude level adjusted by said level adjustment means (5);
level difference detection means (42) for detecting the difference between the maximum amplitude level of the level-adjusted signal and the amplitude level of the output following amplitude control during the time said amplitude controlling means (35) is controlling the amplitude level of the level-adjusted signal;
cumulative addition means (46) for cumulatively adding the level difference from said level difference detection means (42) with a maximum amplitude level width length equal to twice the maximum amplitude level of said level-adjusted signal; and
subtraction control means (47) for gradually subtracting the cumulative sum of said cumulative addition means from the maximum amplitude level of said level-adjusted signal after the amplitude control in said amplitude controlling means (35);
said switching control means (48) causing said switching means (4) to switch from said sigma-delta modulated signal to said delayed sigma-delta modulated signal after the end of subtraction of said cumulative sum in said subtraction control means (47).

7. The digital signal processing apparatus as claimed in any one of the preceding claims, wherein, if a first integrator (51) of said sigma-delta modulation processing means is provided with limiter means (54) for limiting an integrated value of said first integrator (51) with a limiting value equal to an integer number times the maximum amplitude level width, said switching control means (48) clears the cumulative sum value of the cumulative addition means to zero during the time said limiter means (54) is operating in a state in which said integrated value is larger than the limiter value.

8. The digital signal processing apparatus as claimed in claim 1, further comprising:

error detection means (57) for detecting an uncorrectable burst error in said sigma-delta modulated signal;
delaying means (58) provided downstream of said error detection means (57) for delaying said sigma-delta modulated signal;
fade-out means (60) for fading out said sigma-delta modulated signal via said delay means;
fade-in means (60) for fading in said sigma-delta modulated signal via said delay means; and
control means (59) for causing said fade-out means to fade out said sigma-delta modulated signal delayed by said delaying means up to directly before an uncorrectable burst error immediately to a zero level if said error detection means detects such uncorrectable burst error in said sigma-delta modulated signal, said control means causing said fade-in means to fade in said sigma-delta modulated signal directly after said burst error up to the maximum amplitude level.

9. The digital signal processing apparatus as claimed in claim 8, wherein said fade-out means (60) includes amplitude control means for controlling the amplitude level of the level-adjusted signal having the amplitude level adjusted by the level adjustment means;

said fade-out means (60) causing said amplitude control means to control the amplitude level of said level-adjusted signal to execute fade-out processing after said switching control means has caused said switching means to switch from the delayed sigma-delta modulated signal from said input signal delaying means to the sigma-delta re-modulated signal from said sigma-delta modulation processing means.

10. The digital signal processing apparatus as claimed in claim 8, wherein said fade-in means (60) includes;

amplitude control means for controlling the amplitude level of the level-adjusted signal having the amplitude level adjusted by said level adjustment means;

level difference detection means for detecting the difference between the maximum amplitude level of the level adjusted signal and the amplitude level of a level controlled output during the time said amplitude control means controls the amplitude level of said level-adjusted signal,

cumulative addition means for cumulatively adding the level difference from said level difference detection means with a maximum amplitude level width length equal to twice the maximum amplitude level of said level-adjusted signal; and

subtraction control means for gradually decreasing, after amplitude control by said amplitude control means, the cumulative sum of said cumulative addition means from the maximum amplitude level of said level-adjusted signal;

wherein said switching control means causes said switching means to switch from said sigma-delta re-modulated signal to said delayed sigma-delta re-modulated signal after the end of subtraction of said cumulative sum in said subtraction control means to execute fade-in.

11. The digital signal processing apparatus as claimed in any one of the preceding claims, wherein said sigma-delta modulation processing means (6) includes:

a plurality of stages of serially-connected integrators (11, 14, 17, 20, 23); and
a local feedback loop for feeding back an output of said plural stage integrators to inputs of preceding stage integrators.

12. A digital signal processing device (100) for causing switching means (117) to switch between a two-channel sigma-delta modulated signal, as an input signal obtained by two-channel sigma-delta modulation processing, and a sigma-delta re-modulated signal ($S_B$) derived from the input signal, said device comprising:

sigma-delta modulation processing means (115) having a plurality of integrators (11, 14, 17, 20, 23) for outputting said sigma-delta re-modulated signal ($S_B$);

first input signal delaying means (102) for delaying the sigma-delta modulated signal of a first of said two channels by a pre-set number of samples for outputting a first delayed sigma-delta modulated signal ($S_A$);

first level adjustment means (103) for adjusting the amplitude level of the sigma-delta modulated signal of a first of said two channels to match the amplitude level of the feedback signal to a first-stage integrator (11) employed in said sigma-delta modulation processing means (115); and

first amplitude control means (104) for controlling the amplitude level of a first level-adjusted signal ($S_{II}$) having the amplitude level adjusted by the first level adjustment means (103);

second input signal delaying means (108) for delaying the sigma-delta modulated signal of a second of said two channels by a pre-set number of samples for outputting a second delayed sigma-delta modulated signal ($S_C$);

second level adjustment means (109) for adjusting the amplitude level of the sigma-delta modulated signal of a second of said two channels to match the amplitude level of the feedback signal to the first-stage integrator (11) employed in said sigma-delta modulation processing means (115);

second amplitude control means (110) for controlling the amplitude level of a second level-adjusted signal ($S_{I2}$) having the amplitude level adjusted by the second level adjustment means (109);

amplitude control output adjustment means (105) for adjusting outputs of said first amplitude control means (104) and said second amplitude control means (110); and

switching control means (118) for controlling said first amplitude control means (104), second amplitude control means (110), sigma-delta modulation processing means (115), amplitude control output adjustment means (105) and said switching means (117);

said switching control means (118) after switching from said first sigma-delta modulated signal ($S_A$) to said delta re-modulated signal ($S_B$) causing said first amplitude control means (104), second amplitude control means (110) and the amplitude control output adjustment means (105) to control amplitude levels of said sigma-delta modulated signal ($S_A$) and said other sigma-delta modulated signal ($S_C$).

13. The digital signal processing apparatus as claimed in claim 12,
wherein a gain ratio between the initial-stage feedback loop in said sigma-delta modulation processing means (115) and the next-stage feedback loop is an integer and wherein the pre-set number of samples of said input signal delay means (102, 108) is set based on said gain ratio.

14. The digital signal processing apparatus as claimed in claim 12 or 13, further comprising pattern coincidence detection means (116) for detection of coincidence of said first delayed sigma-delta modulated signal ($S_A$) and the sigma-delta re-modulated signal ($S_B$) over a plurality of samples and for detection of coincidence of said second delayed sigma-delta modulated signal ($S_C$) and the sigma-delta re-modulated signal ($S_B$) over a plurality of samples; said first delayed sigma-delta modulated signal ($S_A$) being switched to the sigma-delta re-modulated signal ($S_B$) or vice versa based on a control signal obtained by said pattern coincidence detection means (116) and said second delayed sigma-delta modulated signal ($S_C$) being switched to the sigma-delta re-modulated signal ($S_B$) or vice versa based on the control signal obtained by said pattern coincidence detection means (116).

15. The digital signal processing apparatus as claimed in claim 12, 13 or 14, wherein said switching control means (118) sets the initial value of the integrator (11) of said sigma-delta modulation processing means (115) to zero directly before input of said input signal and/or during the time the delayed signal from said first (102) and second (108) input signal delaying means is selected by switching by said switching means (117).

16. The digital signal processing apparatus as claimed in claim 12, 13, 14 or 15, wherein said sigma-delta modulation processing means (115) includes:

   a plurality of stages of integrators (11, 14, 17, 20, 23) connected in series; and
   a local feedback loop for feeding back outputs of said plurality of stages of the integrators to inputs of preceding stages of the integrators.

17. The digital signal processing apparatus as claimed in any one of claims 12 to 16, wherein said amplitude control output adjustment means (105) includes subtraction means (145) for subtracting a pre-set value from output signals obtained by said first (104) and second (110) amplitude control means.

18. The digital signal processing apparatus as claimed in claim 17,
wherein said amplitude control output adjustment means (105) determines a subtraction value in subtraction means based on an accumulated value of the difference between the amplitude level by said amplitude control means and the maximum amplitude level obtained by said level adjustment means.

19. The digital signal processing apparatus as claimed in claim 18,
wherein said amplitude control output adjustment means includes:

   level difference detection means for detecting the difference between the first level-adjusted signal and an output level after amplitude control by said first amplitude control means during the period said first amplitude control means controls the amplitude level of the first level-adjusted signal;
   cumulative addition means for cumulatively adding the level difference from the level difference detection means and the output level after control of the amplitude level of the second level- adjusted signal by the second amplitude control means with the amplitude level width lengths of the first and second level-adjusted signals; and
   subtraction control means for controlling the subtraction means for gradually subtracting the cumulative sum of said cumulative addition means from an output signal of said amplitude control means

20. The digital signal processing apparatus as claimed in claim 19,
wherein said switching control means after switching from said first delayed delta modulated signal to said sigma-delta re-modulated signal controlling the operation of said first amplitude control means and the operation of said second amplitude control means for controlling the amplitude levels of the sigma-delta modulated signal and the other sigma-delta modulated signal, said switching control means then gradually causing said subtraction value control means to subtract the cumulative sum of the cumulative action means from an output signal of said amplitude control means, said switching control means also causing said switching means to switch from an output of the sigma-delta modulation processing means to said second delayed sigma-delta modulated signal

21. The digital signal processing apparatus as claimed in claim 20,
wherein, if limiter means (54) are provided in the first integrator (51) of said sigma-delta modulation processing means (115) for limiting an integrated value of the first integrator to a limiter value equal to an integer number times the maximum level width, said switching control means clears the cumulative sum value of the cumulative addition means to zero during the time said limiter means is operation with the integrated value larger than the limiter value.

22. The digital signal processing apparatus as claimed in claim 18,
wherein said amplitude control output adjustment means includes level difference detection means for detecting the difference between the second level-adjusted signal and an output level amplitude-controlled by the second amplitude control means during the period said second amplitude control means is controlling the amplitude level of the second level adjusted signal;
cumulative addition means for cumulatively adding the level difference from the level difference detection means and an output level after said first amplitude control means has adjusted the amplitude level of the first level-adjusted means with an amplitude level width lengths of the first and second level adjusted signals.

23. The digital signal processing apparatus as claimed in claim 22,
wherein said switching control means (48) after switching from said first delayed delta modulated signal ($S_A$) to said sigma-delta re-modulated signal ($S_B$) controlling the operation of said first amplitude control means (104) and the operation of said second amplitude control means (110) for controlling the amplitude levels of the sigma-delta modulated signal and the other sigma-delta modulated signal, said switching control means (48) then causing said subtraction value control means to subtract the cumulative sum of the cumulative addition means gradually from an output signal of said amplitude control means, said switching control means (48) also causing said switching means to switch from an output of the sigma-delta modulation processing means to said second delayed sigma-delta modulated signal.

24. The digital signal processing apparatus as claimed in claim 23,
wherein, if limiter means (54) are provided in the first integrator (51) of said sigma-delta modulation processing means (115) for limiting an integrated value of the first integrator to a limiter value equal to an integer number times the maximum level width, said switching control means clears the cumulative sum value of the cumulative addition means to zero during the time said limiter means is operating with the integrated value larger than the limiter value.

25. The digital signal processing apparatus as claimed in claim 17,
wherein said sigma-delta modulation processing means (115) is comprised of at least one integrator (51) and wherein said amplitude control output adjustment means (105) detects a remainder from a reference value of each stage that is based on the structure of the sigma-delta modulation processing means, and determines a subtraction value in the subtraction means provided in an input stage of the integrator based on the detected remainder value.

26. The digital signal processing apparatus as claimed in claim 25,
wherein said amplitude control output adjustment means includes remainder value detection means for detecting a remainder value from the maximum amplitude level width in a first-stage integrator (51) in said sigma-delta modulation processing means; and
subtraction control means for gradually subtracting the detected remainder value from the maximum amplitude level signal; wherein
said switching control means (48) after switching from said first delayed delta modulated signal to said sigma-delta re-modulated signal controlling the operation of said first amplitude control means and the operation of said second amplitude control means for controlling the amplitude levels of the sigma-delta modulated signal and the other sigma-delta modulated signal, said switching control means then causing said subtraction value control means to subtract the cumulative sum of the cumulative addition means gradually from an output signal of said amplitude control means, said switching control means also causing said switching means to switch from an output of the sigma-delta modulation processing means to said second delayed sigma-delta modulated signal.

27. The digital signal processing apparatus as claimed in claim 26,
wherein said remainder value detection means detects a remainder of the sum of the integrated value and the maximum amplitude level from the maximum amplitude level width and wherein said subtraction control means gradually subtracts from the maximum amplitude level signal the result of subtraction of the addition remainder obtained on subtracting the maximum amplitude level from the remainder.

28. The digital signal processing apparatus as claimed in claim 25, 26 or 27, further comprising limiter means (54) for limiting an integrated value of at least one integrator (51) in said sigma-delta modulation processing means.

**29.** The digital signal processing apparatus as claimed in claim 28,
wherein, when limiter means (54) for limiting an integrated value in a first integrator (51) of said sigma-delta modulation processing means (115) are provided, remainder value detection means for detecting the remainder value from the maximum amplitude level width of a value derived from the limited integrated value of the first-stage integrator in said sigma-delta modulation processing means and subtraction control means for gradually subtracting the detected remainder value from the maximum amplitude level signal; said amplitude control output adjustment means before switching from the first delayed sigma-delta modulated signal to the sigma-delta re-modulated signal gradually subtracting said remainder value from the maximum amplitude level signal entering said sigma-delta modulation processing means, during the period the first delayed sigma-delta modulated signal is selected, using said subtracting control means.

**30.** The digital signal processing apparatus as claimed in claim 29,
wherein said remainder value detection means detects a remainder value from the maximum amplitude level width of a value obtained on summing the limited integrated value to the maximum amplitude level and wherein said subtraction control means gradually subtracts the result of subtraction of the sum remainder obtained on subtracting the maximum amplitude level from the remainder value.

**31.** The digital signal processing apparatus as claimed in any one of claims 12 to 30, wherein, if limiter means (54) for limiting the integrated value is provided in the integrator (51) of said sigma-delta modulation processing means, a limiter value of the limiting means (54) is selected to be an integer number times the maximum amplitude level width.

**32.** The digital signal processing apparatus as claimed in claim 12 to 31, further comprising mute pattern signal generating means (132) in one of the two channels.

**33.** The digital signal processing apparatus as claimed in claim 25,
wherein, when controlling an integrated value of the second stage integrator and following stage integrators in said sigma-delta modulation processing means, said amplitude control output adjustment means causes the remainder value detection means in the pre-set stage to detect a remainder value from the maximum amplitude level width obtained on the basis of a product value ahead of the pre-set stage in the sigma-delta modulation processing means.

**34.** The digital signal processing apparatus as claimed in claim 33,
wherein, when gradually subtracting the remainder value detected by the remainder value detection means by subtraction means provided at an input stage to said integrator, the subtraction is sequentially controlled beginning from the integrator on the input side, and wherein switching from an output of said sigma-delta modulation processing means (115) to said second delayed sigma-delta modulated signal ($S_C$) is performed by said switching means (117).

**35.** The digital signal processing apparatus as claimed in claim 25, further comprising limiter means for limiting an integrated value of the second and following stage integrators in said sigma-delta modulation processing means.

**36.** The digital signal processing apparatus as claimed in claim 17 or 34,
wherein said sigma-delta modulation processing means (115) includes:

> a plurality of stages of integrators connected in series;
> a local feedback loop for feeding back outputs of said plural stages of the integrators to inputs of preceding stage integrators; and
> opening/closure means for said local feedback loop;

wherein, during the time said switching control means selects said first delayed sigma-delta modulated signal, said opening/closure means opens said local feedback loop; wherein, if the switching control means selects the sigma-delta modulated signal after said sigma-delta re-modulation, said opening/closure means shorts said local feedback loop and wherein, if the switching control means selects the delayed second sigma-delta modulated signal, said opening/closure means opens said local feedback loop before start of subtraction processing for the integrator to which is fed back the local feedback loop signal.

**37.** A digital signal processing method of switching between a delayed sigma-delta modulated signal ($S_A$) obtained by delaying a sigma-delta modulated signal, as an input signal, and a sigma-delta re-modulated signal ($S_B$) obtained by sigma-delta re-modulation of said input signal, said method comprising:

an input signal delaying step of delaying said input signal by a pre-set number of samples and outputting the delayed sigma-delta modulated signal ($S_A$);

a sigma-delta modulating step for outputting said sigma-delta re-modulated signal ($S_B$) using a plurality of integrators (11, 13, 17, 20, 23);

a level adjustment step of adjusting the amplitude level of the sigma-delta modulated signal entering the sigma-delta modulation processing step to match the amplitude level of the feedback signal to the first-stage integrator (11) used in said sigma-delta modulating step; and

a switching control step for controlling said switching.

**38.** The digital signal processing method as claimed in claim 37, further comprising an amplitude controlling step of controlling the amplitude level of the level-adjusted signal having its amplitude level adjusted by the level adjustment step; said switching control step causing said switching step to switch the delayed sigma-delta modulated signal from the input signal delaying step to the sigma-delta re-modulated signal obtained on sigma-delta modulation of the level-adjusted signal, said switching control step then causing said amplitude control step to control the amplitude of said level-adjusted signal.

**39.** A digital signal processing method for causing a switching step to switch from a two-channel sigma-delta modulated signal, as an input signal obtained by two-channel sigma-delta modulation processing, and a sigma-delta re-modulated signal ($S_B$) derived from the input signal, said method comprising:

a sigma-delta modulation processing step using a plurality of integrators (11, 13,17,20,23) for outputting said sigma-delta re-modulated signal ($S_B$);

a first input signal delaying step for delaying a sigma-delta modulation signal of a first of said two channels by a pre-set number of samples for outputting a first delayed sigma-delta modulated signal ($S_A$);

a first level adjustment step for adjusting the amplitude level of the sigma-delta modulated signal of a first of said two channels to match the amplitude level of the feedback signal to a first-stage integrator (11) employed in said sigma-delta modulation processing step;

a first amplitude control step for controlling the amplitude level of a first level-adjusted signal ($S_{I1}$) having the amplitude level adjusted in the first level-adjustment step;

a second input signal delaying step for delaying the sigma-delta modulated signal of a second of said two channels by a pre-set number of samples for outputting a second delayed sigma-delta modulated signal($S_C$);

a second level adjustment step for adjusting the amplitude level of the sigma-delta modulated signal of a second of said two channels to match the amplitude level of the feedback signal to the first-stage integrator employed in said sigma-delta modulation processing step;

a second amplitude control step for controlling the amplitude level of a second level-adjusted signal ($S_{I2}$) having the amplitude level adjusted in the second level adjustment step;

an amplitude control output adjustment step for adjusting outputs of said first amplitude control step and said second amplitude control step; and

a switching control step for controlling said first amplitude control step, second amplitude control step, sigma-delta modulation processing step, amplitude control output adjustment step and said switching step;

said switching control step after switching from said first sigma-delta modulated signal ($S_A$) to said delta re-modulated signal ($S_B$) causing said first amplitude control step, second amplitude control step and the amplitude control output adjustment step to control amplitude levels of said two-channel sigma-delta modulated signals ($S_A$, $S_C$).

**Patentansprüche**

**1.** Digitalsignal-Verarbeitungsvorrichtung (1) zum Umschalten zwischen einem verzögerten sigma-delta-modulierten Signal ($S_A$), welches durch Verzögern eines sigma-delta-modulierten Signals als Eingangssignal erlangt wird, und eines sigma-delta-zurückmodulierten Signals ($S_B$), welches durch Sigma-Delta-Zurückmodulation des Eingangssignals erlangt wird, wobei die Vorrichtung umfasst:

eine Eingangssignal-Verzögerungseinrichtung (3) zum Verzögern des Eingangssignals um eine vorher festgelegte Anzahl an Proben zum Ausgeben des verzögerten sigma-delta-modulierten Signals ($S_A$):

eine Sigma-Delta-Modulations-Verarbeitungseinrichtung (6), welche mehrere Integratoren (11, 14, 17, 20, 23) hat, um das sigma-delta-zurückmodulierte Signal ($S_B$) auszugeben;

eine Pegeleinstelleinrichtung (5) zum Einstellen des Amplitudenpegels des sigma-delta-modulierten Signals, welches in die Sigma-Delta-Modulations-Verarbeitungseinrichtung (6) eintritt, um den Amplitudenpegel eines Zurückführungssignals an einen erststufigen Integrator (11) anzupassen, der in der Sigma-Delta-Modulations-Verarbeitungseinrichtung (6) verwendet wird; und

eine Schaltsteuereinrichtung (7) zum Steuern des Schaltens durch eine Schalteinrichtung (4).

2. Digitalsignal-Verarbeitungsvorrichtung nach Anspruch 1, wobei ein Gewinnverhältnis zwischen einer erststufigen Zurückführungsschleife der Sigma-Delta-Modulations-Verarbeitungseinrichtung (6) und der nächststufigen Zurückführungsschleife eine ganze Zahl ist und wobei die vorher festgesetzte Anzahl an Proben der Eingangssignal-Verzögerungseinrichtung (3) auf Basis dieses Gewinnverhältnisses festgesetzt wird.

3. Digitalsignal-Verarbeitungsvorrichtung nach Anspruch 1 oder 2, welche außerdem eine Musterübereinstimmungs-Erfassungseinrichtung (28) zum Erfassen der Übereinstimmung des verzögerten sigma-delta-modulierten Signals ($S_A$) und des sigma-delta-zurückmodulierten Signals ($S_B$) über mehrere Proben umfasst; wobei die Schaltsteuereinrichtung (29) die Schalteinrichtung auf Basis des Erfassungsergebnisses steuert, welches durch die Musterübereinstimmungs-Erfassungseinrichtung (28) erlangt wird.

4. Digitalsignal-Verarbeitungsvorrichtung nach Anspruch 1, 2 oder 3,
wobei die Schaltsteuereinrichtung (29) den Anfangswert des Integrators der Sigma-Delta-Modulations-Verarbeitungseinrichtung (6) auf Null unmittelbar vor der Zuführung des Eingangssignals und/oder während der Zeit setzt, wo das verzögerte sigma-delta-modulierte Signal ($S_A$) von der Eingangssignal-Verzögerungseinrichtung (3) durch Umschalten durch die Schalteinrichtung (4) ausgewählt wird.

5. Digitalsignal-Verarbeitungsvorrichtung nach Anspruch 1, 2, 3 oder 4, welche außerdem eine Amplitudensteuereinrichtung (35) zum Steuern des Amplitudenpegels eines pegel-eingestellten Signals ($S_1$) aufweist, welches den Amplitudenpegel hat, der durch die Pegeleinstelleinrichtung eingestellt ist; wobei die Schaltsteuereinrichtung (48) veranlasst, dass die Amplitudensteuereinrichtung den Amplitudenpegel des pegel-eingestellten Signals steuert, nachdem veranlasst ist, dass die Schalteinrichtung von dem verzögerten sigma-delta-modulierten Signal von der Eingangssignal-Verzögerungseinrichtung auf das sigma-delta-zurückmodulierte Signal, welches bei der Sigma-Delta-Modulation des pegel-eingestellten Signals erlangt wird, umschaltet.

6. Digitalsignal-Verarbeitungsvorrichtung nach Anspruch 1, 2, 3 oder 4, welche außerdem aufweist:

eine Amplitudensteuereinrichtung (35) zum Steuern des Amplitudenpegels des pegel-eingestellten Signals, das einen Amplitudenpegel hat, der durch die Pegeleinstelleinrichtung (5) eingestellt ist;
eine Pegeldifferenz-Erfassungseinrichtung (42) zum Erfassen der Differenz zwischen dem maximalen Amplitudenpegel des pegel-eingestellten Signals und dem Amplitudenpegel des Ausgangssignals, das auf die Amplitudensteuerung folgt, während der Zeit, wo die Amplitudensteuereinrichtung (35) den Amplitudenpegel des pegel-eingestellten Signals steuert;
eine Kumulativ-Additionseinrichtung (46) zum kumulativen Addieren der Pegeldifferenz von der Pegeldifferenz-Erfassungseinrichtung mit einer maximalen Amplitudenpegel-Breitenlänge gleich dem zweifachen des maximalen Amplitudenpegels des pegel-eingestellten Signals; und
eine Subtraktionssteuereinrichtung (47) zum graduellen Subtrahieren der kumulativen Summe der Kumulativ-Additionseinrichtung vom maximalen Amplitudenpegel des pegel-eingestellten Signals nach der Amplitudensteuerung in der Amplitudensteuereinrichtung (35);

wobei die Schaltsteuereinrichtung (48) veranlasst, dass die Schalteinrichtung (4) vom sigma-delta-modulierten Signal auf das verzögerte sigma-delta-modulierte Signal nach dem Ende der Subtraktion der kumulativen Summe in der Subtraktionssteuereinrichtung (47) umschaltet.

7. Digitalsignal-Verarbeitungsvorrichtung nach einem der vorhergehenden Ansprüche, wobei, wenn ein erster Integrator (51) der Sigma-Delta-Modulations-Verarbeitungseinrichtung mit einer Begrenzereinrichtung (54) bereitgestellt wird, um einen integrierten Wert des ersten Integrators (51) mit einem begrenzenden Wert zu begrenzen, der gleich einer ganzzahligen Häufigkeit der maximalen Amplitudenpegelbreite ist, die Schaltsteuereinrichtung (48) den kumulativen Summenwert der Kumulativ-Additionseinrichtung auf null während der Zeit löscht, wo die Begrenzereinrichtung (54) in einem Zustand arbeitet, bei dem der integrierte Wert größer ist als der Begrenzerwert.

8. Digitalsignal-Verarbeitungsvorrichtung nach Anspruch 1, welche außerdem umfasst:

eine Fehlererfassungseinrichtung (57) zum Erfassen eines nichtkorrigierbaren Burst-Fehlers im sigma-delta-modulierten Signal;

eine Verzögerungseinrichtung (58), welche stromabwärts von der Fehlererfassungseinrichtung (57) vorgesehen ist, um das sigma-delta-modulierte Signal zu verzögern;

eine Ausblendeinrichtung (60) zum Ausblenden des sigma-delta-modulierten Signals über die Verzögerungseinrichtung;

eine Einblendeinrichtung (60) zum Einblenden des sigma-delta-modulierten Signals über die Verzögerungseinrichtung; und

eine Steuereinrichtung (59), um zu veranlassen, dass die Ausblendeinrichtung das sigma-delta-modulierte Signal, welches durch die Verzögerungseinrichtung verzögert ist, bis unmittelbar vor einem nichtkorrigierbaren Burst-Fehler unmittelbar auf einen Nullpegel ausblendet, wenn die Fehlererfassungseinrichtung diesen nichtkorrigierbaren Burst-Fehler im sigma-delta-modulierten Signal erfasst, wobei die Steuereinrichtung veranlasst, dass die Einblendeinrichtung das sigma-delta-modulierte Signal unmittelbar nach dem Burst-Fehler bis zum maximalen Amplitudenpegel einblendet.

9. Digitalsignal-Verarbeitungsvorrichtung nach Anspruch 8, wobei die Ausblendeinrichtung (60) eine Amplitudensteuereinrichtung zum Steuern des Amplitudenpegels des pegel-eingestellten Signals aufweist, welches den Amplitudenpegel hat, der durch die Pegeleinstelleinrichtung eingestellt ist;

wobei die Ausblendeinrichtung (60) veranlasst, dass die Amplitudensteuereinrichtung den Amplitudenpegel des pegel-eingestellten Signals steuert, um eine Ausblendverarbeitung auszuführen, nachdem die Schaltsteuereinrichtung veranlasst hat, dass die Schalteinrichtung von dem verzögerten sigma-delta-modulierten Signal von der Eingangssignal-Verzögerungseinrichtung auf das sigma-delta-zurückmodulierte Signal von der Sigma-Delta-Modulations-Verarbeitungseinrichtung umschaltet.

10. Digitalsignal-Verarbeitungsvorrichtung nach Anspruch 8, wobei die Einblendeinrichtung (60) umfasst:

eine Amplitudensteuereinrichtung zum Steuern des Amplitudenpegels des pegel-eingestellten Signals, welches den Amplitudenpegel hat, der durch die Pegeleinstelleinrichtung eingestellt ist;

eine Pegeldifferenz-Erfassungseinrichtung zum Erfassen der Differenz zwischen dem maximalen Amplitudenpegel des pegel-eingestellten Signals und dem Amplitudenpegel eines pegel-gesteuerten Ausgangssignals während der Zeit, wo die Amplitudensteuereinrichtung den Amplitudenpegel des pegel-eingestellten Signals steuert,

eine Kumulativ-Additionseinrichtung zum kumulativen Addieren der Pegeldifferenz von der Pegeldifferenz-Erfassungseinrichtung mit einer maximalen Amplitudenpegel-Breitenlänge gleich dem Zweifachen des maximalen Amplitudenpegels des pegel-eingestellten Signals; und

eine Subtraktionssteuereinrichtung zum graduellen Vermindern - nach der Amplitudensteuerung durch die Amplitudensteuereinrichtung - der kumulativen Summe der Kumulativ-Additionseinrichtung vom maximalen Amplitudenpegel des pegel-eingestellten Signals;

wobei die Schaltsteuereinrichtung veranlasst, dass die Umschalteinrichtung vom sigma-delta-zurückmodulierten Signal auf das verzögerte sigma-delta-zurückmodulierte Signal nach dem Ende der Subtraktion der kumulativen Summe in der Subtraktionseinrichtung umschaltet, um das Einblenden auszuführen.

11. Digitalsignal-Verarbeitungsvorrichtung nach einem der vorhergehenden Ansprüche, wobei die Sigma-Delta-Modulations-Verarbeitungseinrichtung (6) aufweist:

mehrere Stufen seriell-geschalteter Integratoren (11, 14, 17, 20, 23); und
eine lokale Zurückführungsschleife zum Zurückführen eines Ausgangssignals der mehrstufigen Integratoren zu Eingängen von Integratoren einer vorhergehenden Stufe.

12. Digitalsignal-Verarbeitungseinrichtung (100), um zu veranlassen, dass eine Schalteinrichtung (117) zwischen einem zweikanaligen sigma-delta-modulierten Signal als Eingangssignal, welches durch eine zweikanalige Sigma-Delta-Modulations-Verarbeitungseinrichtung erlangt wird, und einem sigma-delta-zurückmodulierten Signal ($S_B$), welches vom Eingangssignal abgeleitet wird, umschaltet, wobei die Einrichtung umfasst:

eine Sigma-Delta-Modulations-Verarbeitungseinrichtung (115), welche mehrere Integratoren (11, 14, 17, 20, 23) hat, um das sigma-delta-zurückmodulierte Signal ($S_B$) auszugeben;
eine erste Eingangssignal-Verzögerungseinrichtung (102) zum Verzögern des sigma-delta-modulierten Signals eines ersten der beiden Kanäle um eine vorher festgesetzte Anzahl an Proben zum Ausgeben eines ersten verzögerten sigma-delta-modulierten Signals ($S_A$);

eine erste Pegeleinstelleinrichtung (103) zum Einstellen des Amplitudenpegels des sigma-delta-modulierten Signals eines ersten der beiden Kanäle, um den Amplitudenpegel des Zurückführungssignals an den erststufigen Integrator (11), der in der Sigma-Delta-Modulations-Verarbeitungseinrichtung (115) verwendet wird, anzupassen; und

eine erste Amplitudensteuereinrichtung (104) zum Steuern des Amplitudenpegels eines ersten pegel-eingestellten Signals ($S_{11}$), welches den Amplitudenpegel hat, der durch die erste Pegeleinstelleinrichtung (103) eingestellt ist;

eine zweite Eingangssignal-Verzögerungseinrichtung (108) zum Verzögern des sigma-delta-modulierten Signals eines zweiten der beiden Kanäle um eine vorher festgesetzte Anzahl an Proben zum Ausgeben eines zweiten verzögerten sigma-delta-modulierten Signals ($S_C$);

eine zweite Pegeleinstelleinrichtung (109) zum Einstellen des Amplitudenpegels des sigma-delta-modulierten Signals eines zweiten der beiden Kanäle, um den Amplitudenpegel des Zurückführungssignals an den erststufigen Integrator (11), der bei der Sigma-Delta-Modulations-Verarbeitungseinrichtung (115) verwendet wird, anzupassen;

eine zweite Amplitudensteuereinrichtung (110), um den Amplitudenpegel eines zweiten pegel-eingestellten Signals ($S_{12}$) zu steuern, welches den Amplitudenpegel hat, der durch die zweite Pegeleinstelleinrichtung (109) eingestellt ist;

eine Amplitudensteuer-Ausgangssignal-Einstelleinrichtung (105) zum Einstellen der Ausgangssignale der ersten Amplitudensteuereinrichtung (104) und der zweiten Amplitudensteuereinrichtung (110); und

eine Schaltsteuereinrichtung (118) zum Steuern der ersten Amplitudensteuereinrichtung (104), der zweiten Amplitudensteuereinrichtung (110), der Sigma-Delta-Modulations-Verarbeitungseinrichtung (115), der Amplitudensteuer-Ausgangssignal-Einstelleinrichtung (105) und der Schalteinrichtung (117);

wobei die Schaltsteuereinrichtung (118) nach dem Umschalten vom ersten sigma-delta-modulierten Signal ($S_A$) auf das delta-zurückmodulierte Signal ($S_B$) veranlasst, dass die erste Amplitudensteuereinrichtung (104), die zweite Amplitudensteuereinrichtung (110) und die Amplitudensteuer-Ausgangssignal-Einstelleinrichtung (105) Amplitudenpegel des sigma-delta-modulierten Signals ($S_A$) und des anderen sigma-delta-modulierten Signals ($S_C$) steuert.

**13.** Digitalsignal-Verarbeitungsvorrichtung nach Anspruch 12, wobei ein Gewinnverhältnis zwischen der anfangsstufigen Zurückfiihrungsschleife in der Sigma-Delta-Modulations-Verarbeitungseinrichtung (115) und der nächststufigen Zurückführungsschleife eine ganze Zahl ist, und wobei die vorher festgesetzte Anzahl an Proben der Eingangssignal-Verzögerungseinrichtung (102, 108) auf Basis dieses Gewinnverhältnisses festgesetzt wird.

**14.** Digitalsignal-Verarbeitungsvorrichtung nach Anspruch 12 oder 13, welche außerdem eine Musterübereinstimmungs-Erfassungseinrichtung (116) zum Erfassen der Übereinstimmung des ersten verzögerten sigma-delta-modulierten Signals ($S_A$) und des sigma-delta-zurückmodulierten Signals ($S_B$) über mehrere Proben umfasst und zum Erfassen der Übereinstimmung des zweiten verzögerten sigma-delta-modulierten Signals ($S_C$) und des sigma-delta-zurückmodulierten Signals ($S_B$) über mehrere Abtastungen; wobei das erste verzögerte sigma-delta-modulierte Signal ($S_A$) auf das sigma-delta-zurückmodulierte Signal ($S_B$) oder umgekehrt auf Basis eines Steuersignals umgeschaltet wird, welches durch die Musterübereinstimmungs-Erfassungseinrichtung erlangt wird, und das zweite verzögerte sigma-delta-modulierte Signal ($S_C$) auf das sigma-delta-zurückmodulierte Signal ($S_B$) oder umgekehrt auf Basis des Steuersignals umgeschaltet wird, welches durch die Musterübereinstimmungs-Erfassungseinrichtung (116) erlangt wird.

**15.** Digitalsignal-Verarbeitungsvorrichtung nach Anspruch 12, 13 oder 14, wobei die Schaltsteuereinrichtung (118) den Anfangswert des Integrators (11) der Sigma-Delta-Modulations-Verarbeitungseinrichtung (115) unmittelbar vor dem Eingangssignal des Eingangssignals und/oder während der Zeit auf null setzt, wo das verzögerte Signal von der ersten (102) und der zweiten (108) Eingangssignal-Verzögerungseinrichtung durch Umschalten der Schalteinrichtung (117) ausgewählt wird.

**16.** Digitalsignal-Verarbeitungsvorrichtung nach Anspruch 12, 13, 14 oder 15, wobei die Sigma-Delta-Modulations-Verarbeitungseinrichtung (115) umfasst:

mehrere Stufen an Integratoren (11, 14, 17, 20, 23), die in Reihe geschaltet sind; und
eine lokale Zurückführungsschleife zum Zurückführen der Ausgangssignale der mehreren Stufen der Integratoren zu Eingängen von vorhergehenden Stufen der Integratoren.

17. Digitalsignal-Verarbeitungsvorrichtung nach einem der Ansprüche 12 bis 16, wobei die Amplitudensteuer-Ausgangssignal-Einstelleinrichtung (105) eine Subtraktionseinrichtung (145) aufweist, um einen vorher festgesetzten Wert von Ausgangssignalen zu subtrahieren, welche durch die erste (104) und die zweite (110) Amplitudensteuereinrichtung erlangt werden.

18. Digitalsignal-Verarbeitungsvorrichtung nach Anspruch 17, wobei die Amplitudensteuer-Ausgangssignal-Einstelleinrichtung (105) einen Subtraktionswert in einer Subtraktionseinrichtung auf Basis eines akkumulierten Werts der Differenz zwischen dem Amplitudenpegel durch die Amplitudensteuereinrichtung und dem maximalen Amplitudenpegel, der durch die Pegeleinstelleinrichtung erlangt wird, bestimmt.

19. Digitalsignal-Verarbeitungsvornchtung nach Anspruch 18, wobei die Amplitudensteuer-Ausgangssignal-Einstelleinrichtung umfasst:

    eine Pegeldifferenz-Erfassungseinrichtung zum Erfassen der Differenz zwischen dem ersten pegel-eingestellten Signal und dem Ausgangspegel nach der Amplitudensteuerung durch die erste Amplitudensteuereinrichtung während der Periode, wo die erste Amplitudensteuereinrichtung den Amplitudenpegel des ersten pegel-eingestellten Signals steuert;
    eine Kumulativ-Additionseinrichtung zum kumulativen Addieren der Pegeldifferenz von der Pegeldifferenz-Erfassungseinrichtung und des Ausgangspegels nach der Steuerung des Amplitudenpegels des zweiten pegel-eingestellten Signals durch die zweite Amplitudensteuereinrichtung mit den Amplitudenpegel-Breitenlängen der ersten und zweiten pegel-eingestellten Signale; und
    eine Subtraktionseinrichtung zum Steuern der Subtraktionseinrichtung zum graduellen Subtrahieren der kumulativen Summe der kumulativen Additionseinrichtung von einem Ausgangssignal der Amplitudensteuereinrichtung.

20. Digitalsignal-Verarbeitungsvorrichtung nach Anspruch 19, wobei die Schaltsteuereinrichtung nach dem Umschalten vom ersten verzögerten delta-modulierten Signal auf das sigma-delta-zurückmodulierte Signal den Betrieb der ersten Amplitudensteuereinrichtung steuert und den Betrieb der zweiten Amplitudensteuereinrichtung steuert, um die Amplitudenpegel des sigma-delta-modulierten Signals und des anderen sigma-delta-modulierten Signals zu steuern,
wobei die Schaltsteuereinrichtung danach veranlasst, dass die Subtraktionswert-Steuereinrichtung graduell die kumulative Summe der Kumulativ-Aktionseinrichtung von einem Ausgangssignal der Amplitudensteuereinrichtung subtrahiert, wobei die Schaltsteuereinrichtung außerdem veranlasst, dass die Schalteinrichtung von einem Ausgangssignal der Sigma-Delta-Modulations-Verarbeitungseinrichtung auf das zweite verzögerte sigma-delta-modulierte Signal umschaltet.

21. Digitalsignal-Verarbeitungsvorrichtung nach Anspruch 20, wobei, wenn eine Begrenzereinrichtung (54) im ersten Integrator (51) der Sigma-Delta-Modulations-Verarbeitungseinrichtung (115) zum Begrenzen eines integrierten Werts des ersten Integrators auf einen Begrenzerwert vorgesehen ist, der gleich einer ganzzahligen Häufigkeit der maximalen Pegelbreite ist, die Schaltsteuereinrichtung den kumulativen Summenwert der kumulativen Additionseinrichtung auf null während der Zeit löscht, wo die Begrenzereinrichtung mit dem integrierten Wert arbeitet, der größer ist als der Begrenzerwert.

22. Digitalsignal-Verarbeitungsvorrichtung nach Anspruch 18, wobei die Amplitudensteuer-Ausgangssignal-Einstelleinrichtung eine Pegeldifferenz-Erfassungseinrichtung aufweist, um die Differenz zwischen dem zweiten pegel-eingestellten Signal und einem Ausgangspegel zu erfassen, welcher durch die zweite Amplitudensteuereinrichtung gesteuert wird, während der Periode, wo die zweite Amplitudensteuereinrichtung den Amplitudenpegel des zweiten pegel-eingestellten Signals steuert;
die Kumulativ-Additionseinrichtung zum kumulativen Addieren der Pegeldifferenz von der Pegeldifferenz-Erfassungseinrichtung und eines Ausgangspegels der ersten Amplitudensteuereinrichtung den Amplitudenpegel der ersten pegel-eingestellten Einrichtung mit Amplitudenpegel-Breitenlängen der ersten und zweiten pegel-eingestellten Signale eingestellt hat.

23. Digitalsignal-Verarbeitungsvorrichtung nach Anspruch 22, wobei die Schaltsteuereinrichtung (48) nach Umschalten vom ersten verzögerten delta-modulierten Signal ($S_A$) auf das sigma-delta-zurückmodulierte Signal ($S_B$) den Betrieb der ersten Amplitudensteuereinrichtung (104) und den Betrieb der zweiten Amplitudensteuereinrichtung (110) steuert, um die Amplitudenpegel des sigma-delta-modulierten Signals und des anderen sigma-delta-modulierten Signals zu steuern,

wobei die Schaltsteuereinrichtung (48) dann veranlasst, dass die Subtraktionswert-Steuereinrichtung die kumulative Summe der kumulativen Additionseinrichtung graduell von einem Ausgangssignal der Amplitudensteuereinrichtung subtrahiert,

wobei die Schaltsteuereinrichtung (48) außerdem veranlasst, dass die Schalteinrichtung von einem Ausgangssignal der Sigma-Delta-Modulations-Verarbeitungseinrichtung auf das zweite verzögerte sigma-delta-modulierte Signal umschaltet.

24. Digitalsignal-Verarbeitungsvorrichtung nach Anspruch 23, wobei, wenn eine Begrenzereinrichtung (54) im ersten Integrator (51) der Sigma-Delta-Modulations-Verarbeitungseinrichtung (115) vorgesehen ist, um einen integrierten Wert des ersten Integrators auf einen Begrenzerwert zu begrenzen, der gleich einer ganzzahligen Häufigkeit der maximalen Pegelbreite ist, die Schaltsteuereinrichtung den kumulativen Summenwert der Kumulativ-Additionsrichtung auf null während der Zeit löscht, wo die Begrenzereinrichtung mit dem integrierten Wert arbeitet, der größer ist als der Begrenzerwert.

25. Digitalsignal-Verarbeitungsvorrichtung nach Anspruch 17, wobei die Sigma-Delta-Modulations-Verarbeitungseinrichtung (115) aus zumindest einem Integrator (51) besteht und wobei die Amplitudensteuer-Ausgangssignal-Einstelleinrichtung (115) einen Rest von einem Referenzwert jeder Stufe erfasst, der auf der Struktur der Sigma-Delta-Modulations-Verarbeitungseinrichtung basiert, und einen Subtraktionswert in der Subtraktionseinrichtung, welche in einer Eingangsstufe des Integrators vorgesehen ist, auf Basis des erfassten Restwerts bestimmt.

26. Digitalsignal-Verarbeitungsvorrichtung nach Anspruch 25, wobei die Amplitudensteuer-Ausgangssignal-Einstelleinrichtung eine Restwert-Erfassungseinrichtung aufweist, um einen Restwert von der maximalen Amplitudenpegelbreite in einem erststufigen Integrator (51) in der Sigma-Delta-Modulations-Verarbeitungseinrichtung zu erfassen; und

eine Subtraktionssteuereinrichtung, um den erfassten Restwert von dem maximalen Amplitudenpegelsignal graduell zu subtrahieren; wobei

die Schaltsteuereinrichtung (48) nach dem Umschalten vom ersten verzögerten delta-modulierten Signal auf das sigma-delta-zurückmodulierte Signal den Betrieb der ersten Amplitudensteuereinrichtung und den Betrieb der zweiten Amplitudensteuereinrichtung steuert, um die Amplitudenpegel des sigma-delta-modulierten Signals und des anderen sigma-delta-modulierten Signals zu steuern,

wobei die Schaltsteuereinrichtung dann veranlasst, dass die Subtraktionswert-Steuereinrichtung die kumulative Summe der Kumulativ-Additionseinrichtung graduell von einem Ausgangssignal der Amplitudensteuereinrichtung subtrahiert,

wobei die Schaltsteuereinrichtung außerdem bewirkt, dass die Schalteinrichtung von einem Ausgangssignal der Sigma-Delta-Modulations-Verarbeitungseinrichtung auf das zweite verzögerte sigma-delta-modulierte Signal umschaltet.

27. Digitalsignal-Verarbeitungsvorrichtung nach Anspruch 26, wobei die Restwert-Erfassungseinrichtung einen Rest der Summe des integrierten Werts und des maximalen Amplitudenpegels von der maximalen Amplitudenpegelbreite erfasst und

wobei die Subtraktionssteuereinrichtung graduell von dem maximalen Amplitudenpegelsignal das Subtraktionsergebnis des Additionsrestes, der beim Subtrahieren des maximalen Amplitudenpegels erlangt wird, vom Rest subtrahiert.

28. Digitalsignal-Verarbeitungsvorrichtung nach Anspruch 25, 26 oder 27, welche außerdem eine Begrenzereinrichtung (54) aufweist, um einen integrierten Wert von zumindest einem Integrator (51) in der Sigma-Delta-Modulations-Verarbeitungseinrichtung zu begrenzen.

29. Digitalsignal-Verarbeitungsvornchtung nach Anspruch 28, wobei, wenn eine Begrenzereinrichtung (54) zum Begrenzen eines integrierten Werts in einem ersten Integrator (51) der Sigma-Delta-Modulations-Verarbeitungseinrichtung (115) vorgesehen ist, die Restwert-Erfassungseinrichtung den Restwert von der maximalen Amplitudenpegelbreite eines Werts erfasst, der von den begrenzten integrierten Wert des erststufigen Integrators in der Sigma-Delta-Modulations-Verarbeitungseinrichtung und der Subtraktionssteuereinrichtung hergeleitet wird, um den erfassten Restwert vom maximalen Amplitudenpegelsignal graduell zu subtrahieren; wobei die Amplitudensteuer-Ausgangssignal-Einstelleinrichtung vor dem Umschalten vom ersten verzögerten sigma-delta-modulierten Signal auf das sigma-delta-zurückmodulierte Signal den Restwert von dem maximalen Amplitudenpegelsignal graduell subtrahiert, welches in die Sigma-Delta-Modulations-Verarbeitungseinrichtung eintritt, während der Periode, wo das erste verzögerte sigma-delta-modulierte Signal ausgewählt wird, wobei die Subtraktionssteuereinrichtung verwendet wird.

**30.** Digitalsignal-Verarbeitungsvorrichtung nach Anspruch 29, wobei die Restwert-Erfassungseinrichtung einen Restwert von der maximalen Amplitudenpegelbreite eines Werts erfasst, der beim Summieren des begrenzten integrierten Werts auf die maximalen Amplitudenpegel erlangt wird, und wobei die Subtraktionssteuereinrichtung das Subtraktionsergebnis des Summenrestes, der beim Subtrahieren des maximalen Amplitudenpegels vom Restwert erlangt wird, subtrahiert.

**31.** Digitalsignal-Verarbeitungsvorrichtung nach einem der Ansprüche 12 bis 30, wobei, wenn eine Begrenzereinrichtung (54) zum Begrenzen des integrierten Werts im Integrator (51) der Sigma-Delta-Modulations-Verarbeitungseinrichtung vorgesehen ist, ein Begrenzerwert der Begrenzungseinrichtung (54) so ausgewählt wird, eine ganzzahlige Häufigkeit der maximalen Amplitudenpegelbreite zu sein.

**32.** Digitalsignal-Verarbeitungsvorrichtung nach Anspruch 12 bis 31, welche außerdem eine Stumm-Mustersignal-Erzeugungseinrichtung (132) in einem der beiden Kanäle umfasst.

**33.** Digitalsignal-Verarbeitungsvornchtung nach Anspruch 25, wobei, wenn ein integrierter Wert des zweitstufigen Integrators und der Integratoren der folgenden Stufe in der Sigma-Delta-Modulations-Verarbeitungseinrichtung gesteuert wird, die Amplitudensteuer-Ausgangssignal-Einstelleinrichtung veranlasst, dass die Restwert-Erfassungseinrichtung in der vorher eingestellten Stufe einen Restwert von der maximalen Amplitudenpegelbreite erfasst, welcher auf Basis eines Produktwerts vor der vorher festgesetzten Stufe in der Sigma-Delta-Modulations-Verarbeitungseinrichtung erlangt wird.

**34.** Digitalsignal-Verarbeitungsvorrichtung nach Anspruch 33, wobei, wenn der Restwert, der durch die Restwert-Erfassungseinrichtung durch eine Subtraktionseinrichtung erfasst wird, welche in einer Eingangsstufe zum Integrator vorgesehen ist, die Subtraktion sequenziell beginnend vom Integrator auf der Eingangsseite gesteuert wird, und wobei das Schalten von einem Ausgangssignal der Sigma-Delta-Modulations-Verarbeitungseinrichtung (115) zum zweiten verzögerten sigma-delta-modulierten Signal ($S_C$) durch die Schalteinrichtung (117) durchgeführt wird.

**35.** Digitalsignal-Verarbeitungsvorrichtung nach Anspruch 25, welche außerdem eine Begrenzereinrichtung umfasst, um einen integrierten Wert der Integratoren der zweiten und der folgenden Stufe in der Sigma-Delta-Modulations-Verarbeitungseinrichtung zu begrenzen.

**36.** Digitalsignal-Verarbeitungsvorrichtung nach Anspruch 17 oder 34, wobei die Sigma-Delta-Modulations-Verarbeitungseinrichtung (115) umfasst:

mehrere Stufen an Integratoren, welche in Reihe geschaltet sind;
eine lokale Zurückführungsschleife zum Zurückführen von Ausgangssignalen der mehreren Stufen der Integratoren zu Eingängen der Integratoren der vorhergehenden Stufe; und
eine Öffnungs-/Schließeinrichtung für die lokale Zurückführungsschleife;

wobei, während der Zeit, wo die Schaltsteuereinrichtung das erste verzögerte sigma-delta-modulierte Signal auswählt, die Öffnungs-/Schließeinrichtung die lokale Zurückführungsschleife öffnet; wobei, wenn die Schaltsteuereinrichtung das sigma-delta-modulierte Signal nach der Sigma-Delta-Zurückmodulation auswählt, die Öffnungs-/Schließeinrichtung die lokale Zurückführungsschleife kurzschließt, und
wobei, wenn die Schaltsteuereinrichtung das verzögerte zweite sigma-delta-modulierte Signal auswählt, die Öffnungs-/Schließeinrichtung die zweite Zurückführungsschleife vor dem Start der Subtraktionsarbeitung für den Integrator öffnet, zu dem dieses zum lokalen Zurückführungsschleifensignal zurückgeführt wird.

**37.** Digitalsignal-Verarbeitungsverfahren zum Schalten zwischen einem verzögerten sigma-delta-modulierten Signal ($S_A$), welches durch Verzögern eines sigma-delta-modulierten Signals als Eingangssignal erlangt wird, und einem sigma-delta-zurückmodulierten Signal ($S_B$), welches durch Sigma-Delta-Zurückmodulation des Eingangssignals erlangt wird, wobei das Verfahren umfasst:

einen Eingangssignal-Verzögerungsschritt zum Verzögern des Eingangssignals um eine vorher festgesetzte Anzahl an Proben und um das verzögerte sigma-delta-modulierte Signal ($S_A$) auszugeben;
einen Sigma-Delta-Modulationsschritt zum Ausgeben des sigma-delta-zurückmodulierten Signals ($S_B$) unter Verwendung mehrerer Integratoren (11, 13, 17, 20, 23);

einen Pegeleinstellungsschritt zum Einstellen des Amplitudenpegels des sigma-delta-modulierten Signals, welches in den Sigma-Delta-Modulations-Verarbeitungsschritt eintritt, um den Amplitudenpegel des Zurückführungssignals an den erststufigen Integrator (11) anzupassen, der im Sigma-Delta-Modulationsschritt verwendet wird; und

einen Schaltsteuerschritt zum Steuern des Umschaltens.

38. Digitalsignal-Verarbeitungsverfahren nach Anspruch 37, welches außerdem einen Amplitudensteuerschritt umfasst, um den Amplitudenpegel des pegel-eingestellten Signals zu steuern, welches einen Amplitudenpegel hat, der durch den Pegeleinstellungsschritt eingestellt ist; wobei der Schaltsteuerschritt veranlasst, dass der Schaltschritt das verzögerte sigma-delta-modulierte Signal vom Eingangssignal-Verzögerungsschritt auf das sigma-delta-zurückmodulierte Signal umschaltet, welches bei der Sigma-Delta-Modulation des pegel-eingestellten Signals erlangt wird, wobei der Schaltsteuerschritt danach veranlasst, dass der Amplitudensteuerschritt die Amplitude des pegel-eingestellten Signals steuert.

39. Digitalsignal-Verarbeitungsverfahren, um zu veranlassen, dass ein Schaltschritt von einem zweikanaligen sigma-delta-modulierten Signal als Eingangssignal, welches durch zweikanalige Sigma-Delta-Modulationsverarbeitung erlangt wird, und einem sigma-delta-zurückmodulierten Signal ($S_B$), welches vom Eingangssignal abgeleitet wird, umschaltet, wobei das Verfahren umfasst:

einen Sigma-Delta-Modulations-Verarbeitungsschritt unter Verwendung mehrerer Integratoren (11, 13, 17, 20, 23) zum Ausgeben des sigma-delta-zurückmodulierten Signals ($S_B$);
einen ersten Eingangssignal-Verzögerungsschritt zum Verzögern eines Sigma-Delta-Modulationssignals eines ersten der beiden Kanäle um eine vorher festgelegte Anzahl an Proben, um ein erstes verzögertes sigma-delta-moduliertes Signal ($S_A$) auszugeben;
einen ersten Pegeleinstellschritt zum Einstellen des Amplitudenpegels des sigma-delta-modulierten Signals eines ersten der beiden Kanäle, um den Amplitudenpegel des Zurückführungssignals an einen Integrator (11) einer ersten Stufe anzupassen, der im Sigma-Delta-Modulations-Verarbeitungsschritt verwendet wird;
einen Amplitudensteuerschritt zum Steuern des Amplitudenpegels eines ersten pegel-eingestellten Signals ($S_{11}$), welches den Amplitudenpegel hat, der im ersten Pegeleinstellungsschritt eingestellt wurde;
einen zweiten Eingangssignal-Verzögerungsschritt zum Verzögern des sigma-delta-modulierten Signals eines zweiten der beiden Kanäle um eine vorher festgelegte Anzahl an Proben zum Ausgeben eines zweiten verzögerten sigma-delta-modulierten Signals ($S_C$);
einen zweiten Pegeleinstellungsschritt zum Einstellen des Amplitudenpegels des sigma-delta-modulierten Signals eines zweiten der beiden Kanäle, um den Amplitudenpegel des Zurückführungssignals an den Integrator der ersten Stufe anzupassen, der im Sigma-Delta-Modulations-Verarbeitungsschritt verwendet wird;
einen zweiten Amplitudensteuerschritt zum Steuern des Amplitudenpegels eines zweiten pegel-eingestellten Signals ($S_{12}$), welches den Amplitudenpegel hat, der im zweiten Pegeleinstellschritt eingestellt wurde;
einen Amplitudensteuer-Ausgangssignal-Einstellschritt zum Einstellen der Ausgangssignale des ersten Amplitudensteuerschritts und des zweiten Amplitudensteuerschritts; und
einen Schaltsteuerschritt zum Steuern des ersten Amplitudensteuerschritts, des zweiten Amplitudensteuerschritts, des Sigma-Delta-Modulations-Verarbeitungsschritts, des Amplitudensteuer-Ausgangssignal-Einstellschritts und des Umschaltschritts;

wobei der Schaltsteuerschritt nach dem Umschalten vom ersten sigma-delta-modulierten Signal ($S_A$) auf das delta-zurückmodulierte Signal ($S_B$) veranlasst, dass der erste Amplitudensteuerschritt, der zweite Amplitudensteuerschritt und der Amplitudensteuer-Ausgangssignal-Einstellschritt Amplitudenpegel der zweikanaligen sigma-delta-modulierten Signale ($S_A$, $S_C$) steuert.

## Revendications

1. Dispositif de traitement de signaux numériques (1) pour passer d'un signal modulé sigma-delta retardé ($S_A$), obtenu en retardant un signal modulé sigma-delta, en tant que signal d'entrée, et un signal remodulé sigma-delta ($S_B$) obtenu par remodulation sigma-delta dudit signal d'entrée, ledit dispositif comportant :

un moyen de retard du signal d'entrée (3) pour retarder ledit signal d'entrée d'un nombre prédéterminé d'échantillons, pour délivrer ledit signal modulé sigma-delta retardé ($S_A$) ;
un moyen de traitement de modulation sigma-delta (6) possédant une pluralité d'intégrateurs (11, 14, 17, 20, 23) pour délivrer ledit signal remodulé sigma-delta ($S_B$) ;

un moyen de réglage de niveau (5) pour ajuster le niveau d'amplitude du signal modulé sigma-delta introduit dans ledit moyen de traitement de modulation sigma-delta (6) pour correspondre au niveau d'amplitude d'un signal de rétroaction d'un intégrateur de premier étage (11) utilisé dans ledit moyen de traitement de modulation sigma-delta (6); et

un moyen de contrôle de commutation (7) pour contrôler la commutation par un moyen de commutation (4).

2. Dispositif de traitement de signaux numériques selon la revendication 1, dans lequel un rapport de gain entre une première boucle de rétroaction de premier étage dans ledit moyen de traitement de modulation sigma-delta (6) et la boucle de rétroaction d'étage suivant est un entier et

dans lequel le nombre prédéterminé d'échantillons dudit moyen de retard de signal d'entrée (3) est déterminé en fonction dudit rapport de gain.

3. Dispositif de traitement de signaux numériques selon la revendication 1 ou 2, comportant en outre un moyen de détection de coïncidence de motif (28) pour la détection d'une coïncidence dudit signal modulé sigma-delta retardé ($S_A$) et le signal de remodulation sigma-delta ($S_B$) sur une pluralité d'échantillons ; ledit moyen de contrôle de commutation (29) contrôlant ledit moyen de commutation en fonction du résultat de la détection obtenue par ledit moyen de détection de coïncidence de motif (28).

4. Dispositif de traitement de signaux numériques selon la revendication 1, 2 ou 3, dans lequel ledit moyen de contrôle de commutation (29) fixe la valeur initiale de l'intégrateur dudit moyen de traitement de modulation sigma-delta (6) à zéro directement avant l'entrée dudit signal d'entrée et/ou pendant le temps où le signal modulé sigma-delta retardé ($S_A$) à partir dudit moyen de retard de signal d'entrée (3) est sélectionné par commutation grâce audit moyen de commutation (4).

5. Dispositif de traitement de signaux numériques selon la revendication 1, 2, 3 ou 4, comportant en outre un moyen de contrôle d'amplitude (35) pour contrôler le niveau d'amplitude d'un signal à niveau réglé ($S_1$) possédant le niveau d'amplitude réglé par ledit moyen de réglage de niveau ; ledit moyen de contrôle de commutation (48) amenant ledit moyen de contrôle d'amplitude à contrôler le niveau d'amplitude dudit signal à niveau réglé après avoir amené le moyen de commutation à passer du signal modulé sigma-delta retardé provenant dudit moyen de retard de signal d'entrée au signal remodulé sigma-delta obtenu par modulation sigma-delta dudit signal à niveau réglé.

6. Dispositif de traitement de signaux numériques selon la revendication 1, 2, 3 ou 4, comportant en outre :

un moyen de contrôle d'amplitude (35) pour contrôler le niveau d'amplitude du signal à niveau réglé possédant son niveau d'amplitude réglé par ledit moyen de réglage du niveau (5) ;

un moyen de détection de différence de niveau (42) pour détecter la différence entre le niveau d'amplitude maximum du signal à niveau réglé et le niveau d'amplitude de la sortie suivant le contrôle d'amplitude pendant le temps où ledit moyen de contrôle d'amplitude (35) contrôle le niveau d'amplitude du signal à niveau réglé ;

un moyen d'addition cumulative (46) pour additionner de façon cumulative la différence de niveau dudit moyen de détection de différence de niveau (42) à une longueur de largeur de niveau d'amplitude maximum égale à deux fois le niveau d'amplitude maximum dudit signal à niveau réglé ; et

un moyen de contrôle de soustraction (47) pour soustraire progressivement la somme cumulative dudit moyen d'addition cumulative depuis le niveau d'amplitude maximum dudit signal à niveau réglé après le contrôle d'amplitude dans ledit moyen de contrôle d'amplitude (35) ;

ledit moyen de contrôle de commutation (48) amenant ledit moyen de commutation (4) à passer dudit signal modulé sigma-delta audit signal modulé sigma-delta retardé après la fin de la soustraction de ladite somme cumulative dans ledit moyen de contrôle de soustraction (47).

7. Dispositif de traitement de signaux numériques selon l'une quelconque des revendications précédentes, dans lequel, si un premier intégrateur (51) dudit moyen de traitement de modulation sigma-delta est muni d'un moyen limiteur (54) pour limiter une valeur intégrée dudit premier intégrateur (51) à une valeur de limite égale à un nombre entier fois la largeur de niveau d'amplitude maximum, ledit moyen de contrôle de commutation (48) remet la valeur de somme cumulative du moyen d'addition cumulative à zéro pendant le temps où le moyen limiteur (54) fonctionne dans un état dans lequel ladite valeur intégrée est supérieure à la valeur du limiteur.

8. Dispositif de traitement de signaux numériques selon la revendication 1, comportant en outre :

un moyen de détection d'erreur (57) pour détecter une erreur en rafale incorrigible dans ledit signal modulé sigma-delta ;

un moyen de retard (58) prévu en aval dudit moyen de détection d'erreur (57) pour retarder ledit signal modulé sigma-delta ;

un moyen d'atténuation (60) pour estomper ledit signal modulé sigma-delta par l'intermédiaire dudit moyen de retard;

un moyen d'apparition progressive (60) pour faire apparaître progressivement ledit signal modulé sigma-delta par l'intermédiaire dudit moyen de retard ; et

un moyen de contrôle (59) pour amener ledit moyen de fusion à fondre ledit signal modulé sigma-delta retardé par ledit moyen de retard directement avant qu'une erreur en rafale incorrigible proche d'un niveau si ledit moyen de détection d'erreur détecte une telle erreur en rafale incorrigible dans ledit signal modulé sigma- delta, ledit moyen de contrôle amenant ledit moyen de mélange à mélanger ledit signal modulé sigma-delta directement après ladite erreur en rafale jusqu'au niveau d'amplitude maximum.

9. Dispositif de traitement de signaux numériques selon la revendication 8, dans lequel ledit moyen de fusion (60) comprend un moyen de contrôle d'amplitude pour contrôler le niveau d'amplitude du signal à niveau réglé possédant le niveau d'amplitude réglé par le moyen de réglage de niveau ;

ledit moyen de fusion (60) amenant ledit moyen de contrôle d'amplitude à contrôler le niveau d'amplitude dudit signal à niveau réglé pour effectuer un traitement de fusion après que ledit moyen de contrôle de commutation a amené ledit moyen de commutation à passer du signal modulé sigma-delta retardé provenant dudit moyen de retard de signal d'entrée au signal remodulé sigma-delta provenant dudit moyen de traitement de modulation sigma-delta.

10. Dispositif de traitement de signaux numériques selon la revendication 8, dans lequel ledit moyen de mélange (60) comprend :

un moyen de contrôle d'amplitude pour contrôler le niveau d'amplitude du signal à niveau réglé possédant le niveau d'amplitude réglé par ledit moyen de réglage de niveau ;

le moyen de détection de différence de niveau pour détecter la différence entre le niveau d'amplitude maximum du signal à niveau réglé et le niveau d'amplitude d'une sortie à niveau contrôlé pendant le temps où ledit moyen de contrôle d'amplitude contrôle le niveau d'amplitude dudit signal à niveau réglé ;

un moyen d'addition cumulative pour additionner de façon cumulative la différence de niveau provenant dudit moyen de détection de différence de niveau à une longueur de largeur de niveau d'amplitude maximum égale à deux fois le niveau d'amplitude maximum dudit signal à niveau réglé ; et

un moyen de contrôle de soustraction pour réduire progressivement, après le contrôle d'amplitude par ledit moyen de contrôle d'amplitude, la somme cumulative dudit moyen d'addition cumulative du niveau d'amplitude maximum dudit signal à niveau réglé ;

dans lequel ledit moyen de contrôle de commutation amène ledit moyen de commutation à passer dudit signal remodulé sigma-delta audit signal remodulé sigma-delta retardé après la fin de la soustraction de ladite somme cumulative dans ledit moyen de contrôle de soustraction pour effectuer l'apparition progressive.

11. Dispositif de traitement de signaux numériques selon l'une quelconque des revendications précédentes, dans lequel ledit moyen de traitement de modulation sigma-delta (6) comprend :

une pluralité d'étages d'intégrateurs reliés en série (11, 14, 17, 20, 23) ; et

une boucle de rétroaction locale pour renvoyer une sortie desdits intégrateurs à étages multiples aux entrées des intégrateurs des étages précédents.

12. Dispositif de traitement de signaux numériques (100) pour amener le moyen de commutation (117) à commuter entre un signal modulé sigma-delta à deux canaux, en tant que signal d'entrée obtenu par un traitement de modulation sigma-delta à deux canaux, et un signal remodulé sigma-delta ($S_B$) dérivé du signal d'entrée, ledit dispositif comportant:

un moyen de traitement de modulation sigma-delta (115) possédant une pluralité d'intégrateurs (11, 14, 17, 20, 23) pour délivrer ledit signal remodulé sigma-delta ($S_B$) ;

un premier moyen de retard de signal d'entrée (102) pour retarder le signal modulé sigma-delta d'un premier desdits deux canaux d'un nombre prédéterminé d'échantillons pour délivrer un premier signal modulé sigma-delta retardé ($S_A$) ;

un premier moyen de réglage de niveau (103) pour régler le niveau d'amplitude du signal modulé sigma-delta d'un premier desdits deux canaux pour correspondre au niveau d'amplitude du signal de rétroaction à l'intégrateur de premier étage (11) utilisé dans ledit moyen de traitement de modulation sigma-delta (115) ; et

un premier moyen de contrôle d'amplitude (104) pour contrôler le niveau d'amplitude d'un premier signal à niveau réglé ($S_{11}$) possédant le niveau d'amplitude réglé par le premier moyen de réglage d'amplitude (103) ;

un second moyen de retard de signal d'entrée (108) pour retarder le signal modulé sigma-delta d'un second desdits canaux d'un nombre prédéterminé d'échantillons pour délivrer un second signal modulé sigma-delta retardé ($S_C$) ;

un second moyen de réglage du niveau (109) pour régler le niveau d'amplitude du signal modulé sigma-delta d'un second desdits deux canaux pour correspondre au niveau d'amplitude du signal de rétroaction à l'intégrateur de premier étage (11) utilisé dans ledit moyen de traitement de modulation sigma-delta (115) ;

un second moyen de contrôle d'amplitude (110) pour contrôler le niveau d'amplitude d'un second signal à niveau réglé ($S_{12}$) possédant le niveau d'amplitude réglé par le second moyen de réglage du niveau (109) ;

un moyen de réglage de sortie de contrôle d'amplitude (105) pour régler les sorties dudit premier moyen de contrôle d'amplitude (104) et dudit second moyen de contrôle d'amplitude (110) ; et

un moyen de contrôle de commutation (118) pour contrôler ledit premier moyen de contrôle d'amplitude (104), le second moyen de contrôle d'amplitude (110), le moyen de traitement de modulation sigma-delta (115), le moyen de réglage de sortie de contrôle d'amplitude (105) et ledit moyen de commutation (117) ;

ledit moyen de contrôle de commutation (118) après passage dudit premier signal modulé sigma-delta ($S_A$) audit signal remodulé delta ($S_B$) amenant ledit premier moyen de contrôle d'amplitude (104), le second moyen de contrôle d'amplitude (110) et le moyen de réglage de sortie de contrôle d'amplitude (105) à contrôler les niveaux d'amplitude dudit signal modulé sigma-delta ($S_A$) et dudit autre signal modulé sigma-delta ($S_C$).

**13.** Dispositif de traitement de signaux numériques selon la revendication 12, dans lequel un rapport de gain entre la boucle de rétroaction d'étage initial dans ledit moyen de traitement de modulation sigma-delta (115) et la boucle de rétroaction d'étage suivant est un entier et dans lequel le nombre prédéterminé d'échantillons dudit moyen de retard de signal d'entrée (102, 108) est déterminé en fonction dudit rapport de gain.

**14.** Dispositif de traitement de signaux numériques selon la revendication 12 ou 13, comportant en outre un moyen de détection de coïncidence de motif (116) pour la détection d'une coïncidence dudit premier signal modulé sigma-delta retardé ($S_A$) et du signal remodulé sigma-delta ($S_B$) sur une pluralité d'échantillons et pour la détection d'une coïncidence dudit second signal modulé sigma-delta retardé ($S_C$) et le signal remodulé sigma-delta ($S_B$) sur une pluralité d'échantillons ; ledit premier signal modulé sigma-delta retardé ($S_A$) étant commuté au signal remodulé sigma-delta ($S_B$) ou vice versa en fonction du signal de contrôle obtenu par ledit moyen de détection de coïncidence de motif (116) et ledit second signal modulé sigma-delta retardé ($S_C$) étant commuté au signal remodulé sigma-delta ($S_B$) ou vice versa en fonction du signal de contrôle obtenu par ledit moyen de détection de coïncidence de motif (116).

**15.** Dispositif de traitement de signaux numériques selon la revendication 12, 13 ou 14, dans lequel ledit moyen de contrôle de commutation (118) fixe la valeur initiale de l'intégrateur (11) dudit moyen de traitement de modulation sigma-delta (115) à zéro directement avant l'entrée dudit signal d'entrée et/ou pendant le temps où le signal retardé provenant desdits premier (102) et second (108) moyens de retard de signal d'entrée est sélectionné par commutation par ledit moyen de commutation (117).

**16.** Dispositif de traitement de signaux numériques selon la revendication 12, 13, 14 ou 15, dans lequel ledit moyen de traitement de modulation sigma-delta (115) comprend:

une pluralité d'étages d'intégrateurs (11, 14, 17, 20, 23) reliés en série ; et
une boucle de rétroaction locale pour renvoyer les sorties de ladite pluralité d'étages d'intégrateurs aux entrées des étages précédents des intégrateurs.

**17.** Dispositif de traitement de signaux numériques selon l'une quelconque des revendications 12 à 16, dans lequel ledit moyen de réglage de sortie de contrôle d'amplitude (105) comprend un moyen de soustraction (145) pour soustraire une valeur prédéterminée des signaux de sortie obtenus par lesdits premier (104) et second (110) moyens de contrôle d'amplitude.

**18.** Dispositif de traitement de signaux numériques selon la revendication 17, dans lequel ledit moyen de réglage de sortie de contrôle d'amplitude (105) détermine une valeur de soustraction dans le moyen de soustraction en fonction d'une valeur accumulée de la différence entre le niveau d'amplitude par ledit moyen de contrôle d'amplitude et le niveau d'amplitude maximum obtenu par ledit moyen de réglage de niveau.

**19.** Dispositif de traitement de signaux numériques selon la revendication 18, dans lequel ledit moyen de réglage de sortie de contrôle d'amplitude comprend :

un moyen de détection de différence de niveau pour détecter la différence entre le premier signal à niveau réglé et un niveau de sortie après contrôle d'amplitude par ledit premier moyen de contrôle d'amplitude pendant la période où ledit premier moyen de contrôle d'amplitude contrôle le niveau d'amplitude du premier signal à niveau réglé ;

un moyen d'addition cumulative pour additionner de façon cumulative la différence de niveau provenant du moyen de détection de différence de niveau et le niveau de sortie après contrôle du niveau d'amplitude du second signal à niveau réglé par le second moyen de contrôle d'amplitude grâce aux longueurs de largeur de niveau d'amplitude des premiers et seconds signaux à niveau réglé ; et

un moyen de contrôle de soustraction pour contrôler le moyen de soustraction afin de soustraire progressivement la somme cumulative dudit moyen d'addition cumulative d'un signal de sortie dudit moyen de contrôle d'amplitude.

**20.** Dispositif de traitement de signaux numériques selon la revendication 19, dans lequel ledit moyen de contrôle de commutation après passage du premier signal modulé delta retardé audit signal remodulé sigma-delta contrôlant le fonctionnement dudit premier moyen de contrôle d'amplitude et le fonctionnement dudit second moyen de contrôle d'amplitude pour contrôler les niveaux d'amplitude du signal modulé sigma-delta et de l'autre signal modulé sigma-delta, ledit moyen de contrôle de commutation amenant ensuite progressivement ledit moyen de contrôle de valeur de soustraction à soustraire la somme cumulative du moyen d'addition cumulative d'un signal de sortie dudit moyen de contrôle d'amplitude, ledit moyen de contrôle de commutation amenant également ledit moyen de commutation à passer d'une sortie du moyen de traitement de modulation sigma-delta audit second signal le modulé sigma-delta retardé.

**21.** Dispositif de traitement de signaux numériques selon la revendication 20, dans lequel, si un moyen limiteur (54) est prévu dans le premier intégrateur (51) dudit moyen de traitement de modulation sigma-delta (115) pour limiter une valeur intégrée du premier intégrateur à une valeur du limiteur égale à un nombre entier fois la largeur de niveau maximum, ledit moyen de contrôle de commutation remet la valeur de somme cumulative du moyen d'addition cumulative à zéro pendant le temps où ledit moyen limiteur fonctionne avec la valeur intégrée supérieure à la valeur du limiteur.

**22.** Dispositif de traitement de signaux numériques selon la revendication 18, dans lequel ledit moyen de réglage de sortie de contrôle d'amplitude comprend un moyen de détection de différence de niveau pour détecter la différence entre le second signal à niveau réglé et un niveau de sortie contrôlé en amplitude par le second moyen de contrôle d'amplitude pendant la période où ledit second moyen de contrôle d'amplitude contrôle le niveau d'amplitude dudit second signal à niveau réglé ;

un moyen d'addition cumulative pour additionner de façon cumulative les différences de niveau provenant du moyen de détection de différence de niveau et un niveau de sortie après que ledit premier moyen de contrôle d'amplitude a réglé le niveau d'amplitude du premier signal à niveau réglé grâce aux longueurs de largeur du niveau d'amplitude des premiers et seconds signaux à niveau réglé.

**23.** Dispositif de traitement de signaux numériques selon la revendication 22, dans lequel ledit moyen de contrôle de commutation (48) après le passage du premier signal modulé delta retardé ($S_A$) audit signal remodulé sigma-delta ($S_B$) contrôlant le fonctionnement dudit premier moyen de contrôle d'amplitude (104) et le fonctionnement dudit second moyen de contrôle d'amplitude (110) pour contrôler les niveaux d'amplitude du signal modulé sigma-delta et de l'autre signal modulé sigma-delta, ledit moyen de contrôle de commutation (48) amenant ensuite ledit moyen de contrôle de valeur de soustraction à retrancher la somme cumulative du moyen d'addition cumulative progressivement d'un signal de sortie dudit moyen de contrôle d'amplitude, ledit moyen de contrôle de commutation (48) amenant également ledit moyen de commutation à passer d'une sortie du moyen de traitement de modulation sigma-delta audit second signal modulé sigma-delta retardé.

**24.** Dispositif de traitement de signaux numériques selon la revendication 23, dans lequel, si un moyen limiteur (54) est prévu dans le premier intégrateur (51) dudit moyen de traitement de modulation sigma-delta (115) pour limiter une valeur intégrée du premier intégrateur à une valeur du limiteur égale à un nombre entier fois la largeur de niveau maximum, ledit moyen de contrôle de commutation remet la valeur de la somme cumulative du moyen d'addition cumulative à zéro pendant le temps où ledit moyen limiteur fonctionne avec la valeur intégrée supérieure à la valeur du limiteur.

**25.** Dispositif de traitement de signaux numériques selon la revendication 17, dans lequel ledit moyen de traitement de modulation sigma-delta (115) est constitué d'au moins un intégrateur (51) et dans lequel ledit moyen de réglage de sortie de contrôle d'amplitude (105) détecte un reste d'une valeur de référence de chaque étage qui est basé sur la structure du moyen de traitement de modulation sigma-delta, et détermine une valeur de soustraction dans le moyen de soustraction prévu dans un étage d'entrée de l'intégrateur en fonction de la valeur de reste détectée.

**26.** Dispositif de traitement de signaux numériques selon la revendication 25, dans lequel ledit moyen de réglage de sortie de contrôle d'amplitude comprend un moyen de détection de valeur de reste pour détecter une valeur de reste à partir de la largeur de niveau d'amplitude maximum dans un intégrateur à premier étage (51) dans ledit moyen de traitement de modulation sigma-delta ; et

un moyen de contrôle de soustraction pour retrancher progressivement la valeur de reste détectée du signal de niveau d'amplitude maximum ; dans lequel

ledit moyen de contrôle de commutation (48) après passage dudit premier signal modulé delta audit signal remodulé sigma-delta contrôlant le fonctionnement dudit premier moyen de contrôle d'amplitude et le fonctionnement dudit second moyen de contrôle d'amplitude pour contrôler les niveaux d'amplitude du signal modulé sigma-delta et l'autre signal modulé sigma-delta, ledit moyen de contrôle de commutation amenant ensuite ledit moyen de contrôle de valeur de soustraction à retrancher la somme cumulative du moyen d'addition cumulative progressivement d'un signal de sortie dudit moyen de contrôle d'amplitude, ledit moyen de contrôle de commutation amenant également ledit moyen de commutation à passer d'une sortie du moyen de traitement de modulation sigma-delta audit second signal modulé sigma-delta retardé.

**27.** Dispositif de traitement de signaux numériques selon la revendication 26, dans lequel ledit moyen de détection de valeur de reste détecte un reste de la somme de la valeur intégrée et le niveau d'amplitude maximum à partir de la largeur de niveau d'amplitude maximum et dans lequel ledit moyen de contrôle de soustraction retranche progressivement du signal de niveau d'amplitude maximum le résultat de la soustraction du reste d'addition obtenu en retranchant le niveau d'amplitude maximum de reste.

**28.** Dispositif de traitement de signaux numériques selon la revendication 25, 26 ou 27, comportant en outre un moyen limiteur (54) pour limiter une valeur intégrée d'au moins un intégrateur (51) dans ledit moyen de traitement de modulation sigma-delta.

**29.** Dispositif de traitement de signaux numériques selon la revendication 28, dans lequel, lorsque le moyen limiteur (54) pour limiter une valeur intégrée dans un premier intégrateur (51) dudit moyen de traitement de modulation sigma-delta (115) est prévu, un moyen de détection de valeur de reste pour détecter la valeur de reste à partir de la largeur de niveau d'amplitude maximum d'une valeur dérivée de la valeur intégrée limitée de l'intégrateur de premier étage dans ledit moyen de traitement de modulation sigma-delta et un moyen de contrôle de soustraction pour retrancher progressivement la valeur de reste détectée du signal de niveau d'amplitude maximum ; ledit moyen de réglage de sortie de contrôle d'amplitude avant commutation du premier signal modulé sigma-delta retardé au signal remodulé sigma-delta retranchant progressivement ladite valeur de reste du signal de niveau d'amplitude maximum entrant dans ledit moyen de traitement de modulation sigma-delta, pendant la période où le premier signal modulé sigma-delta retardé est sélectionné, en utilisant ledit moyen de contrôle de soustraction.

**30.** Dispositif de traitement de signaux numériques selon la revendication 29, dans lequel ledit moyen de détection de valeur de reste détecte une valeur de reste à partir de la largeur de niveau d'amplitude maximum d'une valeur obtenue en additionnant la valeur intégrée limitée au niveau d'amplitude maximum et dans lequel ledit moyen de contrôle de soustraction retranche progressivement le résultat de la soustraction du reste de somme obtenu en retranchant le niveau d'amplitude maximum de la valeur de reste.

**31.** Dispositif de traitement de signaux numériques selon l'une quelconque des revendications 12 à 30, dans lequel, si un moyen limiteur (54) pour limiter la valeur intégrée est prévu dans l'intégrateur (51) dudit moyen de traitement de modulation sigma-delta, une valeur du limiteur du moyen de limitation (54) est sélectionnée pour être un nombre entier fois la largeur de niveau d'amplitude maximum.

**32.** Dispositif de traitement de signaux numériques selon l'une des revendications 12 à 31, comportant en outre un moyen de génération de signal de motif muet (132) dans l'un des deux canaux.

33. Dispositif de traitement de signaux numériques selon la revendication 25, dans lequel, lors du contrôle d'une valeur intégrée dans l'intégrateur de second étage et les intégrateurs d'étages suivants dans ledit moyen de traitement de modulation sigma-delta, ledit moyen de réglage de sortie de contrôle d'amplitude amène le moyen de détection de valeur de reste dans l'étage prédéterminé pour détecter une valeur de reste à partir de la largeur de niveau d'amplitude maximum obtenue en fonction d'une valeur de produit avant l'étage prédéterminé dans le moyen de traitement de modulation sigma-delta.

34. Dispositif de traitement de signaux numériques selon la revendication 33, dans lequel, lors de la soustraction progressive de la valeur de reste détectée par le moyen de détection de valeur de reste par le moyen de soustraction prévu à un étage d'entrée audit intégrateur, la soustraction est séquentiellement contrôlée en commençant depuis l'intégrateur sur le côté entrée, et dans lequel la commutation d'une sortie dudit moyen de traitement de modulation sigma-delta (115) audit second signal modulé sigma-delta retardé ($S_C$) est effectuée par ledit moyen de commutation (117).

35. Dispositif de traitement de signaux numériques selon la revendication 25, comportant en outre un moyen limiteur pour limiter une valeur intégrée des intégrateurs de second étage et suivants dans ledit moyen de traitement de modulation sigma-delta.

36. Dispositif de traitement de signaux numériques selon la revendication 17 ou 34, dans lequel ledit moyen de traitement de modulation sigma-delta (115) comprend :

une pluralité d'étages d'intégrateurs reliés en série ;
une boucle de rétroaction locale pour renvoyer les sorties desdits étages multiples des intégrateurs aux entrées des intégrateurs d'étages précédents ; et
un moyen d'ouverture/fermeture pour ladite boucle de rétroaction locale ;

dans lequel, pendant le temps où ledit moyen de contrôle de commutation sélectionne ledit premier signal modulé sigma-delta retardé, ledit moyen d'ouverture/fermeture ouvre ladite boucle de rétroaction locale ; dans lequel, si le moyen de contrôle de commutation sélectionne le signal modulé sigma-delta après ladite remodulation sigma-delta, ledit moyen d'ouverture/fermeture court-circuite ladite boucle de rétroaction locale et dans lequel, si le moyen de contrôle de commutation sélectionne le second signal modulé sigma-delta retardé, ledit moyen d'ouverture/fermeture ouvre ladite boucle de rétroaction locale avant commencement du traitement de soustraction par l'intégrateur auquel est renvoyé le signal de boucle de rétroaction locale.

37. Procédé de traitement de signaux numériques de commutation entre un signal modulé sigma-delta retardé ($S_A$) obtenu en retardant un signal modulé sigma-delta, en tant que signal d'entrée, et un signal remodulé sigma-delta ($S_B$) obtenu par remodulation sigma-delta dudit signal d'entrée, ledit procédé comportant :

une étape de retard de signal d'entrée pour retarder ledit signal d'entrée d'un nombre prédéterminé d'échantillons et délivrer le signal modulé sigma-delta retardé ($S_A$) ;
une étape de modulation sigma-delta pour délivrer ledit signal remodulé sigma-delta ($S_B$) en utilisant une pluralité d'intégrateurs (11, 13, 17, 20, 23) ;
une étape de réglage de niveau pour régler le niveau d'amplitude du signal modulé sigma-delta entrant dans l'étape de traitement de modulation sigma-delta pour correspondre au niveau d'amplitude du signal de rétroaction à l'intégrateur de premier étage (11) utilisé dans ladite étape de modulation sigma-delta ; et
une étape de contrôle de commutation pour contrôler ladite commutation.

38. Procédé de traitement de signaux numériques selon la revendication 37, comportant en outre une étape de contrôle d'amplitude pour contrôler le niveau d'amplitude du signal à niveau réglé possédant son niveau d'amplitude réglé par l'étape de réglage du niveau ; ladite étape de contrôle de commutation amenant ladite étape de commutation à passer du signal modulé sigma-delta retardé provenant de l'étape de retard de signal d'entrée au signal remodulé sigma-delta obtenu lors de la modulation sigma-delta du signal à niveau réglé, ladite étape de contrôle de commutation amenant ensuite ladite étape de contrôle d'amplitude à contrôler l'amplitude dudit signal à niveau réglé.

39. Procédé de traitement de signaux numériques pour amener une étape de commutation à passer d'un signal modulé sigma-delta à deux canaux, en tant que signal d'entrée obtenu par un traitement de modulation sigma-delta à deux canaux, à un signal remodulé sigma-delta ($S_B$) dérivé du signal d'entrée, ledit procédé comportant :

une étape de traitement de modulation sigma-delta utilisant une pluralité d'intégrateurs (11, 13, 17, 20, 23) pour délivrer ledit signal remodulé sigma-delta ($S_B$) ;

une première étape de retard du signal d'entrée pour retarder un signal de modulation sigma-delta d'un premier desdits deux canaux d'un nombre prédéterminé d'échantillons pour délivrer un premier signal modulé sigma-delta retardé ($S_A$) ;

une première étape de réglage de niveau pour régler le niveau d'amplitude du signal modulé sigma-delta d'un premier desdits deux canaux pour correspondre au niveau d'amplitude du signal de rétroaction à un intégrateur de premier étage (11) utilisé dans ladite étape de traitement de modulation sigma-delta ;

une première étape de contrôle d'amplitude pour contrôler le niveau d'amplitude d'un premier signal à niveau réglé ($S_{11}$) possédant le niveau d'amplitude réglé dans la première étape de réglage du niveau ;

une seconde étape de retard de signal d'entrée pour retarder le signal modulé sigma-delta d'un second desdits deux canaux par un nombre prédéterminé d'échantillons pour délivrer un second signal modulé sigma-delta retardé ($S_C$) ;

une seconde étape de réglage de niveau pour régler le niveau d'amplitude du signal modulé sigma-delta d'un second desdits deux canaux pour correspondre au niveau d'amplitude du signal de rétroaction de l'intégrateur de premier étage utilisé dans ladite étape de traitement de modulation sigma-delta ;

une seconde étape de contrôle d'amplitude pour contrôler le niveau d'amplitude d'un second signal à niveau réglé ($S_{12}$) possédant le niveau d'amplitude réglé dans la seconde étape de réglage du niveau ;

une étape de réglage de sortie de contrôle d'amplitude pour ajuster les sorties de ladite première étape de contrôle d'amplitude et de ladite seconde étape de contrôle d'amplitude ; et

une étape de contrôle de commutation pour contrôler ladite première étape de contrôle d'amplitude, la seconde étape de contrôle d'amplitude, l'étape de traitement de modulation sigma-delta, l'étape de réglage de sortie de contrôle d'amplitude et ladite étape de commutation ;

ladite étape de contrôle de commutation après passage dudit premier signal modulé sigma-delta ($S_A$) audit signal remodulé delta ($S_B$) amenant ladite première étape de contrôle d'amplitude, la seconde étape de contrôle d'amplitude et l'étape de réglage de sortie de contrôle d'amplitude à contrôler les niveaux d'amplitude desdits signaux modulés sigma-delta à deux canaux ($S_A$, $S_C$).

EP 0 783 207 B1

INPUT ○ → ⊕ → **INTEGRATION** (183) → **COMPARISON** (184) → ● → ○ **OUTPUT** (187)

181  182

**1-BIT DELAY** (186) ← **1-SAMPLE DELAY** (185)

## FIG.1

191  **MULTIPLICATION** (192)  193

**COEFFICIENT GENERATOR** ~196

**CONTROL SIGNAL** (194) → **CONTROL CIRCUIT** ~195

## FIG.2

FIG.3

EP 0 783 207 B1

**FIG.4**

EP 0 783 207 B1

*1*

*2* *3*

*1*

DELAY LINE → *1* → $S_A$ a *4* c *1* → *8*

$S_B$ b

*5* *6*

BIT LENGTH CONVERTER → *16* → ΣΔ MODULATOR → *1*

*7*

CONTROL SIGNAL → $S_E$

## FIG.5

*11*

*61* *62*

⊕ → $Z^{-1}$ →

## FIG.6

FIG.7

**FIG.8**

*11*

*63*

*64*

$$z^{-1}$$

# FIG.9

FIG.10

**FIG.11A**  ANALOG DEMODULATED WAVEFORM

**FIG.11B**  ANALOG DEMODULATED WAVEFORM

SWITCHING POINT

**2**

**1**

DELAY LINE **1** $S_A$

**3**

**5**

BIT LENGTH CONVERTER **16** $\Sigma\Delta$ MODULATOR **1**

**6**

$S_B$

**28**

PATTERN COINCIDENCE DETECTOR

**a**

**4**

**c** $S_F$ **1**

**8**

**b**

$S_T$

$S_E$

**29**

SWITCHING CONTROLLER

**7**

CONTROL SIGNAL $S_D$

**FIG.12**

ORIGINAL
1-BIT DELAY
SIGNAL S$_A$

La

ΣΔ
RE-MODULATOR
1 BIT SIGNAL S$_B$

S$_M$

COINCIDENCE                    Lb

PATTERN
COINCIDENCE
DETECTION
SIGNAL S$_T$

to

SWITCHING        S$_B$ SIDE
CONTROL
SIGNAL S$_D$      S$_A$ SIDE

SWITCH           b SIDE
CHANGEOVER
SIGNAL S$_E$      a SIDE

1 BIT SIGNAL
OUTPUT S$_F$

S$_M$

La          COINCIDENCE          Lb

# FIG.13

52

FIG.14

ORIGINAL
1-BIT DELAY
SIGNAL S<sub>A</sub>

La1   COINCIDENCE
S<sub>M1</sub>                                    La2

ΣΔ
RE-MODULATOR
1 BIT SIGNAL S<sub>B</sub>

Lb1   COINCIDENCE        COINCIDENCE
S<sub>M2</sub>              S<sub>M3</sub>

PATTERN
COINCIDENCE
DETECTION
SIGNAL S<sub>T</sub>

t1              t2              t3

SWITCHING    S<sub>B</sub> SIDE
CONTROL
SIGNAL S<sub>D</sub>    S<sub>A</sub> SIDE

SWITCH       b SIDE
CHANGEOVER
SIGNAL S<sub>E</sub>    a SIDE

ORIGINAL 1-BIT          ΣΔ          ORIGINAL 1-BIT
DELAY SIGNAL      RE-MODULATOR    DELAY SIGNAL
SELECTION         1-BIT SIGNAL      SELECTION
PERIOD            SELECTION          PERIOD
                   PERIOD

ΣΔ
MODULATOR
INTEGRATOR
CLEAR SIGNAL
S<sub>G</sub>

1 BIT SIGNAL
OUTPUT S<sub>F</sub>

La1              Lb1              La2

COINCIDENCE     COINCIDENCE    COINCIDENCE
S<sub>M1</sub>              S<sub>M2</sub>              S<sub>M3</sub>

# FIG.15

FIG.16

FADEOUT
PROCESSING
SIGNAL S<sub>H</sub>

SWITCH
CHANGEOVER
SIGNAL S<sub>E</sub>

$t_0$

BIT LENGTH
CONVERSION
SIGNAL S<sub>I</sub>

COEFFICIENT
GENERATOR
OUTPUT S<sub>J</sub>

AMPLITUDE
CONTROLLER
OUTPUT S<sub>K</sub>

ΣΔ
RE-MODULATOR
1-BIT SIGNAL S<sub>B</sub>

# FIG.17

56

FIG.18

FIG.19A

MAX. AMPLITUDE LEVEL OF $S_I$

MAX. AMPLITUDE LEVEL WIDTH

AMPLITUDE CONTROLLER OUTPUT $S_K$

LEVEL DIFFERENCE DETECTOR OUTPUT $S_L$

SUBTRACTION VALUE CONTROL GATE OUTPUT $S_N$

LEVEL DIFFERENCE DETECTOR OUTPUT $S_L$

COMULATIVE ADDER OUTPUT $S_M$

SUBTRACTION VALUE CONTROL GATE OUTPUT $S_N$

FIG.19B

MAX. AMPLITUDE LEVEL WIDTH

AMPLITUDE CONTROL PERIOD

SUBTRACTION PERIOD

EP 0 783 207 B1

**FIG.20**

50

10          51

⊕ → FIRST INTEGRATOR
WITH LIMITER → ............

............

# FIG.21

51

52          53          54

⊕ → z⁻¹ → LIMITER → ○

# FIG.22

**FIG.23**

**FIG.24**

**FIG.25**

EP 0 783 207 B1

**FIG.26**

FIG.27

EP 0 783 207 B1

CHANGEOVER
REQUEST SIGNAL $S_D$

$S_B$ SIDE

$S_A$ SIDE

LOCAL FEEDBACK LOOP
CONTROL SIGNAL

ON

OFF

SWITCH CONTROL
SIGNAL $S_E$

b

a

AMPLITUDE
CONTROL
PERIOD

SUBTRACTION
PERIOD

PATTERN
COINCIDENCE
DETECTION
PERIOD

DELAY
ADJUSTMENT
PERIOD

PATTERN
COINCIDENCE
DETECTION
PERIOD

# FIG.28

**FIG.29**

EP 0 783 207 B1

EP 0 783 207 B1

FIG.30

FIG.31

FIG.32

**FIG.33**

EP 0 783 207 B1

FIG.34

FIG.35

FIG.36

FIG.37

FIG.38

**FIG.39**

EP 0 783 207 B1

FIG.40

FIG.41

**FIG.42**

EP 0 783 207 B1

FIG.43

**FIG.44**

FIG.45

**FIG.46**

EP 0 783 207 B1

FIG.47

EP 0 783 207 B1

FIG.48

CHANGEOVER
REQUEST
SIGNAL S$_H$

$S_C$ SIDE

$S_A$ SIDE

LOCAL FEEDBACK
LOOP CONTROL SIGNAL

ON

OFF

SWITCH CONTROL
SIGNAL S$_E$

c

b

a

PATTERN
COINCIDENCE
DETECTION
PERIOD

AMPLITUDE
CONTROL
PERIOD

SUBTRACTION
PERIOD

DELAY
ADJUSTMENT
PERIOD

PATTERN
COINCIDENCE
DETECTION
PERIOD

# FIG.49

FIG.50

EP 0 783 207 B1

FIG.51

EP 0 783 207 B1

CHANGEOVER REQUEST SIGNAL S$_H$

S$_C$ SIDE

S$_A$ SIDE

LOOP GAIN VALUE

USUAL LOOP GAIN VALUE

0

SWITCH CONTROL SIGNAL S$_E$

c
b
a

PATTERN COINCIDENCE DETECTION PERIOD

AMPLITUDE CONTROL PERIOD

INTEGRATOR SUBTRACTION PERIOD FOR FIRST STAGE

INTEGRATOR SUBTRACTION PERIOD FOR SECOND AND FOLLOWING STAGES

DELAY ADJUSTMENT PERIOD

PATTERN COINCIDENCE DETECTION PERIOD

## FIG.52

**EP 0 783 207 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YOSHIO YAMAZAKI.** AD/DA converter and Digital Filter. *Journal of Japan Society of Acoustics,* 1990, vol. 46 (3), 251-257

- **KERSHAW S.M. ; SANDLER M.B.** Digital Signal Processing on a Sigma-Delta Bit stream. *IEE Colloquium on Oversampling Techniques and Sigma-Delta Modulation,* 30 March 1994